(19) Europäisches Patentamt
European Patent Office
Office européen des brevets

(11) EP 1 770 694 A2

## (12) EUROPEAN PATENT APPLICATION

(43) Date of publication:
**04.04.2007 Bulletin 2007/14**

(51) Int Cl.:
***G11B 7/125*** *(2006.01)*

(21) Application number: **06119222.5**

(22) Date of filing: **21.08.2006**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(30) Priority: **01.09.2005 JP 2005253853**
**16.09.2005 JP 2005271087**
**16.09.2005 JP 2005271088**

(71) Applicant: **KABUSHIKI KAISHA TOSHIBA**
**Tokyo 105-8001 (JP)**

(72) Inventors:
• **Higashiyama, Yasushi**
**Toshiba Corporation**
**Tokyo 105-8001 (JP)**
• **Iwata, Katsuo**
**Toshiba Corporation**
**Tokyo 105-8001 (JP)**

(74) Representative: **Henkel, Feiler & Hänzel**
**Patentanwälte**
**Maximiliansplatz 21**
**80333 München (DE)**

(54) **Photodetector circuit, method for deriving laser light emission amount control signal, optical pickup device, and optical disk apparatus**

(57) First and second photo detector cells (PD-A, PD-B) are independently provided. At the time of a disk reproducing laser power, an addition output of electric signals subjected to opto-electric conversion from the first and second photo detector cells is derived as a control signal of a laser drive circuit by a first processing circuit (100). At a disk recording laser power, on the other hand, an electric signal subjected to ooto-electric conversion from any one of the first and second photo detector cells is derived as a control signal of the laser drive circuit by a second processing circuit (299).

FIG.3

**Description**

The present invention relates to a photodetector circuit, a method for deriving a laser light emission amount control signal, as an optical pickup device, and an optical disk apparatus.

As a technical field of the invention, the present invention is effective when used in optical pickup devices such as compact disk (CD) players), laser disk (LD) players, digital versatile disk (DVD) players, and HD DVDs using a blue laser in recent years. Furthermore, photodetector circuits are referred to as an optical sensor semiconductor integrated circuit with a built-in amplifier (hereinafter, the circuits are abbreviated as APC-PDIC). In particular, for an automatic adjustment of a laser light emission amount, the circuits are used for performing a so-called front monitor.

There are available for reading information a compact disk (CD) which uses an infrared laser, a digital versatile disk (DVD) which uses a red laser, and a high definition digital versatile disk (HD DVD) which uses a blue laser, HD DVD being standardized as a recording medium drives for a high vision class images. Information signals such as music and movie are recorded in and reproduced from a recording/reproducing apparatus using these optical disks in such a manner that the optical disks are irradiated with a laser beam by focusing with an objective lens on a fine size focus spot, and laser light reflected from the optical disks is detected.

As a consequence, the wavelength of laser light to be used is given in three waves (for use in CD, for use in DVD, and for use in HD DVD) in recent drives. Furthermore, the recording is heightened in speed. With CD, drives having a 52 times speed are put on the market, and with DVD, drives having a 16 times speed are put on the market. The laser light amount comes to have higher powers.

Laser is irradiated on a disk from an objective lens via mirrors on each section or the like. Generally, an APC-PDIC is mounted on a rear surface of a mirror in the midst of a laser optical path. A partial light amount of laser is monitored and is converted to a voltage to be fed back to a laser drive circuit. An auto power control (hereinafter abbreviated as APC) is performed in order to set a light amount of laser to a definite level by means of the feed back loop.

A conventional APC method uses one photo detector cell to monitor the light amount of laser. For this reason, it has been required to take a balance between the specification of a reproduction system and the specification of a recording system.

In the specification of the reproduction system, a frequency band is permitted to be low on the order of 1 MHz. However, it is demanded that a noise level is low, and a signal output is large.

In the specification of the recording system, contrary to the specification of the reproduction system, it is demanded in order to faithfully monitor a recording pulse, a frequency band is set to 100 MHz or more, and that a low noise is given on the low power side of the recording pulse which changes at a ratio of 1:10 to 150 from a low power to a high power, although depending on a double speed recording mode. That is, a large bandwidth and a low noise are required.

Conventionally, since the reproduction system and the recording system have opposite specifications, it has been very difficult to take a balance between the two specifications. Further, with the optical disk, a high-speed change-over of reproduction and recording is demanded in such a manner that the reproduction is performed immediately after the recording or, on the contrary, the recording is performed immediately after the reproduction. In the conventional circuit, there has been a problem in that a change-over constant on the lower side of the band becomes dominant, so that the change-over of recording and reproduction cannot be performed at a high speed.

Further, the conventional APC-PDIC has the following problem. That is, an increase in the amount of light received (a monitor amount) of the conventional APC-PDIC with respect to an outgoing light amount of laser, namely, an increase in a ratio of a light amount monitored with respect to a laser beam power in the midst of the optical path (an increase in the light amount) enables obtaining a monitor signal with a good SN and stability of laser beam power, but an outgoing power toward an object, namely a recording power becomes insufficient. On the other hand, a decrease in the monitor amount makes it impossible to obtain a sufficient sensitivity of a laser light amount monitor, and a sufficient monitor signal voltage, and therefore the SN is deteriorated. As a result, there are problems that stability of laser light amount is deteriorated, and noises are occurred on laser.

Furthermore, an enlargement of a sensor area for increasing the SN of the reproduction system results in an increase in a sensor capacity. On the other hand, under this influence of the sensor capacity, a phase compensation capacitor having substantially the same capacity as the sensor capacity is required in order to suppress a peaking of the frequency characteristic of the reproduction system. As a consequence, the frequency band is narrowed down, and thus, no problem arises in the reproduction system with this. As a consequence, however, there is a large disadvantage in that a monitor frequency band at the recording time becomes insufficient, or decreased.

As described above, In the conventional circuits, there is a problem in that opposite requirements are present in the specification of the reproduction system and the specification of the recording system, so that it is required to take a balance between these two specifications, and the balance thereof is important. Further, there is also a large disadvantage in that, as described above, the sensor area is enlarged, and along with the enlargement thereof, an increase in the phase compensation capacitor leads to an enlargement in the chip size, so that a unit price of an IC rise.

Jpn. Pat. Appln. KOKAI Publication Nos. 2000-332546 and 2003-187484 disclose an example of a conventional photodetector circuit in which phase compensation capacitors are arranged in parallel in a transimpedance.

Jpn. Pat. Appln. KOKAI Publication No. 2000-332546 discloses a technique for decreasing noises except for the required band. In the Jpn. Pat. Appln. KOKAI Publication No. 2000-332546, a value of the phase compensation capacitor is set to a large value as a method for decreasing noises. This means that a time constant of the circuit becomes large by limiting a band of the reproduction system for the decrease of noises in the reproduction system, and as a result, the change-over speed at the change-over time of recording and reproduction is delayed.

Furthermore, Jpn. Pat. Appln. KOKAI Publication No. 2003-187484 discloses a technique for corresponding to a high-speed writing in a writing (recording) mode while obtaining a favorable reproduction characteristic in a reproduction mode. In the Jpn. Pat. Appln. KOKAI Publication No. 2003-187484, a dedicated transimpedances and phase compensation capacitors thereof are provided respectively in the writing (recording) mode and in the reproduction mode, so that dedicated transimpedances and the phase compensation capacitors thereof are changed over with a switch depending on the mode. In the embodiment of the Jpn. Pat. Appln. KOKAI Publication No. 2003-187484, there is described that since a time constant (Rf x Cf) can be set by separating the writing (recording) and the reproduction from each other, the design precision can be easily increased. There is also described that the time constant differs in the writing (recording) mode and the reproduction mode. In the Jpn. Pat. Appln. KOKAI Publication No. 15-187484, one PD is provided with a plurality of transimpedances of the circuit and a plurality of phase compensation capacitors thereof to provide measures against different time constants.

However, as described above, this means that it is difficult to take a balance between the reproduction system and the recording system, and it becomes impossible to change over the reproduction system and the recording system at a high speed because the time constant is increased at the change-over time when the band is low.

Jpn. Pat. Appln. KOKAI Publication No. 2003-234623 discloses the same description as the Jpn. Pat. Appln. KOKAI Publication No. 2003-187484.

Jpn. Pat. Appln. KOKAI Publication No. 2003-23327 discloses a photodetector circuit technology using a current amplifier. In this patent document, a plurality of current amplifying circuits are added in current followed by being converted in voltage and amplified to be output by a voltage-current conversion circuit. This document does not disclose a technique for satisfying a balance of the specifications with respect to the demands of the recording and reproduction systems, and no attempt is made to settle the problem. Further, with respect to a high-speed change-over between recording and reproduction, a technique is not disclosed similarly, and no attempt is made to settle the problem.

In comparison with CD using an infrared laser and DVD using a red laser in the prior art, an optical disk system has been developed in recent years which uses a blue ray as can be seen in HD DVD and the like. Then, along with a higher recording density of optical disks and a higher speed recording as a result of the need by the user, an attempt is made to heighten the revolution speed of the optical disks. For this reason, a frequency band of a recording/reproduction signal which is handled at a pickup unit (an optical detection unit) also becomes about 100 MHz. As a consequence, a recording laser power ejects a laser power which has a power approximate to about 150 times of a reproducing layer power. A technical development of an APC control (automatic power control) for accurately monitoring a laser power which has a power ratio of 1:150 of the low power to the high power as an outgoing power, and for stably ejecting a laser power has become important for a higher speed recording, a high-speed recording and the like.

In the conventional APC method, one photo detector cell is used to monitor a laser light amount, and therefore, it has been required to take a balance between the specification of the reproduction system and the specification of the recording system. In the specification of the reproduction system, the frequency band may be low on the order of 1 MHz. However, it is required that the noise level is low, and the signal output is large. On the other hand, in the specification of the recording system, contrary to the reproduction system, the frequency band is set to 100 MHz or more from a low power to a high power in order to faithfully monitor the recording pulse. Although depending on the double speed recording mode, a low noise is demanded on the low power side of the recording pulse which changes at a ratio of 1:(10 to 150).

Conventionally, the reproduction system and the recording system have opposite specifications, it has been extremely difficult to take a balance between the two specifications. Furthermore, with the optical disk, a high-speed change-over is demanded such that reproduction is performed immediately after recording and recording is performed immediately after reproduction. However, with the conventional circuit, there is a problem in that the time constant of the circuit on the lower band side becomes dominant, and the change-over of recording and reproduction can not be performed at a high speed.

Moreover, with the conventional APC-PDIC, there is a problem in that an increase in the amount of light received (a monitor amount) of the APC-PDIC with respect to the laser outgoing light amount, namely an increase in a ratio of the light amount to be monitored with respect to the laser beam power (an increase in the light amount) in the midst of the optical path enables obtaining a monitor signal with a good SN and stability of laser beam power, but results in an insufficiency of the object outgoing power, namely recording power. On the other hand, a decrease in the monitor amount disables obtaining a sufficient sensitivity of a laser light amount monitor, and a sufficient monitor signal voltage, which leads to a deterioration of SN. As a result, there are problems that stability of laser light amount is deteriorated, and noises are occurred on laser.

Furthermore, when a sensor area is enlarged in order to raise SN for the reproduction system, a sensor capacity is enlarged. Under the influence of the sensor capacity, a phase compensation capacitor having the same capacity as the sensor capacity is required to suppress the peaking of the frequency characteristic of the reproduction system. As a consequence, the frequency band is narrowed down, so that no problem rises in the reproduction system as it is. However, as a consequence, there arises a disadvantage in that the frequency band of the monitor at the recording becomes insufficient and is decreased.

As described above, in the conventional circuits, there is a problem in that opposite requirements are present in the specification of the reproduction system and the specification of the recording system, so that it is required to take a balance between these two specifications, and the balance thereof is important. Further, there is also a large disadvantage in that when the sensor area is enlarged and the phase compensation capacitor is enlarged along therewith as described above, the chip size is enlarged and the unit price of the IC is raised.

There is also a problem with the conventional APC-PDIC in that a disparity is generated in an attachment position. This is because the attachment is performed depending on the precision of manufacturing machines. However, conventionally, such precision is not an object of the problem. That is because a shift of the attachment position of the photodetector is considered, and the laser beam is allowed to be incident on the photodetector with a beam size larger than a light receiving area. However, there has been a problem in that enlargement in the beam size results in a rise of the output of the laser, so that the laser radiates heat. Further, along with a higher speed of recording in recent years, the light amount of laser comes to have a higher power. Consequently, the laser radiates an extremely large heat. In this manner, there is a problem in that the heat generation by the laser leads to the drift of a radiation angle of the laser.

As a technology associated with the photodetector circuit as described above, there are technologies disclosed in the following documents.

The technology disclosed in the Jpn. Pat. Appln. KOKAI Publication No. 05-81695 is such that a photodetector is divided into two to improve the precision of a sensor for use as a low power and for use as a high power. In addition, a photodetector is divided into a plurality of portions to calculate at a cell which receives laser beams and a cell which does not receive laser beams, so that measures are taken against a dark current and an offset voltage.

The technology disclosed in the Jpn. Pat. Appln. KOKAI Publication No. 2003-281770 is such that one photo detector cell is used, and a plurality of amplifiers having different gains are provided.

The technology disclosed in the Jpn. Pat. Appln. KOKAI Publication No. 2003-23327 is such that after adding outputs of a plurality of current amplifying circuits, the voltage thereof is changed and amplified to be output by a current-voltage conversion circuit.

The technology disclosed in the Jpn. Pat. Appln. KOKAI Publication No. 2003-63543 is such that a control signal is sent through optical transmission with a photodetector, thereby controlling a decoder, a memory, and the sensitivity of the photodetector with an electronic volume.

The technology disclosed in the Jpn. Pat. Appln. KOKAI Publication No. 2005-182868 intends to calculate received laser noise to remove laser noise from the reflected light from the disk.

In comparison with the conventional CD using an infrared laser, and DVD using a red laser, an optical pickup device using a blue laser has been developed in recent years as can be seen in the HD DVD or the like. For this reason, the capacity of the disk to be handled has been increased, and a higher recording density, a higher speed recording, and a high-speed recording are demanded. In order to realize such a demand, an attempt is made to heighten the revolution speed of the optical disks. As a result, the frequency band of the recording/reproduction signal which is handled at the pickup unit for detecting light becomes 100 MHz. Therefore, the recording laser power becomes approximately 150 times as large as the reproducing laser power. As a result, there arises a problem in that the laser radiates an extremely large heat and a radiation angle of the laser is drifted.

Furthermore, the problem of the conventional APC-PDIC will be described as follows.

1. An adjustment volume is required as an external component of the APC-PDIC.
2. The consumed power thereof is large. At the recording time, a wide dynamic range, a frequency characteristic having a wide band exceeding 100 MHz, and a high through rate are required, so that the consumed power thereof is increased.
3. Since one receiving cell is provided, it is extremely difficult to take a balance of the characteristic at the time of recording and the characteristic at the time of reproduction.

1.1 There will be explained hereinbelow a reason for the need of volume and a reason for the need of volume adjustment. In the beginning, a partial light amount of laser for reproducing/recording a disk is monitored by the APC-PDIC, and the laser amount is converted to a voltage. The voltage is fed back to the laser drive circuit. Consequently, an auto power control is performed in order to set the light amount of laser to a definite level.

Consequently, when an outgoing light amount of the objective lens in the pickup is set to a predetermined light amount, an output voltage of the APC-PDIC must be set to a definite level. That is because no individual different should be generated with the pickup. However, owing to a disparity in each component as described hereinbelow, the output voltage of the APC-PDIC does not become definite:

1) a disparity in sensitivity of the APC-PDIC itself;
2) a disparity resulting from the wavelength sensitivity of the APC-PDIC itself;
3) a disparity in light amount of laser;
4) a disparity in wavelength of laser;
5) a disparity in position of the APC-PDIC; and
6) a disparity in transmission factor or reflection factor of the components of the optical system.

In order to compensate for such a disparity, an external volume is required.

There will be explained a problem in the case where the volume of 1) is present. Because of the reasons, the volume is required. However, three waves are required for CD, DVD and HD DVD. In order to allow the pickup to perfectly cope with the problem, the number of volumes is at least three.

As a result, for the need of the volumes, the cost of the components thereof increases. Furthermore, with respect to slim drives as well as ultra slim drives, the number of components such as a laser increases for coping with the three waves. As a consequence, there arises a large problem in that the attachment place and the installation place for the volume does not exist. Furthermore, the personnel expenditure is required because of the need of the volume adjustment, whereby the price of the pickup rises and the cost itself increases.

As described above, there also arises a problem in that since the number of components such as a laser for three waves increases, there arises a problem in that the design of an adjustment instrument becomes difficult.

2.2 There will be explained hereinbelow that the consumed power is large. In the beginning, there is provided one photo detector cell PD in the conventional photodetector circuit. An output of current depending on the partial light amount received by the photo detector cell PD is current-voltage converted at a current-voltage conversion circuit U1. To the current-voltage conversion circuit U1, a plurality of transimpedances RA1 and RA2 are connected for changing over a current-voltage conversion gain.

A signal output from the current-voltage conversion circuit U1 passes through either an external gain adjustment volume VR1 side or VR2 side with a switch, and the signal is transmitted to the side of a voltage amplifying circuit U3 on the rear stage. In the voltage amplifying circuit U3, the gain is determined from the volume VR1 or VR2, and resistors Rg and Rf possessed by the circuit itself. Then, the voltage from the volume VR1 or VR2 is amplified to be derived as an output of the APC-PDIC from an output terminal 76.

In general, at the time of reproduction, the light amount input to the APC-PDIC is small, and thus, the transimpedance and the gain adjustment volume are set in such a manner that the gain is heightened. Since the light amount at the time of recording is large, the transimpedance and the gain adjustment volume are set in such a manner that the gain is reduced. Therefore, a plurality of gain modes can be obtained. As described above, the gain volume is input in order to compensate for the disparity of each component.

In particular, at the time of recording, DVD with 16-fold speed and CD with 52-fold speed must be coped with and followed. As a consequence, the dynamic range thereof is widened, and the frequency band is widened to 100 MHz or more, so that the through rate must be heightened. Furthermore, the load condition is largely associated with the consumed power. 10 KΩ//20 PF, 1 KΩ//50 PF, and 10 KΩ//50 PF are used as a general load condition. As a result, the consumed power is enlarged.

In this manner, for the simplification of the control, the gain mode is decreased, and the dynamic range is set to a large level for coping with a higher speed. This method is not changed so much. As a consequence, along with an increase in the number of waves to three waves, the consumed power increases against to the will of the system designers, so that time, labor and money must be consumed to take measures against heat radiation.

There will be explained the second point problem. When the consumed power is large, the temperature within the drive rises, and an excessive development cost and labor are required for the measures taken against heat radiation. This is an extremely large problem. In a slim drive or ultra slim drive incorporated in a notebook type personal computer, the consumed power largely depends on life of batteries, and further, the life of the drive itself and reliability thereof.

As a result of a higher speed, an increase in the number of waves to three waves, and larger consumed power, there arises a problem in that the life of batteries is shortened, and further, the life of the drive itself is shortened to thereby deteriorate the reliability thereof.

In particular, compared with the blue laser and the infrared laser, the temperature characteristic of the red laser used in DVD is extremely inferior. When the temperature rises, a ratio in the fall of the output of laser is large. In other words, those skilled in the art already know that when the temperature rises, a so-called IL curve (I = laser drive current, L = laser light amount) is laid and the output of laser is lowered. For this reason, a set manufacturer manufacturing optical disks has an extremely hard time for taking measures against the temperature and a control of the laser light amount. Compared with a desk-top type personal computer, a casing is small and the heat radiation capability is small in a slim drive or ultraslim drive, and thus, such a tendency is conspicuous.

When the consumed power increases, there arises a large problem in design of a flexible substrate which is mounted on a pickup in addition to a problem of heat generation. That is, the reason is that the width of a wiring must be thickened such that a current allowable by the portion of the consumed power is allowed to flow. However, with the slim drive and the ultra slim drive, there is a size of a drawing width limit to the substrate of the main body of the flexible drive. In general, there arises a large problem in that the 1 mm/1A rule which is a design rule cannot be observed, and a common impedance or the like resulting from thinning of the wiring width is generated, so that the operation of the circuit becomes precarious or the like.

Reasons for the third point will be explained hereinbelow.

In the beginning, in the conventional APC method, one photo detector cell is used to monitor the laser light amount. For this reason, it is required to take a balance between two specifications; the specification of the reproduction system and the specification of the recording system. In the specification of the reproduction system, the frequency band may be low on the order of 1 MHz. However, it is demanded that the noise level is low and the signal output is large.

In the specification of the recording system, contrary to the specification of the recording system, it is demanded in order to faithfully monitor the recording pulse, the frequency band is set to 100 MHz or more. It is demanded that a low noise is generated on the low power side of the recording pulse which changes at a ratio of 1:(10 to 150) of a low power to a high power depending on the double speed recording mode. That is, a wide band and a low noise are demanded.

3.3 Since only one photo detector cell is provided, it is extremely difficult to take a balance between the characteristic at the recording time and the characteristic at the reproduction time. The problem will be explained. Conventionally, because of opposite specifications between the reproduction system and the recording system, it has been extremely difficult to take a balance between the two specifications. Further, in the optical disks, a high-speed change-over is demanded such that the reproduction is performed immediately after the recording and the recording is performed immediately after the reproduction. In the conventional circuit, there is a problem in that the constant at the change-over time on the lower band side becomes dominant, and a change-over of the recording and the reproduction can not be performed at a high speed.

In addition, in the conventional APC-PDIC, an increase in the amount of light received (a monitor amount) of the APC-PDIC with respect to the laser outgoing light amount, namely, an increase in the light amount monitored with respect to the laser beam power in the midst of the optical path enables obtaining a monitor signal with a good SN and stability of laser beam power. However, there is a problem in that an outgoing power toward the object, namely, the recording power is insufficient. On the contrary, a decrease in the monitor amount disables obtaining a sufficient sensitivity of the laser light amount monitor, and a sufficient monitor signal voltage, so that the SN is deteriorated. As a result, there are problems that stability of laser light amount is deteriorated, and noises are occurred on laser.

Since an enlargement of a sensor area in order to raise the SN of the reproduction system suppresses a peaking of the frequency band in relation to the sensor capacity, the phase compensation capacitor having substantially the same capacity as the sensor capacity is required. As a consequence, the frequency band is narrowed, but there is no problem in the reproduction system. However, as a result, there is a large disadvantage in that the monitor frequency band at the recording time becomes insufficient, and decreased. This point refers to an explanation to the effect that it is required to take a balance between the two specifications; the specification of the reproduction system and the specification of the recording system, and the balance thereof is important.

Moreover, there is a large disadvantage in that an enlargement of the sensor area, namely, an enlargement of the phase compensation capacitor along therewith leads to an enlargement of the chip size, and a rise in the unit price of the IC.

Jpn. Pat. Appln. KOKAI Publication No. 2004-22051 discloses a technology in which a plurality of photodetectors corresponding to different wavelengths and a current-voltage conversion circuit for amplifying an output of the photodetectors are provided, and the photodetectors and the current-voltage conversion circuit are changed over with a switch according to a used wavelength.

Jpn. Pat. Appln. KOKAI Publication No. 2004-342278 discloses a technology in which a plurality of photodetectors and a current-voltage conversion circuit for amplifying an output of the photodetectors are provided, and gain volume resistors of the current-voltage conversion circuit are provided for each wavelength, so that the photodetectors and the current-voltage conversion circuit are changed over with a switch according to a used wavelength.

Jpn. Pat. Appln. KOKAI Publication No. 2004-273033 discloses a technology for adjusting with no steps a gain of a light receiving circuit by using an electronic volume and a memory.

As seen in this document, a variable gain with no steps is the most favorable. For example, with a notebook type personal computer, it is required to mount APC-PDIC or the like in a thickness of 4 mm in an ultra slim drive. For this reason, a package size having a height of 3 mm or less is demanded in an APC-PDIC package. Regrettably, in the method of the document, in consideration of a circuit scale of a plurality of memories, electronic volumes and decoders, it is limitlessly impossible to mount all the photo detector cells of $\phi$0.7 mm and the circuit in a package having a size of

3 mm $\times$ 3 mm at the present time.

As has been described above, in the prior art, it is extremely difficult to take a balance between the characteristic at the recording time and the characteristic at the reproduction time because of the need of volumes, a large consumed power, and one photo detector cell. Such a problem is not settled in a sufficient manner.

An object of the embodiments is to enable stably performing a higher speed recording and a high-speed recording by accurately monitoring the light amount of laser.

Furthermore, description will be made by means of classification.

(A1) An object of one embodiment is to provide a cheap and superior photodetector circuit capable of performing stably a higher speed recording and a high-speed recording of optical disks by accurately monitoring the light amount of laser. Another object thereof is to provide a method for deriving a laser light emission amount control signal and an optical pickup device having a stable reliability along therewith.

(B1) According to another embodiment of the invention, an object thereof is to provide a cheap photodetector circuit and an optical disk apparatus which are capable of performing stably a higher speed recording and a high-speed recording of optical disks by accurately monitoring a laser power even when a laser radiation angle from a laser light source is drifted owing to a temperature rise, and which contribute to a lower consumed power. Furthermore, the object thereof is to provide a photodetector circuit and an optical disk apparatus which are effective for alleviating an allowable range of an attachment position for the photodetector and as a result realize a lower consumed power.

(C1) Another embodiment of the invention has been made to solve the above-described problems. An object thereof is to provide a cheap and superior integrated photodetector circuit and optical disk apparatus which enable omitting an external adjustment component and an automation of adjustment and which are capable of stably performing a higher speed recording and a high-speed recording of optical disks by accurately monitoring the light amount of laser.

(A2) The photodetector circuit according to one embodiment is configured so that two photo detector cells are provided thereon, and at the time of a disk reproducing laser power, electric signal outputs subjected to an opto-electric conversion from both the photo detector cells are added to be used while at the time of a disk recording laser power, only an electric signal output is used which has been subjected to an opto-electric conversion from either of the photo detector cells.

(B2) Another embodiment is a photodetector circuit which monitors the light amount of laser. The photodetector circuit comprises a first photo detector cell formed by arranging a plurality of rectangle-shaped light receiving areas on a substrate and connecting the light receiving areas with a metal wiring, and a second photo detector cell formed by connecting the light receiving areas except for the first photo detector cell with a metal wiring. The circuit is characterized by being constituted such that both outputs of the first photo detector cell and the second photo detector cell are used at the reproduction time while either of the outputs of the first photo detector cell and the second photo detector cell is used at the recording time.

(C2) Furthermore, according to another embodiment, there is provided a photodetector circuit which monitors the light amount of laser, comprising: a photodetector PD; an amplifying circuit U1 which amplifies and outputs an output current from the photodetector; impedances VRr, VRw for use in reproduction and for use in recording, which are accumulated in operation by means of the change-over of a gain of the amplifying circuit at the reproduction time and at the recording time; a gain control circuit which produces fixed gain modes of 6 types to 27 types by the impedance value VRr for use in reproduction and the impedance value VRw for use in recording respectively, and one type of the fixed gain mode is able to set, and the gain of the amplifying circuit is changed over and controlled at the reproduction time and at the recording time; and a gain switching terminal to give a setting signal with respect to the gain control circuit from the outside in order to obtain one type of the fixed gain mode. The meaning of above mentioned fixed gain modes and its setting include follows. The fixed gain modes present a number of the fixed gain modes, and the gain modes are selected when the PDIC is designed or manufactured. And it presents to selecting the gains or to setting the gains from the fixed gain modes which are determined to the individual PDICs.

According to another aspect, there is provided a photodetector circuit which monitors a light emission amount of laser, comprising a photodetector including a photo detector cell PD-A of a reproduction system and a photo detector cell PD-B of a recording system; a first amplifying circuit U1 which amplifies and outputs an output current from the photo detector cell of the reproduction system; a second amplifying circuit which amplifies and outputs an output current from the photo detector cell of the recording system; an impedance VRA1 for use in reproduction, which is connected to the first amplifying circuit U1 to be accumulated such that a gain of the first amplifying circuit U1 is changed over; an impedance VRA2 for use in recording, which is connected to the second amplifying circuit to be accumulated such that a gain of the second amplifying circuit U2 is changed over; a gain control circuit which produces fixed gain modes of 6 types to 27 types by the impedance VRA1 for use in reproduction and a value of impedance VRA2 for use in recording; and a gain switching terminal to give a setting signal with respect to the gain control circuit from the outside in order to obtain one type of the fixed gain mode.

The invention can be more fully understood from the following detailed description when taken in conjunction with the accompanying drawings, in which:

FIG. 1 is a block diagram showing an exemplary configuration of an information recording and reproducing device (an optical disk apparatus) to which an embodiment of the present invention can be applied;

FIG. 2 is a schematic diagram shown for explaining a basic configuration of an internal equivalent circuit of an APC-PDIC for use in an optical head device which is incorporated in the optical disk apparatus shown in FIG. 1;

FIG. 3 is a schematic diagram showing a first embodiment of the internal equivalent circuit of the APC-PDIC;

FIG. 4 is a schematic view showing one example of an outline of a photo detector cell of the APC-PDIC;

FIG. 5 is a schematic diagram showing one embodiment of the APC-PDTC of FIG. 2 and a laser drive circuit;

FIG. 6 is a schematic diagram showing another embodiment of the internal equivalent circuit of the APC-PDIC;

FIG. 7 is a schematic diagram showing still another embodiment of the internal equivalent circuit of the APC-PDIC;

FIG. 8 is a schematic diagram showing still another embodiment of the internal equivalent circuit of the APC-PDIC;

FIG. 9 is a schematic diagram showing further still another embodiment of the internal equivalent circuit of the APC-PDIC;

FIG. 10 is a schematic diagram showing another embodiment of the internal equivalent circuit of the APC-PDIC;

FIG. 11 is a schematic diagram showing still another embodiment of the internal equivalent circuit of the APC-PDIC, the diagram showing one example of a circuit provided with a reference voltage circuit inside thereof;

FIG. 12 is a schematic diagram showing further still another embodiment of the internal equivalent circuit of the APC-PDIC, the diagram showing a case in which a current amplifier is used in a first stage amplifier;

FIG. 13 is a schematic diagram showing still another embodiment of the internal equivalent circuit, the diagram showing a case in which a current amplifier is used in a first stage amplifier;

FIG. 14 is a schematic diagram showing an example of a basic circuit of a current mirror circuit;

FIG. 15 is a schematic diagram showing an embodiment in the case where the current mirror circuit is used in a first stage circuit of the APC-PDIC;

FIG. 16 is a view showing another embodiment of a PD cell pattern;

FIG. 17 is a view showing still another embodiment of the PD cell pattern;

FIG. 18 is a view showing still another embodiment of the PD cell pattern;

FIG. 19 is a view showing another embodiment in which the PD cell pattern is divided into three parts;

FIG. 20 is a diagram showing one example of a specific circuit configuration which controls an output of a TIA circuit or a current amplifier to high impedance;

FIG. 21 is a diagram showing a basic configuration of an APC-PDIC circuit for use in an optical head device which is incorporated in the optical disk apparatus of FIG. 1;

FIG. 22 is an explanatory view showing a configuration of a physical pattern of photo detector cells PD-A12 and PD-B of FIG. 21;

FIG. 23 is an explanatory view showing a configuration of another example of the physical pattern of the photo detector cells PD-A12 and PD-B of FIG. 21;

FIG. 24 is an explanatory view showing a configuration of still another example of the physical pattern of the photo detector cells PD-A12 and PD-B of FIG. 21;

FIG. 25 is an explanatory view showing a configuration of still another example of the physical pattern of the photo detector cells PD-A12 and PD-B of FIG. 21;

FIG. 26 is a configuration explanatory diagram showing the APC-PDIC circuit shown in FIG. 21 in more detail;

FIG. 27 is an explanatory view showing a configuration of still another example of the physical pattern of the photo detector cells PD-A12 and PD-B of FIG. 21;

FIG. 28 is an explanatory view showing a configuration of still another example of the physical pattern of the photo detector cells PD-A12 and PD-B of FIG. 21;

FIG. 29 is an explanatory view showing a configuration of still another example of the physical pattern of the photo detector cells PD-A12 and PD-B of FIG. 21;

FIG. 30 is an explanatory view showing a configuration of still another example of the physical pattern of the photo detector cells PD-A12 and PD-B of FIG. 21;

FIG. 31 is an explanatory view showing a configuration of still another example of the physical pattern of the photo detector cells PD-A12 and PD-B of FIG. 21;

FIG. 32 is a view showing one embodiment of the photo detector cell of the APC-PDIC for use in the optical head device which is incorporated in the optical disk apparatus shown in FIG. 1;

FIG. 33 is a diagram showing a first embodiment of the internal equivalent circuit of the APC-PDIC;

FIG. 34 is a view showing another embodiment of the photo detector cell of the APC-PDIC;

FIG. 35 is a diagram showing another embodiment of the internal equivalent circuit of the APC-PDIC;

FIG. 36 is a diagram showing still another embodiment of the internal equivalent circuit of the APC-PDIC;

FIG. 37 is a diagram showing further still another embodiment of the internal equivalent circuit of the APC-PDIC;

FIG. 38 is a diagram showing still another embodiment of the internal equivalent circuit of the APC-PDIC;

FIG. 39 is a diagram showing still another embodiment of the internal equivalent circuit of the APC-PDIC;

FIG. 40 is a diagram showing still another embodiment of the internal equivalent circuit of the APC-PDIC;

FIG. 41 is a diagram showing still another embodiment of the internal equivalent circuit of the APC-PDIC;

FIG. 42 is a diagram showing further still another embodiment of the internal equivalent circuit of the APC-PDIC;

FIG. 43 is a diagram showing further still another embodiment of the internal equivalent circuit of the APC-PDIC;

FIG. 44 is a diagram showing still another embodiment of the internal equivalent circuit of the APC-PDIC;

FIG. 45 is a diagram showing still another embodiment of the internal equivalent circuit of the APC-PDIC;

FIG. 46 is a diagram showing further still another embodiment of the internal equivalent circuit of the APC-PDIC;

FIG. 47 is a diagram showing an example of a basic circuit of the current mirror circuit;

FIG. 48 is a diagram showing an example in the case where the current mirror circuit is applied to the first stage circuit of the APC-PDIC;

FIG. 49 is a diagram showing an example of a specific circuit of a multiple gain mode circuit in the APC-PDIC according to the invention;

FIG. 50 is a diagram showing another example of the specific circuit of the multiple gain mode circuit in the APC-PDIC according to the invention; and

FIG. 51 is an explanatory view showing a gain mode characteristic of the APC-PDIC according to the invention.

Various embodiments according to the invention will be described hereinafter with reference to the accompanying drawings. In general, according to one embodiment of the invention, the explanation shown hereinbelow is one embodiment and does not intend to restrict a device and a method of the present invention.

In a plurality of embodiments which will be explained hereinbelow, the following configuration is realized.

First and second photo detector cells PD-A and PD-B are independently provided. At the time of a disk reproducing laser power, an addition output of electric signals subjected to opto-electric conversion from the first and second photo detector cells is derived as a control signal of a laser drive circuit by a first processing circuit 100. At the time of a disk recording laser power, on the other hand, an electric signal subjected to opto-electric conversion from any one of the first and second photo detector cells is derived as a control signal of the laser drive circuit by a second processing circuit 200.

Furthermore, the embodiment is a photodetector circuit for monitoring a light emission amount of laser of an optical disk apparatus, the circuit having: at least three light receiving areas arranged therein; a first photo detector cell formed by outside light receiving areas connected with a metal wiring, and a second photo detector cell formed by an outside area.

The photodetector circuit further comprises: a photodetector PD; an amplifying circuit U1; reproducing and recording integrated impedances VRr and VRw for selectively operating a gain of the amplifying circuit at the reproduction time and at the recording time; a gain control which produces fixed gain modes of 6 types to 27 types by the impedance value VRr for use in reproduction and the impedance value VRw for use in recording respectively, and one type of the fixed gain mode is able to set, and the gain of the amplifying circuit is changed over and controlled at the reproduction time and at the recording time; and a gain switching terminal for giving a setting signal to the gain control circuit from the outside in order to obtain one type of the fixed gain mode. The meaning of above mentioned fixed gain modes and its setting include follows. The fixed gain modes present a number of the fixed gain modes, and the gain modes are selected when the PDIC is designed or manufactured. And it presents to selecting the gains or to setting the gains from the fixed gain modes which are determined to the individual PDICs.

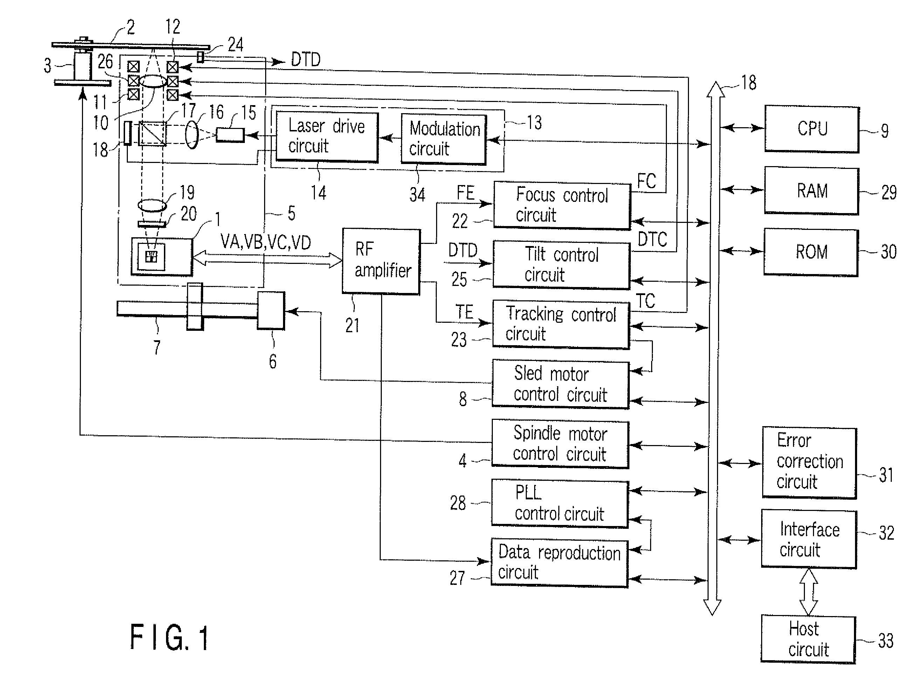

FIG. 1 is a block diagram showing a configuration of an optical disk apparatus to which the present invention is applied. First, an outline of the operation of the optical disk apparatus will be explained.

An optical disk 2 is a read-only optical disk or an optical disk capable of recording user data. The optical disk 2 is rotationally driven with a spindle motor 3. The spindle motor 3 attached with the optical disk 2 controls the revolution number of the optical disk 2 and the spindle motor 3 in such a manner that reproduction data is stably read.

Information is recorded in and reproduced from the optical disk 2 by an optical pickup head (hereinafter referred to as PUH) 5. The PUH 5 is connected to a sled motor 6 via a gear 7, and the revolution of the sled motor 6 allows the PUH 5 to move in a radial direction of the optical disk 2. The sled motor 6 is controlled by a sled motor control circuit 8.

A seek destination address of the PUH 5 is input to the sled motor control circuit 8 from a CPU 9. On the basis of this address, the sled motor control circuit 8 controls the sled motor 6.

The PUH 5 is provided with an objective lens 10 supported with a wire or a plate spring (not shown). The objective lens 10 can be moved in a focusing direction (an optical axis direction of the lens) with the drive of a focus drive coil 11, and can be moved in a tracking direction (a direction perpendicular to an optical axis of the lens) with the drive of a tracking drive coil 12.

Laser light is emitted from a semiconductor laser 15 by a laser drive circuit 14 within a laser control circuit 13. The laser light emitted from the semiconductor laser 15 is radiated on the optical disk 2 via a collimator lens 16, a half prism 17 and the objective lens 10.

In the meantime, laser light which transmits a half prism 17 is converted to an electric signal by an APC-PDIC 18, and is output to the laser drive circuit 14. The APC-PDIC 18 is a so-called front monitor. Therefore, the laser drive circuit 14 monitors a light amount of the laser light emitted from the semiconductor laser 15, and makes a controls such that the light amount instructed to the CPU 9 is constantly emitted.

The light reflected from the optical disk 2 is led to a PDIC 1 via the objective lens 10, the half prism 17, a condensing lens 19 and a cylindrical lens 20.

The PDIC 1 comprises, for example, four divided photodetector cells. A detection signal of each of the divided photodetector cells is output to a high frequency (hereinafter referred to as RF) amplifier 21. The RF amplifier 21 synthesizes signals from the photodetector cells to output a focusing detection signal FE, a tracking detection signal TE, and a total addition signal RF.

A focusing control circuit 22 creates a focus control signal FC on the basis of the focusing detection signal FE. The focus control signal FC is supplied to the focus drive coil 11 which moves the objective lens 10 in a focusing direction, so that a focus servo is performed in which laser light is accurately focused on a recording film of the optical disk 2 at all times.

A tracking control circuit 23 creates a tracking control signal TC on the basis of the tracking detection signal TE. The tracking control signal TC is supplied to the drive coil 12 which moves the objective lens 10 in a tracking direction, so that a tracking servo is performed wherein laser light constantly traces tracks formed on the optical disk 2. When the objective lens 10 is controlled by the tracking control circuit 23, the sled motor 6, namely, the PUH 5 is controlled by the sled motor control circuit 8 in such a manner that the objective lens 10 is positioned in the vicinity of a predetermined position of the PUH 5.

A tilt sensor 24 emits tilt detection light beams on the optical disk 2, and the reflection light is received with a position sensing device (PSD) to detect a tile of the disk 2. A detection output of the tilt sensor 24, namely, a disk tile detection signal DTD is supplied to a tilt control circuit 25.

The tilt control circuit 25 creates a disk tilt control signal DTC on the basis of the disk tilt detection signal DTD. The disk tilt control signal DTC is supplied to a tilt drive coil 26, so that an inclination of the objective lens 10 is controlled in such a manner that the tilt becomes 0 with respect to the disk 2.

The focus servo, the tracking servo and the tilt control are performed, whereby a change of the reflection light from pits formed on tracks of the optical disk 2 is reflected on the addition signal RF, namely, the signal (VA + VB + VC + VD) obtained by adding all the outputs of four photo detector cells of the PDIC 1.

The RF signal is supplied to a data reproduction circuit 27. The data reproduction circuit 27 decodes information by a PRML (Partial Response and Most Likelihood) system on the basis of a reproduction clock signal from a PLL circuit 28.

The decoded information signal is error-corrected by a RAM 29 and an error correction circuit 31 via a bus 18 upon receipt of an instruction of the CPU 9. Then, the information signal is sent to a host circuit 33 outside of the drive from an interface circuit 32 by means of a general ATAPI interface.

The spindle motor control circuit 4, the spindle motor control circuit 8, the laser control circuit 13, the PLL control circuit 28, the data reproduction circuit 27, the focus control circuit 22, the tracking control circuit 23, the error correction circuit 31, the RAM 29 and a ROM 30 are controlled by the CPU 9 via the bus 18. The CPU 9 generally controls the recording and reproduction device in accordance with an operation command provided from the host circuit 33 via the interface circuit 32. In addition, the CPU 9 uses the RAM 29 as a work area to perform a predetermined operation in accordance with a program recorded on the ROM 30.

Until this point, there has been explained reproduction of the information signal recorded on the disk 2. Recording of the information signal will be briefly explained.

The information signal sent through the ATAPI interface from the host circuit 33 outside of the drive is sent to the bus 18 via the interface circuit 32. Then, by using the error correction circuit 31 and the RAM 29, an error correction signal, additional information of the header or the like are added to the information signal to become a recording signal.

The recording signal is 8-16 modulated at a modulation circuit 34 within the laser control circuit 13. The modulated information signal is converted to light from the semiconductor laser 15 by the laser drive circuit 14 to be output. The light-output recording signal is applied to the optical disk 2 via the collimator lens 16, the half prism 17, and the objective lens 10. On the optical disk 2, a recording signal corresponding to light intensity is recorded. Reproduction of the recording signal is as already described, and the detailed explanation thereof is omitted.

In the beginning, in each embodiment, explanation will be given to the device capable of stably performing a higher speed recording and a high-speed recording of an optical disk.

(A3) There will be explained an embodiment of a method for deriving a laser light emission amount control signal and an optical pickup device which is a cheap and excellent light receiving circuit and which has stability and high reliability.

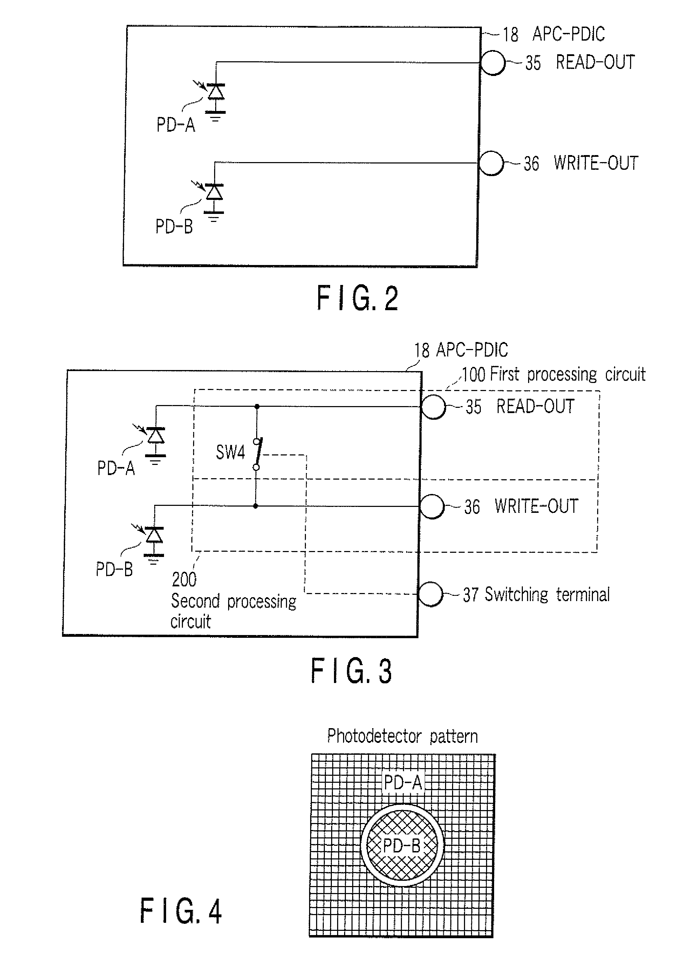

FIG. 2 is a basic configuration example shown for allowing the invention to be understood with ease. The PD, which is one in the prior art, is divided into two, so that one is used for reproduction while the other is used for recording.

At the reproduction time, a current corresponding to a reproducing laser power is output from the photo detector cell PD-A to a READ-OUT terminal 35. At the recording time, a current corresponding to a recording laser power (a recording information signal) is output from the photo detector cell PD-B to a WRITE-OUT terminal 36.

Incidentally, light for measuring the reproducing laser power and the recording laser power is not light reflected from the disk, and the light is used a part of light in the midst of an optical path which leads from a light source to the disk.

FIG. 3 is a diagram showing a first embodiment which is different from the basic configuration of FIG. 2 in that a switch SW4 is provided thereon. In this embodiment, a signal for turning on (ON) the switch SW4 is input from a switching terminal 37 at the reproduction time. Then, currents from both the photo detector cell PD-A and the photo detector cell PD-B corresponding to the reproducing laser power are synthesized to be output to the READ-OUT terminal 35.

At the recording time, on the other hand, a signal for turning off (OFF) the switch SW4 is input from the switching terminal 37. Then, only the current from the photo detector cell PD-B corresponding to the recording laser power (recording information signal) is output to the WRITE-OUT terminal 36.

Further, in FIG. 3, a portion 100 surrounded by a dot line is a first processing circuit, and various embodiments of this portion will be described later. In addition, a portion 200 surrounded by a dot line is a second processing circuit, and various embodiments of this portion will be also described later. Consequently, the first and second processing circuits 100 and 200 may be formed on a same substrate (first substrate) as the photo detector cell. Instead, the first and second processing circuits 100 and 200 may be formed over the first substrate and a second substrate on which the laser drive circuit 14 is formed.

FIG. 4 is a view showing one embodiment of a formation pattern on the substrate of the photo detector cell PD-A and the photo detector cell PD-B used in the embodiment of FIGS. 2 and 3. The photo detector cell PD-A is used for reproduction as described above. Since the laser power at the reproduction time is small, and a required frequency band may be low, the PD cell size is in the larger size group. Furthermore, the photo detector cell PD-B is also utilized at the reproduction time, so that the output of the photo detector cell PD-B is added to the output of the photo detector cell PD-A.

On the other hand, the photo detector cell PD-B is used for recording as described above. Since the laser power at the recording time is about 10 times to 150 times larger than the laser power at the reproduction time, the PD cell size becomes small.

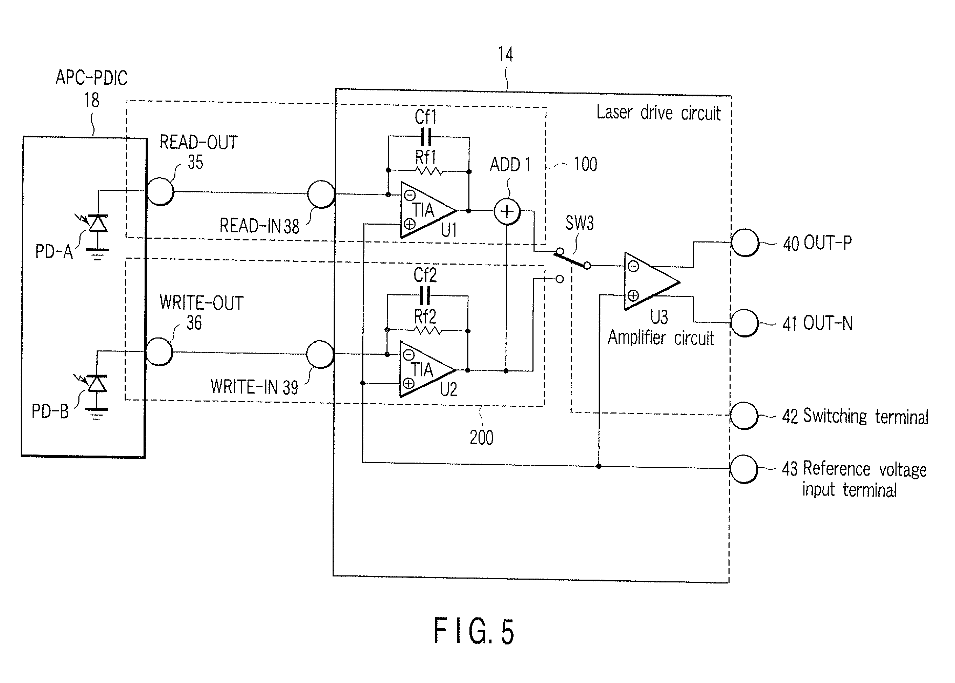

FIG. 5 shows an embodiment in which the laser drive circuit 14 which is a rear stage circuit is connected to the PD used in the embodiment of FIG. 2. It is assumed that a light receiving pattern of the photo detector cell is one used in the embodiment of FIG. 4. Incidentally, terminals 40 to 43 in the drawing are located inside of the laser drive circuit 14, and thus, the terminals do not exist in actuality. These are provided for convenience for facilitating an explanation and understanding of the present invention.

In this embodiment, an output current of the photo detector cell PD-A is a current which corresponds to the recording information signal. The output current is input to a READ-IN terminal 38 of the laser drive circuit 14 at the rear stage via the READ-OUT terminal 35.

An output current of the photo detector cell PD-B is a current corresponding to the recording information signal. The output current is input to a WRITE-IN terminal 39 of the laser drive circuit 14 at the rear stage via the WRITE-OUT terminal 36.

At the reproduction time, a switch SW3 of the laser drive circuit 14 is set to the side of a TIA circuit U1 on the basis of a signal from a switching terminal 42. The TIA circuit is also referred to as a transimpedance circuit or a current-voltage conversion circuit.

An output current of the photo detector cell PD-A is input to the TIA circuit U1 of the laser drive circuit 14 via the terminals 35 and 38. Here, the current corresponding to the reproducing laser power is subjected to current-voltage conversion to be output to an addition circuit ADD1.

At the same time, an output current from the photo detector cell PD-B is also input to a TIA circuit U2 of the laser drive circuit 14 via the terminals 36 and 39. Here, the current corresponding to the reproducing laser power is subjected to current-voltage conversion to be output to the terminal of the switch SW3.

An output signal from the TIA circuit U2 and an output signal from the TIA circuit U1 are added at the addition circuit ADD1, and the obtained signal is input to an amplifying circuit U3 via the switch SW3 as a signal corresponding to the reproducing laser power. Here, the input is subjected to single-ended/differential conversion. An output of the amplifying circuit 3 is transmitted to an APC system circuit inside of the laser drive circuit via an output terminal OUT-P 40 and an output terminal OUT-N 41.

At the recording time, the switch SW3 of the laser drive circuit 14 is set to the side of the TIA circuit U2 on the basis of a signal from the switching terminal 42. An output of the photo detector cell PD-B is input to the TIA circuit via the terminals 36 and 39. At the TIA circuit U2, the current corresponding to the recording laser power (the recording information signal) is subjected to current-voltage conversion to be output. This output is input to the amplifying circuit U3 via the switch SW3 set to the side of the TIA circuit U2, and subjected to single-ended/differential conversion. An output of the amplifying circuit U3 is transmitted to the rear stage of the APC system circuit inside of the laser drive circuit via the output terminals OUT-P 40 and OUT-N 41.

A reference voltage is sent and input to the reference voltage input terminal 43 from the reference voltage generation circuit inside of the laser drive circuit, and is supplied to the TIA circuits U1 and U2 and the amplifying circuit U3. The TIA circuits U1 and U2 also serve as means for supplying a reverse bias to the photo detector cells PD-A and PD-B.

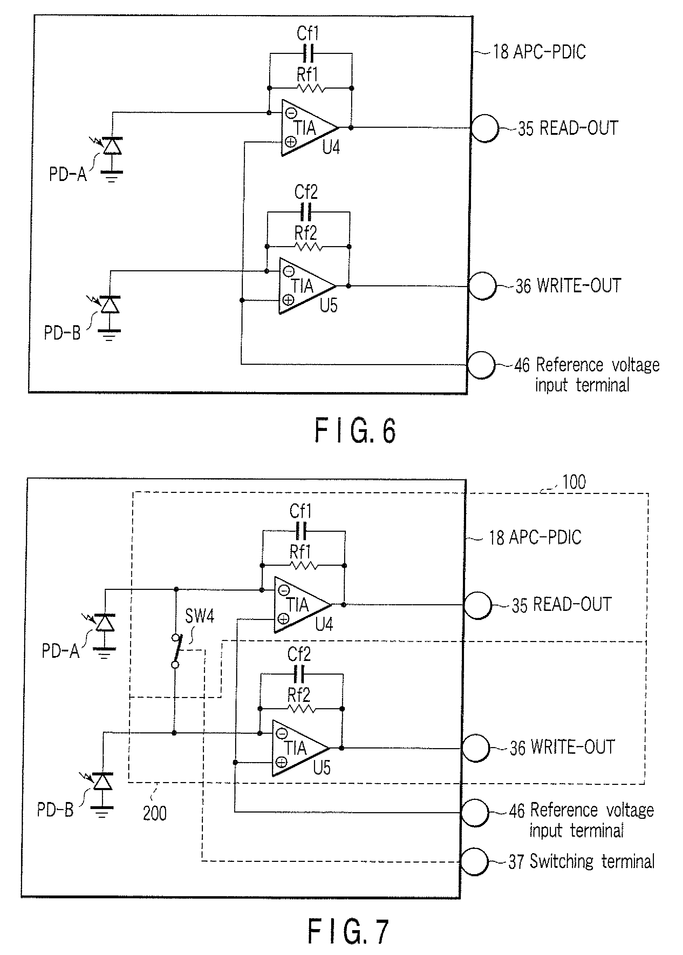

FIG. 6 shows an embodiment in which the TIA circuits U1 and U2 which exist in the laser drive circuit used in the embodiment of FIG. 5 are incorporated in the PDIC used in the embodiment of FIG. 2 as TIA circuits U4 and U5. For facilitating understanding thereof, components having the same functions as in FIG. 5 are denoted by the same reference numerals.

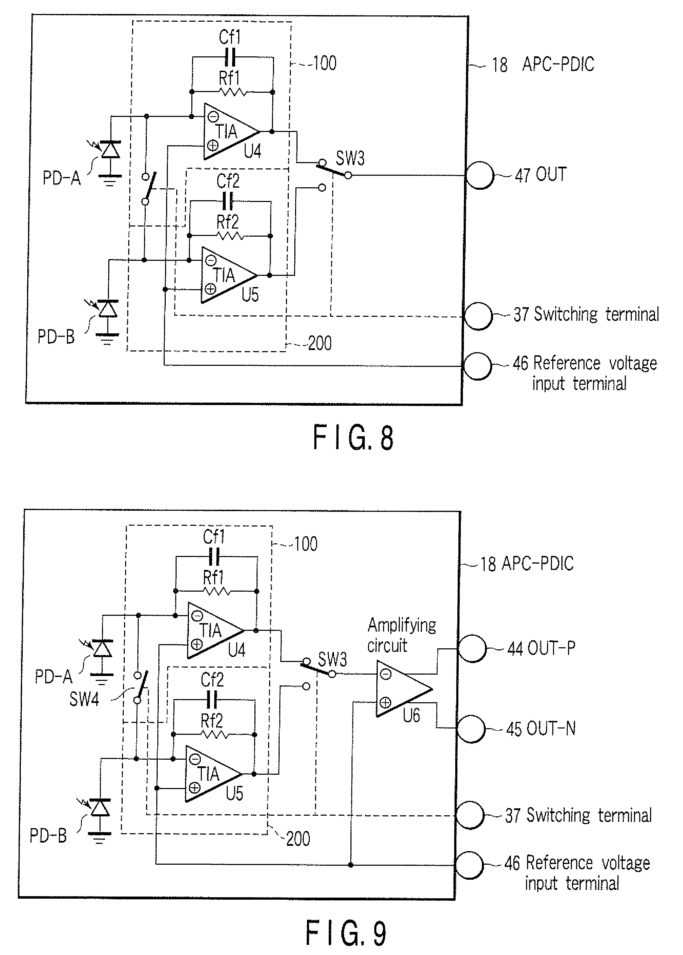

FIG. 7 shows an embodiment in which the TIA circuit which exists in the laser drive circuit used in the embodiment of FIG. 5 is incorporated in the PDIC used in the embodiment of FIG. 3. Also for facilitating understanding, components having the same functions as in FIG. 5 and 6 are denoted by the same reference numerals. In this case, the addition circuit ADD1 in the laser drive circuit 14 is omitted.

FIG. 8 shows an embodiment in which, in the PDIC used in the embodiment of FIG. 3, the TIA circuits U1 and U2 which exist in the laser drive circuit used in the embodiment of FIG. 5 are incorporated as TIA circuits U4 and U5, and the switches SW3 and SW4 are incorporated. Consequently, in this case, the terminals 35 and 36 in FIG. 5 are put together in a terminal 47, and the terminal 47 is shared for reproduction and recording.

FIG. 9 shows an embodiment in which, in the PDIC used in the embodiment of FIG. 3, the TIA circuits U1 and U2 which exist in the laser drive circuit used in the embodiment of FIG. 5 are incorporated as TIA circuits U4 and U5, switches SW3 and SW4 are incorporated, and an amplifying circuit U6 is incorporated instead of the amplifying circuit U3. A signal input to the amplifying circuit U6 is subjected to single-ended/differential conversion, and the converted signal is output from differential output terminals OUT-P 44 and OUT-N 45. In this example as well, a output signal line is shared for reproduction and recording.

A reference voltage is sent and input to a reference voltage input terminal 46 from the reference voltage generation circuit (not shown) inside of the laser drive circuit, and is supplied to the TIA circuits U4, U5 and U6. The TIA circuits U4 and U5 also serve as means for supplying a reverse bias to the photo detector cells PD-A and PD-B.

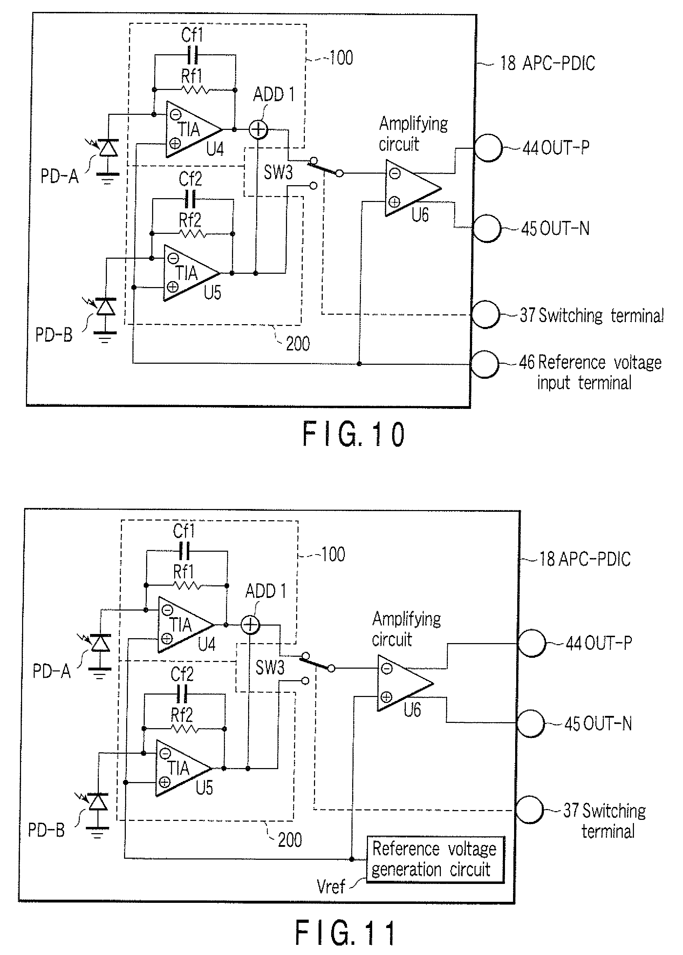

FIG. 10 is a view showing an example in which, in the PDIC used in the embodiment of FIG. 3, the TIA circuits U1 and U2 which exist in the laser drive circuit 14 used in the embodiment of FIG. 5 are incorporated as TIA circuits U4 and U5, the switch SW3 is incorporated, and furthermore, the amplifying circuit U6 and the addition circuit ADD 1 are incorporated therein. A signal input to the amplifying circuit U6 is subjected to single-ended/differential conversion, and is output from the differential output terminals OUT-P 44 and OUT-N 45. In this example as well, an output signal line is shared for reproduction and recording.

A reference voltage is sent and input to the reference voltage input terminal 46 from the reference voltage generation circuit inside of the laser drive circuit, and is supplied to the TIA circuits U4, U5 and U6. Further, the TIA circuits U4 and U5 also serve as means for supplying a reverse bias to the photo detector cells PD-A and PD-B.

At the reproduction time, a control signal is input from the switching terminal 37 in such a manner that the change-over switch SW3 selects an output of the addition circuit ADD1. At the reproduction time, an output of the photo detector cell PD-A is subjected to current-voltage conversion at the TIA circuit U4 to be input to the addition circuit ADD1. At the same time, an output of the photo detector cell PD-B is also subjected to current-voltage conversion at the TIA circuit U5 to be input to the addition circuit ADD1. An output of the addition circuit ADD1 is amplified by the amplifier U6 via the switch SW3 to be output to the output terminals OUT-P 44 and OUT-N 45. This output is transmitted to the APC system circuit inside of the laser drive circuit which is performing a reproduction operation.

At the recording time, a control signal is input from the switching terminal 37 in such a manner that the switch SW3 selects an output of the TIA circuit U5. An output of the photo detector cell PD-B is subjected to current-voltage conversion at the TIA circuit U5 to be output to the switch SW3. Thereafter, the output is subjected to single-ended/differential conversion at the amplifier U6, and is transmitted to the APC system circuit inside of the laser drive circuit which is performing a recording operation via the output terminals OUT-P 44 and OUT-N 45.

Including an embodiment of FIG. 10, as has been explained so far, the size of an optimal photo detector cell can be selected respectively for reproduction use and for recording use.

Generally, in a front monitor system APC for setting a light amount of laser to a definite level, a light amount which is 1 to 0.1% of the outgoing light amount of laser is allocated to the APC-PDIC. In particular, the laser for reproduction has a small laser power, and the use area thereof is narrow. Consequently, it is necessary to enlarge the light receiving area of the photo detector cell in such a manner that the amplifier gain for amplifying a PD output is not increased so much. This is because characteristics such as an output offset and a temperature drift are deteriorated.

When the light receiving area is enlarged, the volume is increased in correspondence to the area thereof, so that the frequency band of the circuit is naturally decreased. However, for reproduction use, such a specification is provided, and thus, no problem is caused.

On the other hand, a photo detector cell for recording use is not allowed to be the same in area as the cell for the reproduction use. In correspondence to the higher speed recording, it is required that the whole frequency band is widened, a high-speed recording signal is detected without distortion to be allowed to return to the laser drive circuit. For this reason, there arises a problem in that when the area is widened in the same manner as at the time of reproduction, an upper limit of the loop frequency band naturally falls to a lower frequency for the portion of the volume.

However, the present invention has a large characteristic such that the photo detector cells are provided as two cells instead of one cell in the prior art, and the cell for reproduction and the cell for recording can be determined in different sizes. Therefore, the photo detector cell for recording is formed as a photo detector cell with a small area having a small volume. As a result, the frequency characteristic having a wide band can be provided. Furthermore, since the laser power for recording has a power 10 to 150 times larger than the laser power for reproduction, no problem is caused even when the light receiving area is decreased.

In addition, the photo detector cells are divided for reproduction and recording in this manner, and further, the amplifying circuit at the rear stage is provided in correspondence to each of the photo detector cells. As a consequence, the change-over of the circuit for reproduction and recording, and the change-over speed of the recording/reproduction mode are not deteriorated with a time constant which is determined by the band of the circuit, and it becomes possible to change over the recording and reproduction at a high speed with a switch. That is, as can be seen from the circuit configuration of FIG. 10, a simple circuit is provided which is not attached with a parasitic circuit associated with a time constant at which the change-over speed of the recording/reproduction mode is deteriorated.

Embodiments which will be explained hereinafter have exactly the same characteristics and advantages. In the embodiments which have been so far explained, including the embodiment of FIG. 10, the reference voltage of the PDIC is supplied from the outside of the PDIC. In the embodiment shown in FIG. 11, a reference voltage generation circuit Vref is provided inside of the PDIC. Even when the temperature of the PDIC itself and the peripheral temperature rise, a stable output is obtained. A relative set potential relation between the reference voltage and an internal operation voltage is not affected by the temperature rise and is maintained.

In the embodiments which have been so far described, the voltage-current conversion circuit is used for the current-voltage conversion of the current corresponding to the laser power output from the photo detector cell. Embodiments different from the embodiments will be explained.

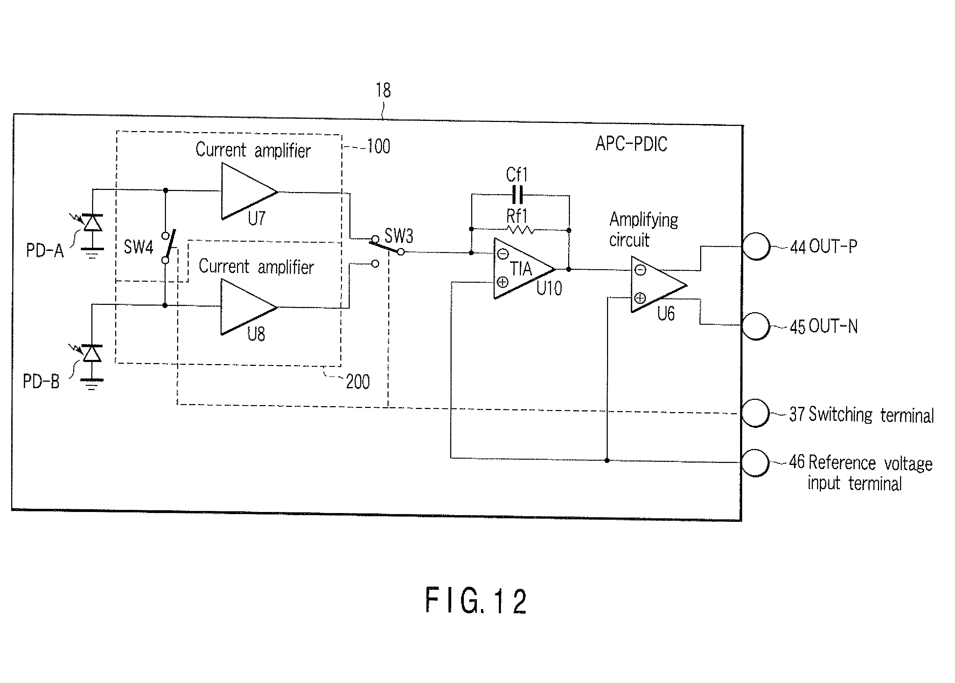

FIG. 12 is a diagram showing, unlike the embodiments which have been described so far, a circuit method for current-voltage conversion by using a current-voltage conversion circuit after a current corresponding to the laser power is amplified by the current amplifying circuit prior to the current-voltage conversion of the current corresponding to the laser power output from the photo detector cell.

In detailed description, when the switch SW4 is turned on (ON), currents corresponding to the reproducing laser power from both the photo detector cell PD-A and the photo detector cell PD-B are synthesized to be current-amplified by a current amplifier U7. When the switch SW4 is turned off (OFF), a current output of the photo detector cell PD-B is current-amplified by a current amplifier U8. Thereafter, an output current of the current amplifier U7 or U8 which is selected with the switch SW3 is subjected to current-voltage conversion at the TIA circuit U10 which is a current-voltage conversion circuit to be output to the amplifier 6. The amplifier 6 subjects a signal corresponding to the reproducing laser power which is converted to a voltage to single-ended/differential conversion to be respectively output to the output terminals OUT-P 44 and OUT-N 45.

In this embodiment, there is shown an embodiment in which a differential output from the amplifier U6 is shared for recording and reproduction with an output signal line of the output terminals OUT-P 44 and OUT-N 45.

A reference voltage is sent from the reference voltage generation circuit (not shown) inside of the laser drive circuit to be input to the reference voltage input terminal 46, and is supplied to the TIA circuit U10 and the amplifier U6.

Next, a reproduction operation and a recording operation will be explained. At the reproduction time, a control signal is given to the switching terminal 37 in such a manner that the switch SW4 is turned on (ON) and the change-over switch SW3 selects an output of the current amplifier U7. At the reproduction time, an output current of the photo detector cell PD-A is synthesized with an output current of the photo detector cell PD-B because the switch SW4 is turned on (ON), and the synthesized current is current-amplified by the current amplifier U7 to be output via the switch SW3. A current output of the switch SW3 is subjected to current-voltage conversion at the TIA circuit U10 which is a current-voltage conversion circuit to be output to the amplifier U6. The amplifier U6 subjects a signal corresponding to the reproducing laser power which is converted to a voltage to single-ended/differential conversion to be respectively output to the output terminals OUT-P 44 and OUT-N 45. The signals corresponding to the reproducing laser power output to the output terminals OUT-P 44 and OUT-N 45 are transmitted to the APC system circuit inside of the laser drive circuit which is performing a reproduction operation.

At the recording time, a control signal is given to the switching terminal 37 in such a manner that the switch SW4 is turned off (OFF) and the change-over switch SW3 selects an output of the current amplifier U8. Since the switch SW4 is turned off (OFF) at the recording time, only the current output of the photo detector cell PD-B is current-amplified by the current amplifier U8 to be output via the switch SW3. A current output of the switch SW3 is subjected to current-voltage conversion at the TIA circuit U10 which is a current-voltage conversion circuit to be output to the amplifier U6. The amplifier U6 subjects a recording laser power (a recording information signal) converted to a voltage to single-ended/differential conversion to be output respectively to the output terminals OUT-P 44 and OUT-N 45. The recording laser powers (the recording information signals) respectively output to the output terminals OUT-P 44 and the output terminal OUT-N 45 are transmitted to the APC system circuit inside of the laser drive circuit which is performing a recording operation.

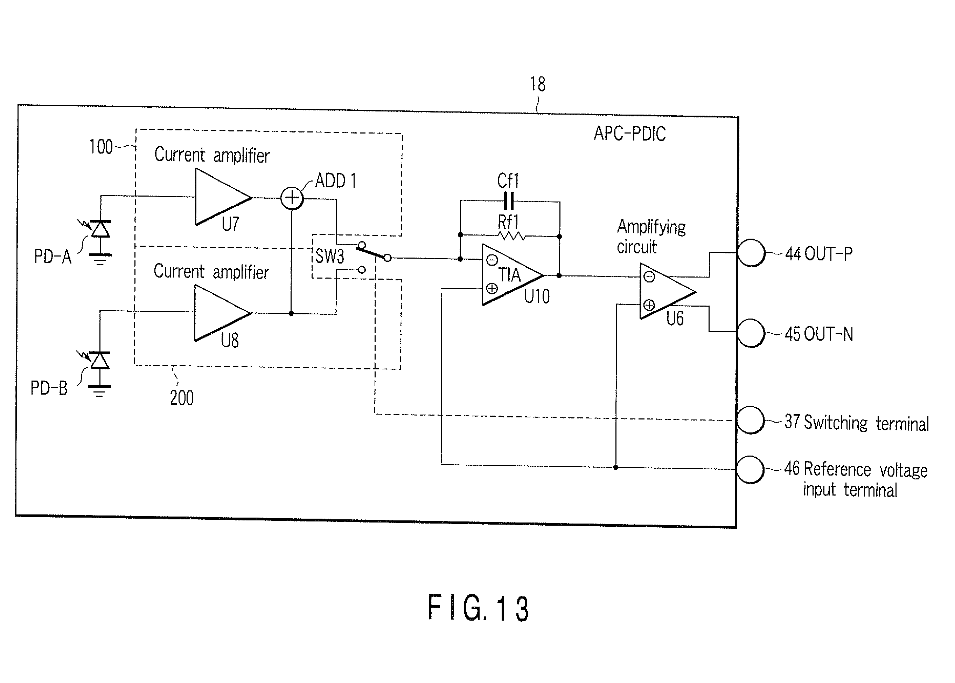

FIG. 13 is a still another embodiment. Components common to those in FIG. 12 are denoted by the same reference numerals.

FIG. 13 shows a circuit method in which an addition circuit ADD1 is provided for adding in current the outputs of the current amplifiers U7 and U8. A current output of the photo detector cell PD-A is current-amplified by the current amplifier U7, and a current output of the photo detector cell PD-B is current-amplified by the current amplifier U8. The signals which are current-amplified by the current amplifiers U7 and U8 are added in current by the current addition circuit ADD1 to be supplied to one of the input terminals of the switch SW3. An output signal of the current amplifier 8 is supplied to the other input terminal of the switch SW3.

The addition signal of the photo detector cells PD-A and PD-B selected with the switch SW3 or the current output of PD-B is subjected to current-voltage conversion at the TIA circuit U10 which is a current-voltage conversion circuit, and is output to the amplifier U6. The amplifier U6 subjects a signal corresponding to the reproducing laser power which is converted to a voltage to single-ended/differential conversion to be output respectively to the output terminals OUT-P 44 and OUT-N 45.

In this embodiment, a differential output from the amplifier U6 is shared for reproduction and recording with the output signal line of the terminals OUT-P 44 and OUT-N 45. A reference voltage is sent from the reference voltage generation circuit inside of the laser drive circuit to be input to the reference voltage input terminal 46, and is supplied to the TIA circuit U10 and the output terminal OUT-N 45.

Next, a reproduction operation and a recording operation will be explained. At the reproduction time, a control signal is given to the switching terminal 37 in such a manner that the switch SW3 selects an output of the addition circuit ADD1. At the reproduction time, a current output of the photo detector cell PD-A is current-amplified by the current amplifier U7 while a current output of the photo detector cell PD-B is current-amplified by the current amplifier U8.

The current outputs which are current-amplified by the current amplifiers U7 and U8 are added in current by the current addition circuit ADD1 to be selected with the switch SW3 and to be supplied to the TIA circuit U10. An output signal of the TIA circuit U1 is output to the amplifier U6. The amplifier U6 subjects a signal corresponding to a reproducing laser power which is converted to a voltage to single-ended/differential conversion to be output respectively to the output terminals OUT-P 44 and OUT-N 45. The signals corresponding to the reproduction power output respectively to the output terminals OUT-P 44 and OUT-N 45 are transmitted to the APC system circuit inside of the laser drive circuit which is performing a reproduction operation.

At the recording time, a control signal is given to the switching terminal 37 in such a manner that the change-over switch SW3 selects an output of the current amplifier U8. At the recording time, a current corresponding to the recording laser power (the recording information signal) is output from the photo detector cell PD-3, and the current output thereof is current-amplified by the current amplifier U8. The current output from the photo detector cell PD-B which is output via the switch SW3 is subjected to current-voltage conversion at the TIA circuit U10 which is a current-voltage conversion circuit to be output to the amplifier U6. The amplifier U6 subjects the recording laser power (the recording information signal) converted to a voltage to single-ended/differential conversion to be output respectively to the output terminal OUT-P 44 and the output terminal OUT-N 45. The recording laser powers (the recording information signals) output respectively to the output terminals OUT-P 44 and OUT-N 45 are transmitted to the APC system circuit inside of the laser drive circuit which is performing the recording operation.

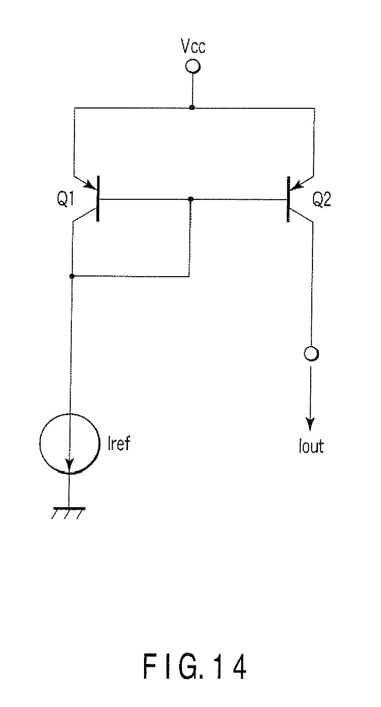

FIG. 14 shows one embodiment of a current amplifying circuit. In this embodiment, there is shown a current mirror circuit in the current amplifying circuit. The current mirror is widely used as a bias circuit of a transistor, a positive load, and the like. The current mirror circuit is a circuit for obtaining an output current Iout (a reference current = an output current is used in many cases) which stands proportional to a certain reference current Iref by allowing the reference Iref to flow.

In FIG. 14, it is assumed that the characteristics of two pnp transistors Q1 and Q2 are equal for simplifying the explanation. A voltage Vcc is applied to an emitter of the transistors Q1 and Q2. In addition, a base and a collector of the transistor Q1 are short-circuited, and the collector of the transistor Q1 is grounded via a current source for allowing the reference current Iref to flow. Furthermore, respective bases of the transistors Q1 and Q2 are connected to each other.

Since the base and the collector of the transistor Q1 are short-circuited in the current mirror circuit, the transistor Q1 operates as a diode, so that the reference current Iref flows in the transistor Q1. At this time, the characteristics of the transistors Q1 and Q2 are equal, and the voltages applied between the base and the emitter thereof are equal, so that a current (an output current Iout) having the same size as the reference current Iref which flows in the transistor Q1 flows in the transistor Q2.

So far, the current mirror circuit has been explained. Those skilled in the art can easily assume that another circuit method can be used which enables obtaining the same function and the same performance in consideration of the circuit configuration, the consumed power, and other specifications.

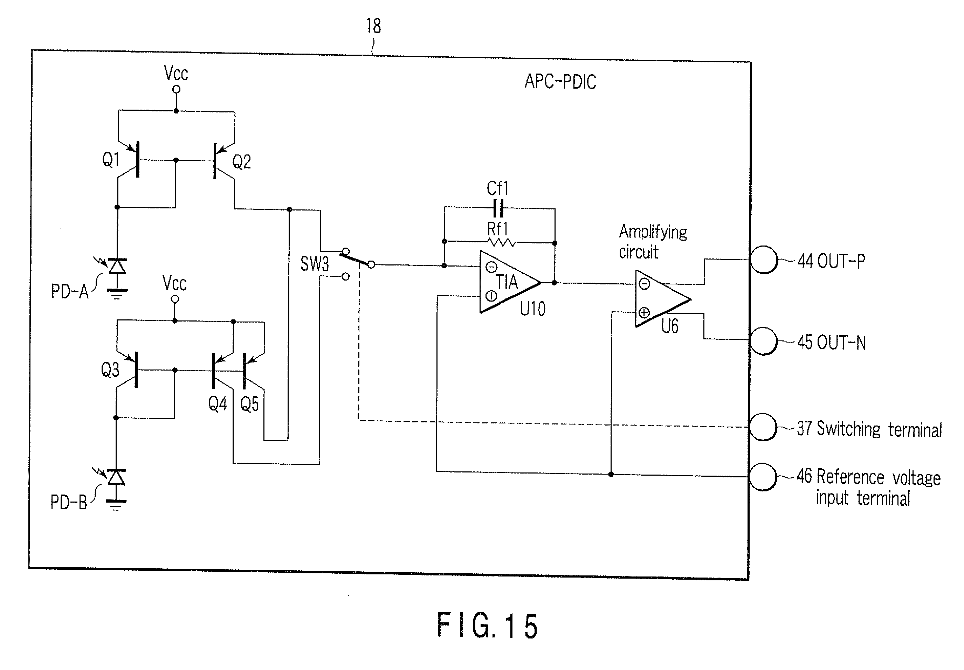

FIG. 15 shows an embodiment in which the current mirror circuit explained in FIG. 14 is used. The circuit of FIG. 13 constitutes a base thereof. An output of the photo detector cell PD-A is supplied to the side of a reference current source (the collector of the transistor Q1) of the current mirror circuit composed of the transistors Q1 and Q2. A collector output of the transistor Q2 is connected to one input terminal of the switch SW4. The current mirror circuit is of one-input and one-output type.

Furthermore, an output of the photo detector cell PD-B is supplied to the side of a reference current source of a current mirror circuit (a collector of a transistor Q3) of a current mirror circuit composed of transistors Q3, Q4 and Q5. A collector output of the transistor Q4 is connected to the other input terminal of the switch SW4. Further, a collector output of the transistor Q5 is commonly connected with the collector output of the transistor Q2 in an attempt to perform addition. The current mirror is of one-input and two-output type.

As has been described above, since the wide band is not required at the reproduction time unlike the recording time and the laser power at the reproduction time is small, a current ratio of the transistors Q1 and Q2 located on the reproduction side assumes a large value. A current ratio is adjusted, for example, with an emitter area. Finally, a current ratio of the transistors Q3 and Q5 also assumes a large value, and is synthesized with the output current of the transistor Q2 by an input unit prior to the switch SW3.

At the recording time, on the other hand, the wide band is required, and the laser power at the recording time is large, so that a current ratio of the transistors Q3 and Q4 located on the recording side assumes a small value. Then, in the same manner as the example of FIG. 13 described above, the recording/the reproduction is selectively changed over with the switch SW3 in accordance with a request of the system, and is transmitted to the APC system circuit inside of the laser drive circuit (not shown).

With optical disks, a high-speed change-over is demanded such that the reproduction is performed immediately after the recording and the recording is performed immediately after the reproduction. As has been explained so far in the embodiments in FIGS. 2 to 15, the circuit for recording and the circuit for reproduction are completely independent of each other in the APC-PDIC using the two photo detector cells according to the present invention. Consequently, a large problem ceases to occur such that the change-over speed is delayed with the time constant on the lower side band. There is provided a large advantage in that the change-over of recording and reproduction is changed over at a high speed.

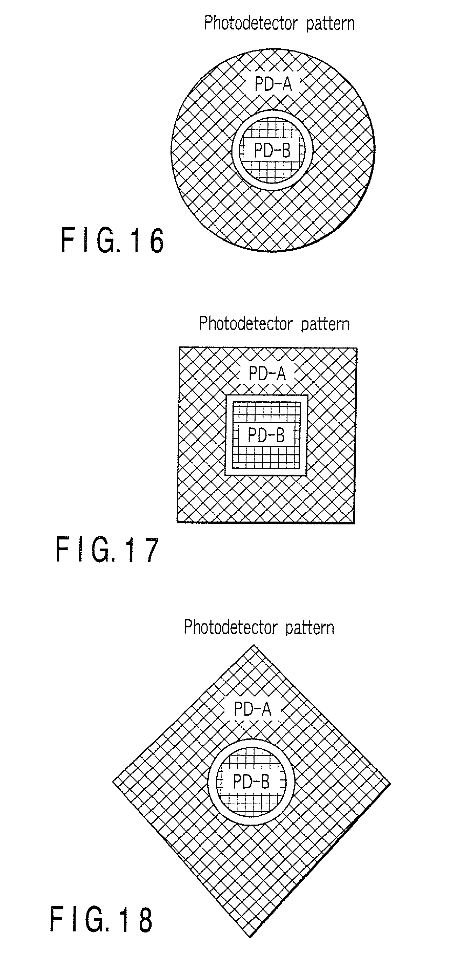

Next, FIGS. 16 to 18 show several examples of a pattern of the photo detector (PD) cells. In the drawings, a hatching portion is a photo detector cell portion. FIG. 16 shows a double round type. An outside area is a photo detector cell PD-A while an inside area is a photo detector cell PD-B. FIG. 17 shows a double square type. An outside area is a photo detector cell PD-A while an inside light area is a receiving cell PD-B. FIG. 18 shows an example of a combination of a round type and a square type. An outside area is a photo detector cell PD-A while an inside area is a photo detector cell PD-B.

In embodiments in any of the drawings, the inside serves as a recording photo detector cell (PD-B). This is because a light amount intensity distribution of the laser beam is strong on the inside. By just that much, the photo detector cell can be made in a small size, and it becomes possible to raise the frequency band.

In the embodiment shown in FIG. 18, the direction of the square photo detector cell is different from the example of FIG. 4. In short, the shape is not required to be limited to any specific shape at all. The shape can be freely determined depending on the usage state of the APC-PDIC, the circuit arrangement, the sensitivity and the frequency band. It is important to determine the size of the photo detector cell in consideration of the yield, the price, the shift in position of the APC-PDIC, the used wavelength, the disparity in the light source, the disparity in the APC-PDIC itself and the like, and in consideration of the merit and the demerit thereof with good balance. Furthermore, in the case where it is difficult to satisfy the specifications with two photo detector cells, the photo detector cell may be further divided into a plurality of cells, two or more cells. The present invention does not intend to limit the number of the division.

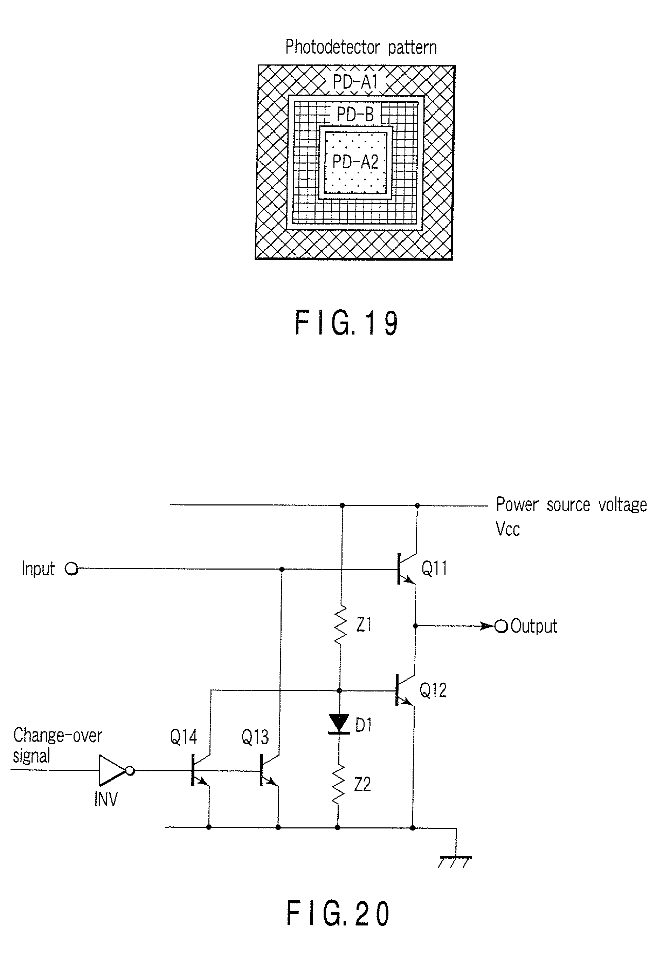

In the embodiment of FIG. 19, there is shown a case in which the number of division is set to three. In this embodiment, a PD-A for use in reproduction is divided into two, an outside PD-A1 and an innermost PD-A2. The two cells are wired with metal, for example, they are wired (not shown) with aluminum or copper to be connected to use in an equivalent manner the cells as a photo detector cell PD-A. On the other hand, a photo detector cell PD-B for used in recording uses the photo detector cell located at the second position from the inside as shown in the drawing. The shape of this photo detector cell has a characteristic in that the shape is strong against the position shift of the laser beams.

In this manner, according to the present invention, compared with the conventional one photo detector cell method, there is provided a large characteristic in that the balance between the recording specification and the reproduction specification can be easily taken, the cell is strong against the position shift, and the change-over speed of the recording and the reproduction is fast, and the method of the invention is effective.

Further, when a corresponding photo detector cell is set in a non-active state (a cell output is not adopted), a corresponding TIA circuit, or an output circuit of a current amplifier is such that the output is set as a high impedance. Such setting is effective for preventing the deterioration of the frequency characteristic of the active state (a path in an output use state).

FIG. 20 shows one example of a circuit for realizing the high impedance. In the transistor Q1, an emitter follower circuit is formed, so that a transistor Q12, resistors Z1 and Z2, and a diode D1 constitute a constant current circuit to allow a constant current to flow in the emitter follower circuit. The change-over of the active state and the non-active state of the emitter follower circuit is realized with a circuit which comprises an inverter INV, and transistors Q13 and Q14.

When a change-over signal is set to a high level, the transistors Q13 and Q14 are turned off, and the emitter follower circuit is set to an active state. At this time, the input signal is output from an emitter of the transistor Q11. On the contrary, when a change-over signal is set to a low level, the transistors Q13 and Q14 are turned on, and the emitter follower circuit is set to a non-active state, so that the output impedance is set to a high impedance.

With the above-described means, not only the sensitivity characteristic but also the current characteristic such as the frequency band, the phase characteristic, the through rate, and the group delay characteristic can be independently adjusted and optimized respectively in the reproduction system and the recording system.

That is, in the reproduction system, the laser power is small, the frequency characteristic is low on the order of about 1 MHz. As a result, it becomes possible to enlarge the signal level with good SN by enlarging the light receiving area. On the other hand, since a laser power which is about 150 times as large as the reproduction system is applied, a high-speed pulse must be received with a wide band. For this reason, the size of the photo detector cell is smaller than the size of the photo detector cell for the reproduction system, this makes it possible to correspond to a higher speed recording and a high-speed recording.

As has been described above, in a method in which two photo detector cells are used and the laser light amount is monitored, there is provided an advantage in that it becomes extremely easy to take a balance between the two specifications, i.e., the specifications of the reproduction system and the specifications of the recording system.

By optimizing the photo detector cell size in terms of the sensitivity characteristic and the current characteristic, the laser power is accurately monitored with good linearity, thereby facilitating the APC control for stabilizing the laser power in the case where the ratio of the laser power between the reproducing laser power and the recording laser power is 1:150. As a consequence, a high recording density and a higher speed recording of the optical disk can be facilitated.

Furthermore, in the optical disk, a high-speed change-over is demanded such that the reproduction is performed immediately after the recording and the recording is performed immediately after the reproduction. In the circuit using the APC-PD1C of the present invention, a large problem ceases to exist such that a change-over speed is delayed with a time constant on the lower side of the band. There is provided an extremely large advantage in that the change-over of the recording and the reproduction is enabled at a high speed.

As has been described above, according to the present invention, it becomes possible to provide a cheap APC-PDIC with excellent AC characteristic respectively in the reproduction system and in the recording system.

(B3) In the following embodiment, there will be explained a cheap photodetector circuit and an optical disk apparatus which are capable of stably performing a higher speed recording and a high-speed recording by accurately monitoring a laser power even in the case where a laser radiation angle from a laser light source is drifted with the temperature rise, and which contribute toward a lower consumed power. Furthermore, description will be given to a photodetector circuit and an optical disk apparatus which are effective for alleviating the allowance range of the installation position of the photodetector, thereby consequently realizing lower consumed power.

Here, in the following explanation, the definitions of terms such as "reproducing laser power" and "recording laser power" accurately refer to a laser output which generates a reproducing laser power or a recording laser power from an objective lens, and not laser beams which include a reproduction signal or a recording signal which is reflected to be allowed to return from the disk. Attention should be paid to this point.

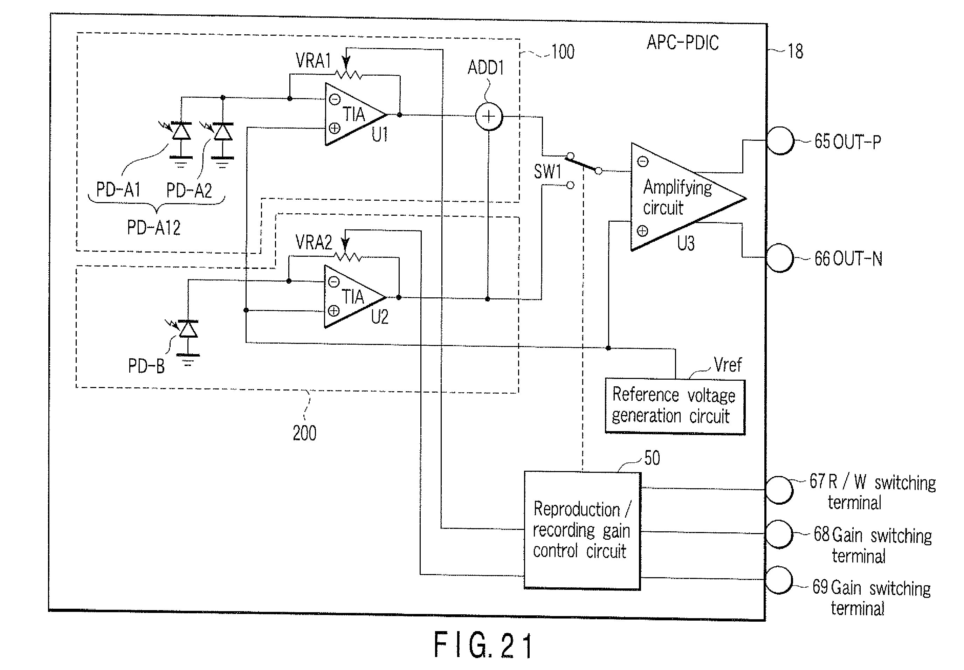

FIG. 21 is a diagram showing an example of a circuit configuration of an APC-PDIC 18 shown in FIG. 1. Reference symbols PD-A1 and PD-A2 refer to light receiving areas for reproduction. Furthermore, reference symbols PD-B refers to a light receiving area for recording. Here, the light receiving areas PD-A and PD-B are connected to each other with a metal wiring, and electrically form one photo detector cell RD-A12 for reproduction. Furthermore, the PD-B simultaneously forms a photo detector cell for recording. The photo detector cell PD-A12 for reproduction and the photo detector cell PD-B for recording constitute the whole of the photodetector.

At the reproduction time, a current corresponding to the reproducing laser power is output to a TIA circuit U1 from the photo detector cell PD-A12 for reproduction (the light receiving areas PD-A1 and PD-A2). Furthermore, a current corresponding to the reproducing laser power is output from the photo detector cell PD-B to a TIA circuit U2. Here, the TIA circuits U1 and U2 respectively perform current-voltage conversion onto the current corresponding to the reproducing laser power, and amplify the converted current to be output. An output of the TIA circuit U2 is added to an output of the TIA circuit U1 at the addition circuit ADD1 to be output to one input terminal of the switch SW1. An output of the TIA circuit U2 is supplied to the other input terminal of the switch SW1. The switch SW1 selects any one of the inputs and supplies the input to an amplifying circuit U3. At the reproduction time, an output of the addition circuit ADD1 is selected. In the amplifying circuit U3, the input is subjected to single-ended/differential conversion. An output of the amplifying circuit U3 is transmitted to the APC system circuit inside of the laser drive circuit 14 via an output terminal OUT-P 65 and an output terminal OUT-N 66.

At the recording time, the switch SW1 is changed over so as to select the output of the TIA circuit U2. A current corresponding to the recording laser power is output from the light receiving area PD-B to the TIA circuit U2. The TIA circuit U2 subjects a current corresponding to the recording power to current-voltage conversion, and amplifies the current to be output. The output of the TIA circuit U2 is supplied to the amplifying circuit U3 via the switch SW. Here, the input is subjected to single-ended/differential conversion, and the output of the amplifying circuit U3 is transmitted to the APC system circuit inside of the laser drive circuit 14 via the output terminal OUT-P 65 and the output terminal OUT-N 66.

The APC-PDIC 18 further includes a reference voltage generation circuit Vref, and a reproduction/recording gain control circuit 50. The reference voltage generation circuit Vref generates a reference potential, and supplies the potential to the TIA circuits U1 and U2 and the amplifying circuit U3. The TIA circuits U1 and U2 also serve as means for supplying a reverse bias to the photo detector cells PD-A12 and PD-B.

To the reproduction/recording gain control circuit 50, an R/W switching terminal 67 for changing over the recording mode and the reproduction mode, a first gain switching terminal 68, and a second gain switching terminal 69 are connected. The reproduction/recording gain control circuit 50 controls the change-over of the selection state of the switch SW1, and the gain state of the TIA circuits U1 and U2 at the recording time and the reproduction time on the basis of control signals supplied from these terminals 67, 68 and 69.

A gain of the TIA circuit U1 is changed over with the variation of a transimpedance VRA1 connected between its output terminal and a negative input terminal. Further, a gain of the TIA circuit U2 is changed over with the variation of a transimpedance VRA2 connected between its output terminal and the negative input terminal.

Now, it is assumed that the transimpedance VRA1 and the transimpedance VRA2 can be changed in respective three states at the first gain switching terminal 68 and the second gain switching terminal 69 which are gain switching terminals. Then, at the reproduction time and at the recording time respectively, three states x three states = nine gain modes can be obtained. Incidentally, the transimpedances VRA1 and VRA2 are shown as a volume in the drawing. However, in actuality, a plurality of fixed resistors arranged in series or in parallel are selected and changed over, so that the gain can be adjusted stepwise. In addition, the numbers of gains of the transimpedance VRA1 and the transimpedance VRA2 are respectively set to nine, but the present invention is not limited thereto. Even using a stepless transimpedance does not result in a departure from the gist of the present invention.

The APC-PDIC 18 constitutes a first processing circuit 100 for deriving as a control signal of the laser drive circuit an addition output of electric signals subjected to opto-electric conversion from the first photo detector cell PD-A12 and the second photo detector cell PD-B at the disk reproducing laser power. In addition, at the disk recording laser power, the APC-PDIC 18 constitutes a second processing circuit 200 for deriving as a control signal of the laser drive circuit an electric signal subjected to opto-electric conversion from any one of the first and second photo detector cells, in this example, the photo detector cell PD-B.

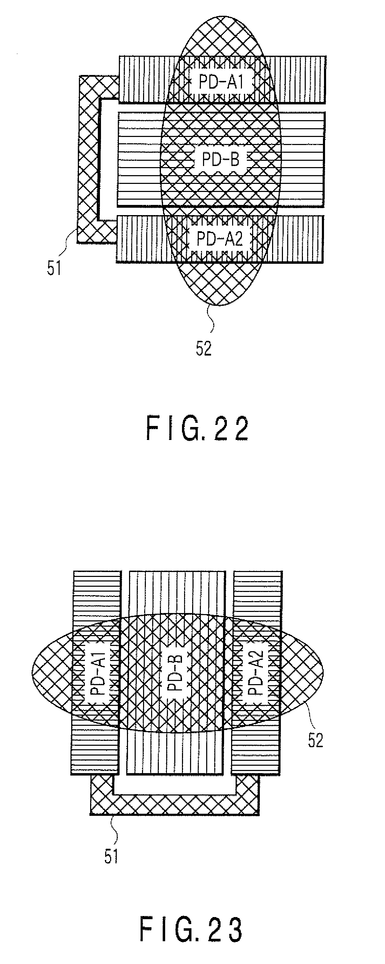

FIG. 22 is a view showing an example of a physical arrangement structure of the photo detector cells PD-A12 and PD-B of FIG. 21. This photodetector is such that three rectangular light receiving areas are basically formed in a stripe (parallel) configuration and arranged on a semiconductor substrate. That is, the light receiving area PD-A1, the light receiving area PD-B, and the light receiving area PD-A2 are arranged in order. An outside area constitutes the light receiving area PD-A1 and the light receiving area PD-A2 while an inside area constitutes the light receiving area PD-B. Further, the outside light receiving area PD-A1 and the outside light receiving area PD-A2 are connected with an aluminum wiring 51. As a consequence, an electric connection forms a photodetector shown in FIG. 21.

Here, there will be explained a relation between the above-described photodetector and a luminous flux of a laser beam 52 applied from a semiconductor laser 15. A sectional configuration of the laser beam 52 as seen from the intensity distribution is oblong. Here, for the explanation of the oblong configuration, it is assumed in the explanation that the longitudinal direction of the diameter is set as a longer elliptical direction whereas the widthwise direction is set as a shorter elliptical direction.

In the example of FIG. 22, a relation is set such that a direction in which a plurality of light receiving area are arranged (a direction of a shorter side of each area) and a longer elliptical direction of the laser beam 52 agree with each other. The reason goes as follows.

That is, the laser beam such as the reproducing laser power and the recording laser power has an oblong-shaped intensity distribution. An aspect ratio is generally defined as a longer elliptical direction vs a shorter elliptical direction = 2:1. In the case where a drift of a radiation angle of laser beam with a temperature rise, or a mutual position shift resulting from the attachment precision are generated in a longer elliptical direction between the photodetector and the laser beam, the shift does not give much influence on the detection performance. However, the drift of the radiation angle and the position shift are generated in a shorter elliptical direction, the shift gives a large influence on the detection performance. Therefore, the photodetector of the present invention has a configuration shown in FIG. 22 such that the drift in the shorter elliptical direction and the position shift do not affect the detection performance. This is because selection is made in such a manner that the longitudinal direction of each light receiving area agrees with the widthwise direction of the laser beam.

FIG. 23 is a view showing an embodiment in which the APC-PDIC photo detector cell pattern PD of the embodiment of FIG. 22 is rotated in a clockwise direction through 90.5 degrees. A longitudinal line hatching portion denotes the photo detector cell PD-A1 and PD-A2 while a latitudinal line hatching portion denotes the photo detector cell PD-B. An oblong-shaped hatching portion shows laser beam. The photo detector cells PD-A1 and PD-A2 are electrically operated as one photo detector cell with an aluminum wiring 51. In the embodiment of FIG. 22, there is shown a case in which the longer elliptical direction of the intensity distribution of the laser beam 52 to be received is a up and down direction. In the embodiment of FIG. 23, there is shown a case in which the longer elliptical direction of the intensity distribution of the laser beam 52 to be received is a right and left direction. The function and the operation are the same. In this manner, the photo detector cell arrangement can be set in such a manner that the longer elliptical direction of the intensity distribution of the laser beam 52 can be either the right and left direction or the up and down direction depending on the system and optical system used.

Of course, in the case of FIG. 23 in the same manner as the case of FIG. 22, the laser beam 52 is described to be small with respect to the photo detector cell for facilitating understanding. As a general APC-PDIC usage method, there is adopted a method for eliminating a position error by allowing beam larger than the photodetector to enter.

However, since large laser beam consume larger energy by just that much, it is preferable to select a size as effective as much as possible.

What is important here is an aspect ratio of the oblong laser beam 52. Generally, the shorter elliptical direction is set to a ratio of 1 as against 2 of the longer elliptical direction. Assuming from catalog data, etc. of general photodetectors, the price, the characteristic balance and the like are considered to be set to $\phi$0.4 mm to $\phi$0.8 mm.

Considering this real size and the aspect ratio described above, a ratio of the area of the light receiving area (PD-A1) + (PD-A2) + (PD-B) which is used for the reproduction and the area of the light receiving area PD-B which is used for recording is set to 2:1, or preferably an area ratio which is approximate to this value. The reason is that the frequency band may be sufficiently 1 MHz at most with respect to the reproduction, and thus, the light receiving area may be large. However, with respect to recording, in order to accurately and faithfully monitor an optical signal modulated with recording information which is output from the laser, a wide band of 100 MHz or more is required.

It is considered from the specification that a size of the photodetector which satisfies the characteristic with the current technology is $\phi$0.1 mm to $\phi$0.6 mm. Of course, the values change depending on the manufacture process for the photodetector. Further, the values also change depending on the specification of an optical disk system using this photodetector and the system design thereof. Therefore, the size is not necessarily limited to the level. With the current technology, the level is provided. Consequently, for example, when the light receiving area for reproduction is $\phi$0.8 mm and the light receiving area for recording is $\phi$0.1 mm to $\phi$0.6 mm, an area ratio is set to about 0.16 to 0.56.

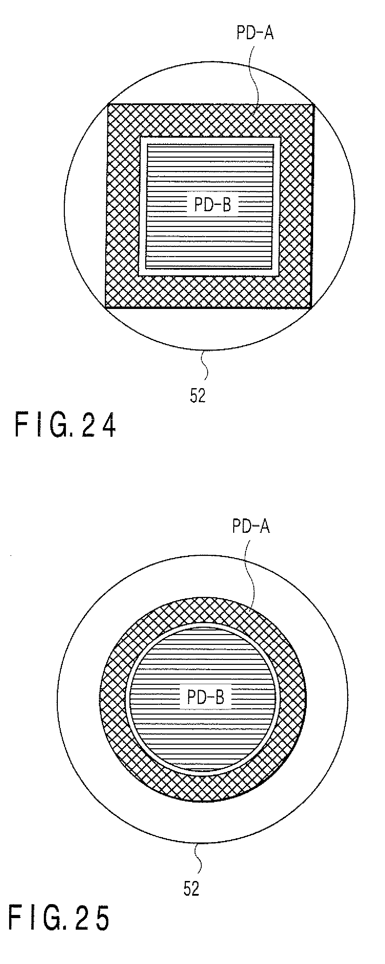

FIGS. 24 and 25 are views showing a configuration example of the photodetector in the case where the configuration of the laser beam 52 radiated from the semiconductor laser 15 is a genuine circle or a configuration approximate to the genuine circle. The photodetector is formed in such a manner that a light receiving area PD-B is surrounded by a light receiving area PD-A.

The light receiving areas PD-A and PD-B of FIG. 24 are square-shaped light receiving areas. At the reproduction time, an addition output of outputs of the light receiving area PD-A and the light receiving area PD-B is used. Furthermore, at the recording time, an output of the light receiving area PD-B is used. A basic operation thereof is the same as that of the photodetector shown in FIG. 22. In this case as well, the ratio of the light receiving area for reproduction and the light receiving area for recording is 2 to 1.

Light receiving areas PD-A and PD-B of FIG. 25 are round-shaped light receiving areas. At the reproduction time, an addition output of outputs of the light receiving area PD-A and the light receiving area PD-B is used. Furthermore, at the recording time, an output of the light receiving area PD-B is used. A basic operation thereof is the same as that of the photodetector shown in FIG. 22. In this case as well, the area ratio of the light receiving area for reproduction and the light receiving area for recording is 2 to 1.

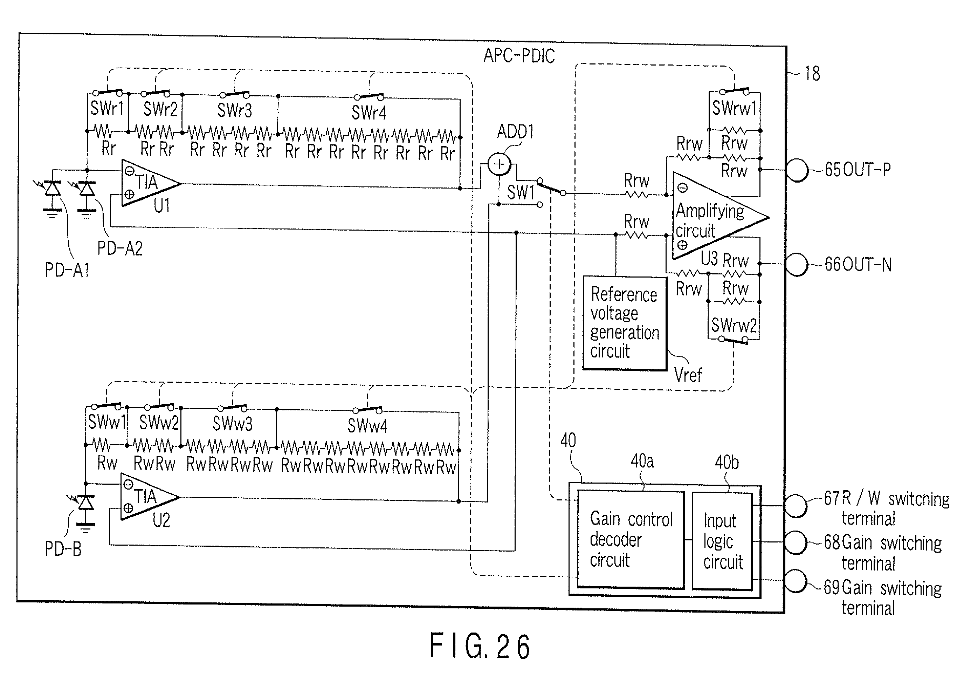

FIG. 26 is a diagram further specifically showing the details of the APC-PDIC 18 shown in FIG. 21. Here, the circuit configuration of the transimpedance connected to the TIA circuits U1 and U2 is clearly shown. Further, the peripheral circuit of the amplifying circuit U3 which performs single-ended/differential conversion is also specifically shown. Furthermore, the inside of the reproduction/recording gain control circuit 50 is shown in more detail.

First, there will be explained a gain change-over element of the TIA circuit U1. Between a negative input terminal of the TIA circuit U1 and an output terminal, for example, one, two, four, eight, and a total of 15 transimpedances Rr are connected in series. To the first transimpedance from the side of the negative input terminal Rr out of the transimpedances Rr connected in series, an electronic switch SWr1 is connected in parallel. Further, to the next two transimpedances Rr and Rr, an electronic switch SW2 is connected in parallel. Furthermore, to the next four transimpedances Rr, Rr, Rr and Rr, an electronic switch SWr3 is connected in parallel. Still furthermore, to the eight transimpedances Rr, ..., Rr, an electronic switch SWr4 is connected in parallel. In addition, the electronic switches SWr1, SWr2, SWr3 and SWr4 are connected in series. With this configuration, a gain can be changed by turning on and off (ON/OFF) the electronic switches SWr1, SWr2, SWr3 and SWr4 in a selective combination thereof.

There will be explained a gain change-over element of the TIA circuit U2. Between a negative input terminal of the TIA circuit U2 and an output terminal, for example, one, two, four, eight, and a total of 15 transimpedances Rw are connected in series. To the first transimpedance Rw from the side of the negative input terminal out of the transimpedances Rw connected in series, an electronic switch SWw1 is connected in parallel. Further, to the next two transimpedances Rw and Rw, an electronic switch SWw2 is connected in parallel. Furthermore, to the next four transimpedances Rw, Rw, Rw and Rw, an electronic switch SWw3 is connected in parallel. Still furthermore, to the eight trans impedances Rw, ... Rw, an electronic switch SWw4 is connected in parallel. In addition, the electronic switches SWw1, SWw2, SWw3 and SWw4 are connected in series. With this configuration, a gain can be changed by turning on and off (ON/OFF) the electronic switches SWw1, SWw2, SWw3 and SWw4 in a selective combination thereof.

One transimpedance Rrw is connected between the negative input terminal of the amplifying circuit U3 and the switch SW1. Further, two transimpedances Rrw are connected in series between the negative input terminal of the amplifying circuit U3 and the output terminal OUT-P 65. Furthermore, to the transimpedance Rrw at the rear stage within the two transimpedances Rrw connected in series, two transimpedances Rrw are connected in parallel. Moreover, to the transimpedances Rrw connected in parallel, an electronic switch SWrw1 is connected in parallel.

In addition, one transimpedance Rrw is connected between the positive input terminal of the amplifying circuit U3 and the reference voltage generation circuit Vref. Further, two transimpedances Rrw are connected in series between the positive input terminal of the amplifying circuit U3 and the output terminal OUT-N 66. Furthermore, to the transimpedance Rrw at the rear stage in two transimpedances connected in series, two transimpedances Rrw are connected in parallel. In addition, to the transimpedances Rwr connected in parallel, an electronic switch SWrw2 is connected in parallel.

Here, the electronic switches SWr1 to SWr4, SWw1 to SWw4, SWrw1, SWrw 2 and SW1 are ON/OFF controlled with a control signal from the reproduction/recording gain control circuit 50. The reproduction/recording gain control circuit 50 outputs a control signal on the basis of the input signal supplied from the R/W switching terminal 67, the gain switching terminal 68, and the gain switching terminal 69.

The reproduction/recording gain control circuit 50 has an input logic circuit 40b for primarily detecting a 3-state input, and a gain control decoder circuit 40a for ON/OFF controlling the electronic switches SWr1 to SWr4, SWw1 to SWw4, SWrw1, and SWrw2.

In this case, it is assumed that the electronic switches SWrw1 and SWrw2 are ON/OFF controlled in conjunction with each other. That is, in the case where the electronic switches SWwr1 and SWwr2 are turned off, the gain is obtained in the following equation 1.

$$(Rrw + Rrw//Rwr)/Rrw = 1.5 \text{ times} \quad \dots \text{ (equation 1)}$$

In the case where the electronic switches SWrw1 and SWrw2 are turned on, on the other hand, the gain is obtained in the following equation 2.

$$(Rrw)/Rwr = 1 \text{ time} \quad \dots \text{ (equation 2)}$$

Consequently, with the above configuration example, a mode of 1 to 16 times gain ratio can be obtained in the TIA circuit U1 on the reproduction side. Furthermore, a mode of 1 to 1.5 times gain ratio can be obtained with the ON/OFF control of the switches SWrw1 and SWrw2.

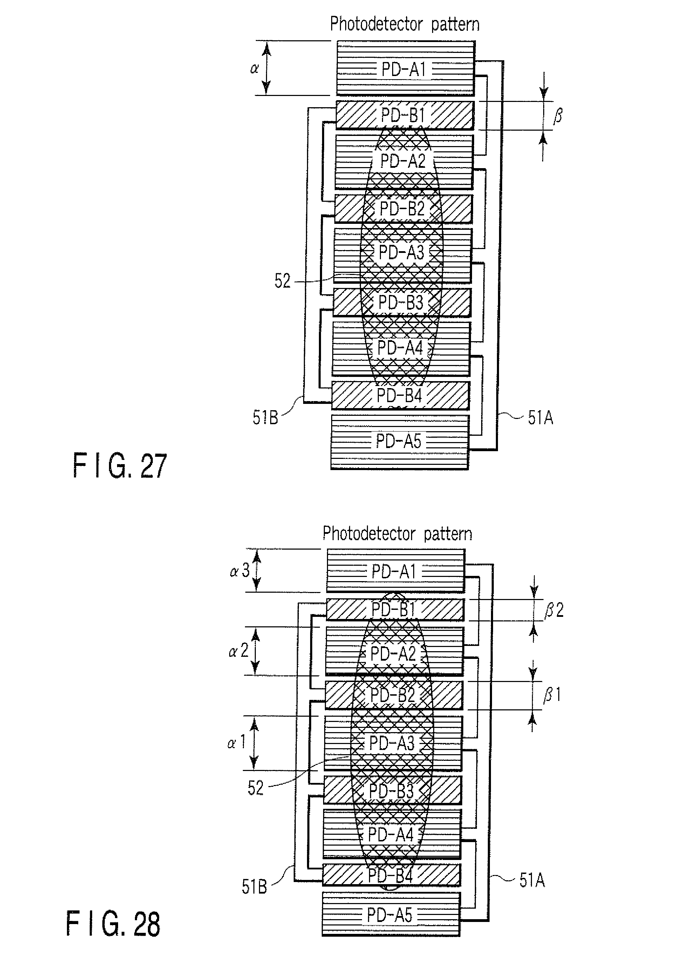

FIG. 27 is a view showing a configuration example of a photodetector in another embodiment of the present invention. This photodetector has light receiving areas (PD-A1), (PD-A2), (PD-A3), (PD-A4) and (PD-A5) for reproduction and light receiving areas (PD-B1), (PD-B2), (PD-B3) and (PD-B4) for recording. The areas for reproduction and the areas for recording are alternately arranged to each other. Furthermore, the light receiving areas (PD-A1), (PD-A2), (PD-A3), (PD-A4) and (PD-A5) for reproduction are connected with an aluminum wiring 51A to be formed as a photo detector cell for reproduction. The light receiving areas (PD-B1), (PD-B2), (PD-B3) and (PD-B4) for recording are connected with an aluminum wiring 51B to be formed as a photo detector cell for recording.

Here, widths of the light receiving areas (PD-A1) to (PD-A5) for reproduction shown in FIG. 27 are all denoted by symbol $\alpha$. Further, widths of the light receiving areas (PD-B1) to (PD-B4) for recording are all denoted by symbol $\beta$. In examples of FIGS. 22 and 23, there is provided a configuration which is not affected by the detection performance with respect to the position shift in the shorter elliptical direction of the laser beam. In addition, the embodiment of FIG. 27 has a configuration which is hardly affected by the detection performance with respect to the position shift in the longer elliptical direction of the laser beam.

When the number of division of the light receiving area is small, the change in the detection signal becomes rough when the position shift in the longer elliptical direction of the laser beam is generated. On the other hand, in the embodiment of FIG. 27, the number of division increases. For this reason, the change in the detection signal is finer even when the position shift in the longer elliptical direction of the laser beam is generated. Consequently, the configuration is still less affected by the detection performance with respect to the position shift in the longer elliptical direction of the laser beam as well.

According to the above-described embodiment, a more stable monitor can be performed with respect to the drift of the radiation angle in the longer elliptical direction of the laser beam 52 to be radiated. Here, the number of light receiving areas for forming the photodetectors is set to nine. However, the number is not limited thereto. It is possible to perform a more stable monitor with respect to the drift of the radiation angle of the laser beams 52 with an increase in the number of the light receiving areas.

FIG. 28 is a view showing still another embodiment of the embodiment shown in FIG. 27. The embodiment of FIG. 28 is different from the configuration example of FIG. 27 in that the widths of the light receiving areas (PD-A1) to (PD-A5) for reproduction and the widths of the light receiving areas (PD-B1) to (PD-B4) for recording become thinner as the arrangement positions thereof become more and more outer.

The widths of the light receiving areas PD-A1, PD-A2 and PD-A3 for reproduction are denoted respectively by symbols $\alpha 1$, $\alpha 2$ and $\alpha 3$. In this case, the widths of $\alpha 1$ to $\alpha 3$ has a relation of $\alpha 1 > \alpha 2 > \alpha 3$. In addition, the widths of the light receiving areas PD-B1 and PD-B2 for recording are respectively denoted by $\beta 1$ and $\beta 2$. In this case, the widths of $\beta 1$ and $\beta 2$ has a relation of $\beta 1 > \beta 2$.

Further, the areas of the light receiving areas has a relation of PD-A1 = PD-A5, PD-A2 = PD-A4, PD-B1 = PD-B4, and PD-B2 = PD-B3.

With the above-described configuration, the area of the light receiving area which is considered to be an area in which a change is likely to occur with the drift of the radiation angle of the laser beam 52, and therefore, the change which occurs due to the edge of the profile of the laser beam can be made small. As a result, it is possible to perform more stable monitor without an increase in the number of division of the light receiving area with respect to the radiation angle of the laser beam 52. This case is also favorable in the manufacture thereof.

The present invention is not limited to the above-described embodiment. In the case where the drift of the radiation angle of the semiconductor laser 15 is generated, the outgoing laser power of the objective lens decreases. For this reason, a configuration may be adopted wherein the drift of the radiation angle is sensed to suppress the change in the light amount of the outgoing laser power of the objective lens.

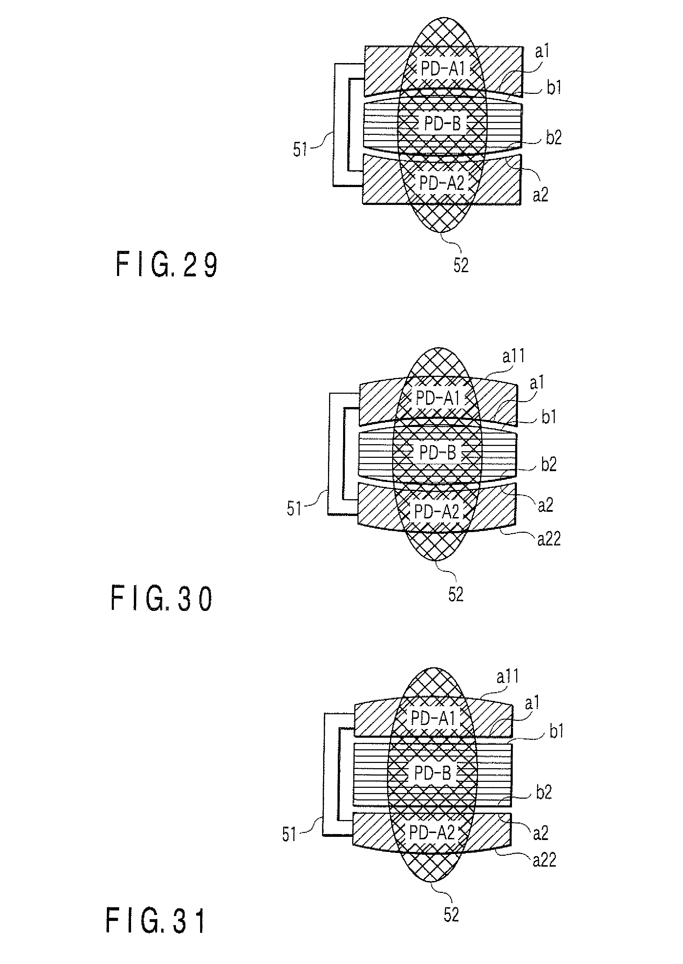

FIG. 29 is a view showing a configuration example of another embodiment of the photodetector shown in FIG. 22. Basically, the configuration of FIG. 29 is the same as that of the photodetector shown in FIG. 22. In this example, upper and lower long sides b1 and b2 of the light receiving area PD-B for recording are arc-shaped. Along with this, a long side a1 of the light receiving area PD-A1 for reproduction which is located opposite to the long side b1 is formed in a reverse arc shape. Furthermore, a long side a2 of the light receiving area PD-A2 for reproduction located opposite to the long side b2 is also formed in a reverse arc shape.

With this configuration, as compared with the configuration example of FIG. 22, it is possible to detect a change in the light intensity at the time of an angle shift in an optical axis of the semiconductor laser. That is, at the time of the angle shift in the optical axis which is emitted from the light source (a direction shift of the optical axis), the outgoing laser power of the objective lens decreases because of the position shift of the optical axis. However, there is a disadvantage in that a beam bundle larger than the size of the photo detector cell is normally allowed to enter the APC-PDIC, so that even in the presence of a change in the outgoing laser beam power of the objective lens, the monitor side cannot detect such a change.

However, in the embodiment shown in FIG. 29, this problem can be settled. As shown in FIG. 29, the photo detector cell is formed in an arc shape as shown in the drawing, whereby a change in the light amount of the outgoing laser beam power of the objective lens can be detected even if the laser emitted to the photo detector cell is shifted in any of the right and left direction and the up and down direction. As a result, it is possible to suppress the change in the light amount of the outgoing laser beam power of the objective lens even at the time of the angle shift of the optical axis of the semiconductor laser at the recording time and the reproduction time. At the same time, the luminous flux of the laser beams is set to an appropriate thickness to enable obtaining a lower consumed power.

With the above-described structure, it is possible to sense the drift of the radiation angle of the semiconductor laser 15 at the time of the light receiving of the recording laser power, and it is possible to suppress the change in the light amount of the outgoing laser power of the objective lens.

FIG. 30 is a view showing a configuration example of still another embodiment of the photodetector shown in FIGS. 22 and 29. Basically, the configuration of FIG. 30 is the same as that of the photodetector shown in FIGS. 22 and 29. In this embodiment, upper and lower long sides b1 and b2 of the light receiving area PD-B for recording have an arc shape. Along with this, a long side a1 of the light receiving area PD-A1 for recording located opposite to the long side b1 is formed in a reverse arc shape. Further, a long side a2 of the light receiving area PD-A1 for reproduction located opposite to the long side b2 is also formed in a reverse arc shape. Moreover, the long side a2 outside of the light receiving area PD-A1 and the long side a22 outside of the light receiving area PD-A2 are also formed in an arc shape.

With the above-described structure, it is possible to detect the drift of the radiation angle of the semiconductor laser 15 at the time of the light receiving of the reproducing laser power, and it is possible to suppress the change in the light amount of the outgoing laser power of the objective lens.

FIG. 31 is a view showing a configuration example of still another embodiment of the photodetector shown in FIGS. 22, 29 and 30. Basically, the configuration of FIG. 31 is the same as that of the photodetector shown in FIGS. 22, 29 and 30. In this embodiment, the long sides a1, b1, b2 and a2 are straight lines respectively, but the long sides a11 and a22 have an arc shape.

In this case as well, it is possible to sense the drift of the radiation angle of the semiconductor laser 15 even at the light receiving time of the laser power for recording and reproduction. It is also possible to suppress a change in the light amount of the outgoing laser power of the objective lens. The long sides of the arc shape and the reverse arc shape may be provided in the light receiving area shown in FIGS. 27 and 28.

With the above-described means, not only the sensitivity characteristic but also the current characteristic such as the frequency band, the phase characteristic, the through rate, and the group delay characteristic can be adjusted independently in the reproduction system and in the recording system, so that these characteristics can be optimized.

That is, in the reproduction system, the laser power is small, and the frequency characteristic is low on the order of 1 MHz. Thus, it is possible to enlarge the signal level and improve the SN by enlarging the area of the photo detector cell. On the other hand, in the recording system, a very large laser power 150 times as large as that of the reproduction system is emitted, and thus, a high-speed pulse must be light-received in a wide band. Consequently, it is possible to correspond to a higher speed recording and a high-speed recording by shrinking the size of the photo detector cell to a size smaller than the size of the photo detector cell of the reproduction system.

As has been described above, in a method for monitoring the light amount of laser by using two photo detector cells, there is provided an advantage in that it becomes extremely easy to take a balance between the two specifications, i.e., the specification of the reproduction system and the specification of the recording system. Furthermore, a lower consumed power can be expected by saving unnecessary energy.

The light receiving size is optimized in the sensitivity characteristic and current characteristic, whereby it becomes possible to easily perform the APC control for stabilizing the laser power by accurately monitoring the laser power with a good linearity even in the case where the ratio of the laser power between the reproducing laser power and the recording laser power is 1:150 as well. As a consequence, a higher speed recording and a high-speed recording of the optical disks are facilitated.

In the case where the radiation angle of the laser changes due to heat generation of the laser, it is possible to accurately monitor the laser power even in the case where a shift is generated in the installation position of the photodetector.

Further, with optical disks, a high-speed change-over is demanded such that the reproduction is performed immediately after the recording and, on the contrary, the recording is performed immediately after the reproduction. In the circuit using the APC-PDIC of the present invention, there is provided an extremely large advantage in that a large problem ceases to exist such that the change-over speed is delayed with a time constant on the lower side of the band, so that a high-speed change-over of recording and reproduction is enabled.

As has been described above, according to the present invention, it becomes possible to provide a cheap APC-PDIC excellent in AC characteristic respectively in the reproduction system and in the recording system.

(C3) There will be explained in detail embodiments of a cheap and excellent integrated photodetector circuit and an optical disk apparatus which enable the omission of external adjustment parts, the automation of the adjustment, and which enable performing a higher speed recording and a high-speed recording of optical disks by accurately monitoring a light amount of laser.

Here, in the following explanation, the definitions of terms such as a "reproducing laser power" and a "recording laser power" accurately refer to a laser output which generates a "reproducing laser power" or a "recording laser power" from an objective lens, and do not refer to laser beams including a reproduction signal or a recording signal which is reflected to return with disks. Attention should be paid to this point.

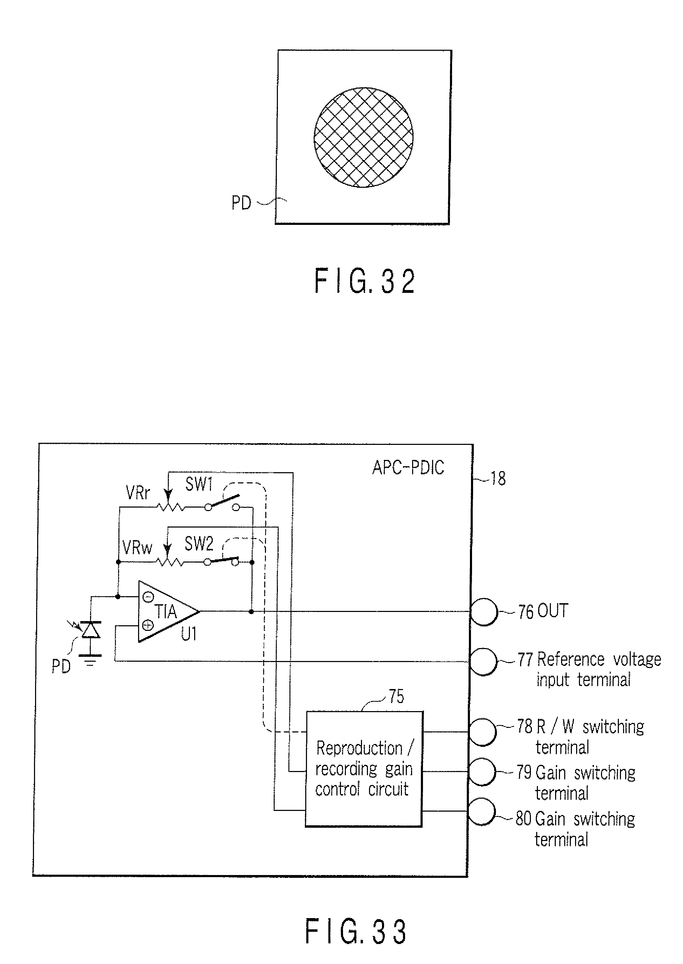

FIG. 32 is a view showing one embodiment of a pattern of a photo detector cell PD within the APC-PDIC used in the embodiment of FIG. 1. The hatching portion is the photo detector cell. This is the case in which one photo detector cell is provided. In general, the photo detector cell has a round shape, and a size thereof is from 0.4 mm to 1 mm, but the size is $\phi$0.7 mm in many cases.

FIG. 33 is a block diagram showing a circuit according to this embodiment. An output of the photo detector cell PD formed on a semiconductor substrate is supplied to a negative input terminal of a TIA circuit U1 which is a current-voltage conversion circuit. Between the negative input terminal of the TIA circuit U1 and an output terminal, a series circuit of a transimpedance VRr and a switch SW1, and a series circuit of a transimpedance VRw and a switch SW2 are connected in parallel. A reference voltage is supplied from a reference voltage input terminal 77 to a positive input terminal of the TIA circuit U1. An output of the TIA circuit U1 is derived to an output terminal (OUT) 76.

A reproduction/recording gain control circuit 75 can control the states of the switches SW1 and SW2. A control signal is given to the reproduction/recording gain control circuit 75 from an R/W switching terminal 78, a first gain switching terminal 79, and a second gain switching terminal 80.

At the reproduction time, a control signal for turning on the switch SW1 and turning off the switch SW2 is input to the R/W switching terminal 78. At the reproduction time, an output current of the photodetector PD is subjected to current-voltage conversion at the TIA circuit U1 and is output from the OUT 76 to be transmitted to the APC system (not shown) inside of the laser drive circuit 14 which is performing a reproduction operation. At this time, since the switch SW1 is turned on, VRr is used as the transimpedance at the reproduction time. The gain will be described in detail later.

At the recording time, a control signal for turning off the switch SW1 and turning on the switch SW2 is input to the R/W switching terminal 78. At the recording time, the output current of the photodetector PD is subjected to current-voltage conversion at the TIA circuit U1 and is output from the OUT 76 to be transmitted to the APC system circuit (not shown) inside of the laser drive circuit 14 which is performing a recording operation. At this time, since the switch SW2 is turned on, VRw is used as the transimpedance at the recording time.

The gain of the photodetector circuit is controlled via the reproduction/recording gain control circuit 75 in accordance with the control signals input to the R/W switching terminal 78, the gain switching terminal 79 and the gain switching terminal 80 together with the transimpedances VRr and VRw. Assuming that it is possible to control in two states the R/W switching terminal 78 and to control in three states the gain switching terminal 79 and the gain switching terminal 80, it becomes possible to set a multiple-stage gain mode.

```
3 states x 3 states x 2 states = 18 gain modes
```

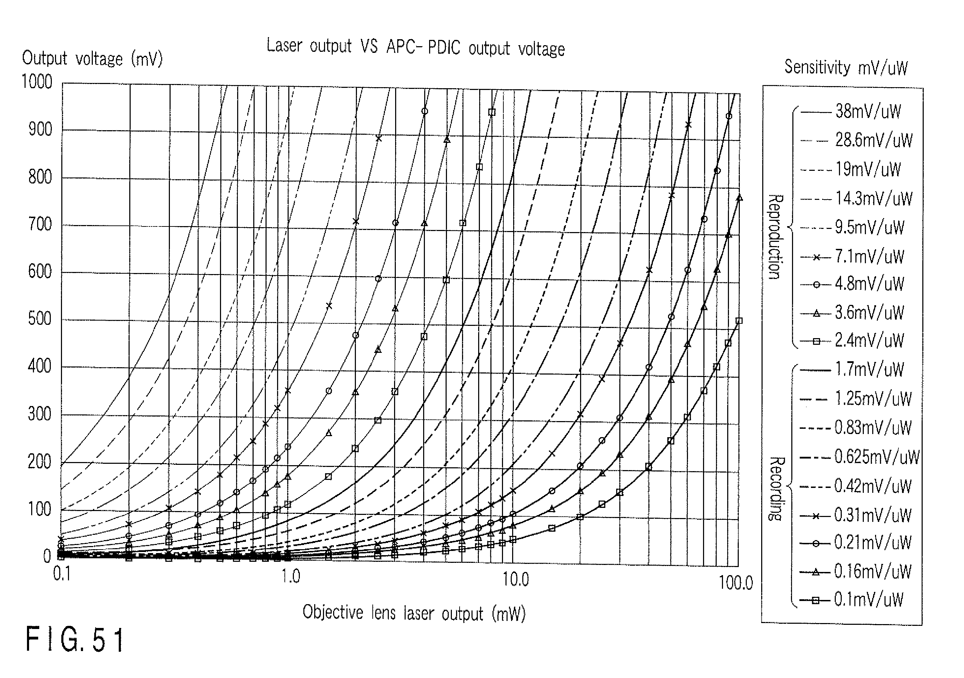

Out of the 18 gain modes, the reproduction 9 gain modes are provided on VRr and the recording 9 gain modes are provided on VRw. The gain mode is capable of setting any of gain modes 1 to 9 at a recoding state and a reproducing state, respectively. This gain mode will be described in detail later with reference to FIG. 51.

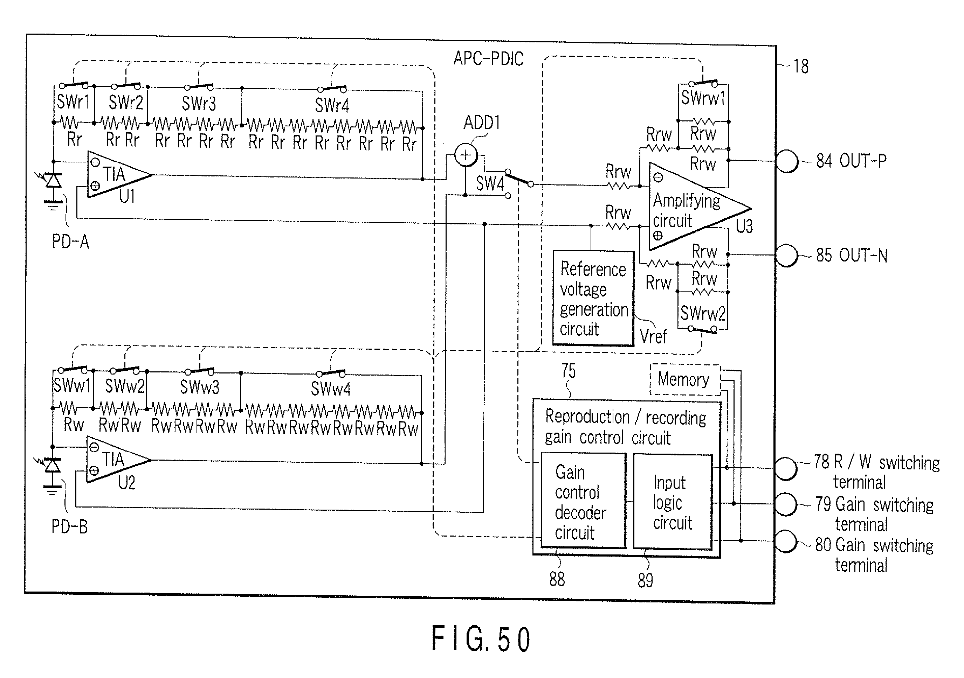

The transimpedances VRr and VRw are described in volume. In actuality, the gain is changed over in a stepwise manner by changing over a fixed resistor. A specific circuit thereof will be described later with reference to FIGS. 50 and 51.

A reference voltage is sent and input to the reference voltage input terminal 77 from the reference voltage generation circuit (not shown) inside of the laser drive circuit 14 to be supplied to the TIA circuit U1. The TIA circuit U1 serves as means for supplying a reverse bias of the photodetector PD.

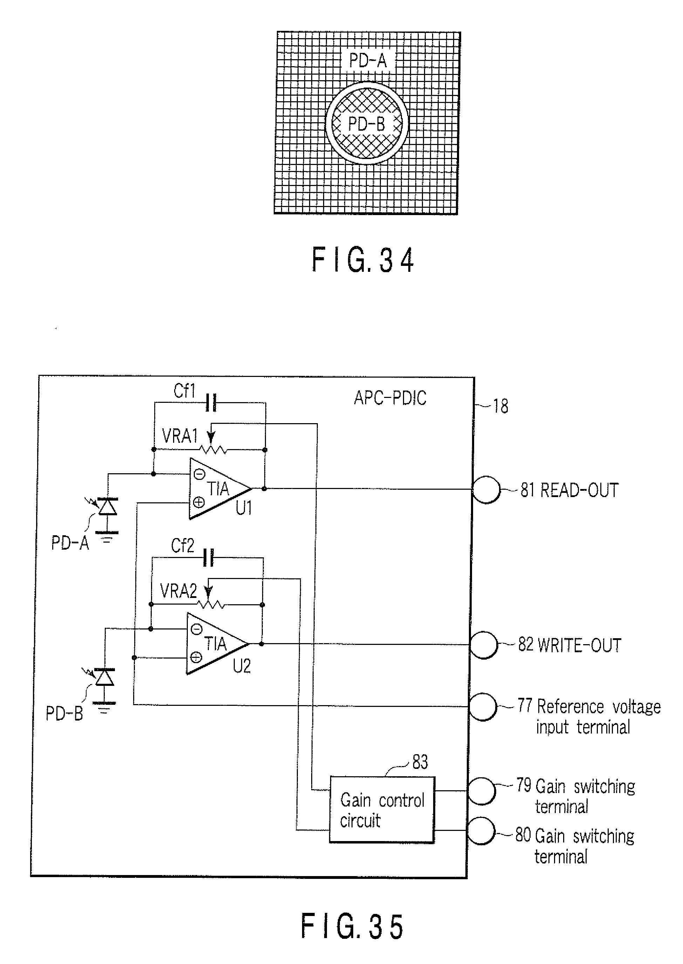

FIG. 34 is a view showing another example of a photo detector cell pattern. A photo detector cell for reproduction is defined as PD-A while a photo detector cell for recording is defined as PD-B. A round hole is provided on a central position of the square-shaped photo detector cell PD-A for reproduction, and the photo detector cell PD-B for recording is formed in the round hole.

FIG. 35 is a diagram showing a configuration of a circuit of a photodetector circuit (APC-PDIC) 18 using the photodetector of FIG. 34.

At the reproduction time, an output of the photo detector cell PD-A for reproduction is input to the TIA circuit U1, and is subjected to current-voltage conversion to be output from an output terminal (READ-OUT terminal) 81. An output of the READ-OUT terminal 81 is transmitted to the APC system circuit (not shown) inside of the laser drive circuit 14 at the rear stage which is performing a reproduction operation.

At the recording time, an output of the photo detector cell PD-B for recording is input to the TIA circuit U2, and is subjected to current-voltage conversion to be output from an output terminal (WRITE-OUT terminal) 82. An output of the output terminal 82 is transmitted to the APC system circuit (not shown) inside of the laser drive circuit 14 which is performing a recording operation.

Between a negative input terminal of the TIA circuit U1 and an output terminal, a parallel circuit of an impedance VRA1 and a capacity Cf1 is connected. The impedance VRA1 is rendered variable on the basis of a control signal from a gain control circuit 83. Consequently, the gain of the TIA circuit U1 is controlled.

Between a negative input terminal of the TIA circuit U2 and an output terminal, a parallel circuit of an impedance VRA2 and a capacity Cf2 is connected. The impedance VRA2 is rendered variable on the basis of the control signal from the gain control circuit 83. As a consequence, the gain of the of the TIA circuit U2 is controlled.

A reference voltage is supplied to the positive input terminals of the TIA circuit U1 and the TIA circuit U2 from the reference voltage input terminal 77. The reference voltage is sent and input to the reference voltage input terminal 77 from the reference voltage generation circuit (not shown) inside of the laser drive circuit 14. The TIA circuits U1 and U2 also serve as means for supplying a reverse bias to the photo detector cells PD-A and PD-B.

The gain control circuit 83 is also constituted in the APC-PDIC 18. In accordance with the control signal input to the first gain switching terminal 79 and the second switching terminal 80, an output control signal of the gain control circuit 83 is determined, so that the gains of the TIA circuits U1 and U2 are controlled.

When the gain switching terminal 79 and the gain switching terminal 80 can be controlled in three states respectively, it becomes possible to set a multiple-stage gain mode as will be described hereinbelow.

```
3 states x 3 states = 9 gain modes
```

With respect to the 9 gain modes, recording/reproduction 9 gain modes can be provided in VRA1 and VRA2. With respect to the gain mode, it is possible to set any of the gain modes 1 to 9 at a recoding state and a reproducing state, respectively. This gain mode will be described in detail with reference to FIG. 51.

The impedances VRA1 and VRA2 are described in volume. In actuality, a connection and a combination of a plurality of fixed resistors can be changed over. With this, the gain can be changed over in a stepwise manner. The specific circuit will be explained with reference to FIGS. 50 and 51.

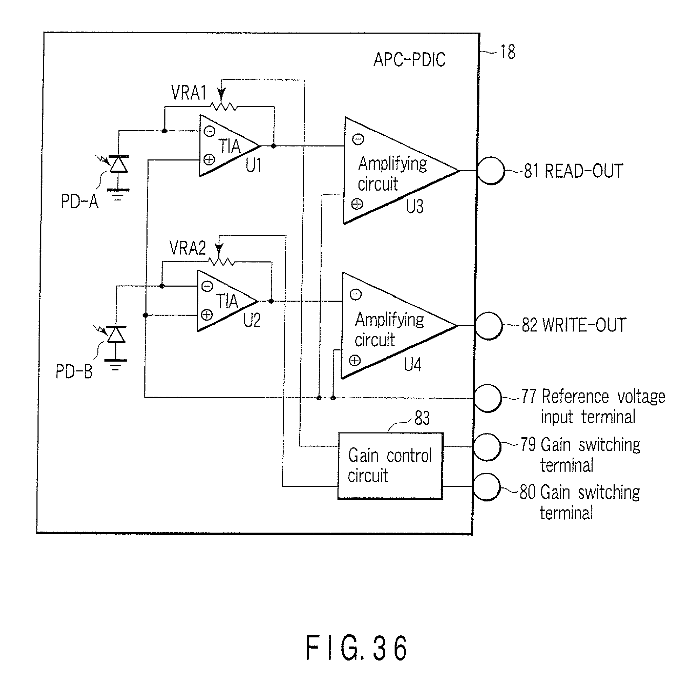

FIG. 36 is a diagram showing another embodiment of the present invention. This embodiment is such that amplifying circuits U3 and U4 are incorporated which serve as a buffer for outputting a signal and/or means for amplifying a signal within the APC-PDTC 18 of the embodiment of FIG. 35. For the facilitation of understanding, components having the same function as those in FIG. 35 are denoted by the same reference numerals. The gain control thereof is the same as the embodiment of FIG. 35. That is, an output of the TIA circuit U1 is connected to a negative input terminal of the amplifying circuit U3, and an output of the amplifying circuit U3 is derived to the READ-OUT terminal 81. In addition, an output of the TIA circuit U2 is connected to a negative input terminal of the amplifying circuit U4, and an output of the amplifying circuit U4 is derived to the READ-OUT terminal 82. A reference voltage from the reference voltage input terminal 77 is supplied to positive input terminals of the amplifying circuits U3 and U4.

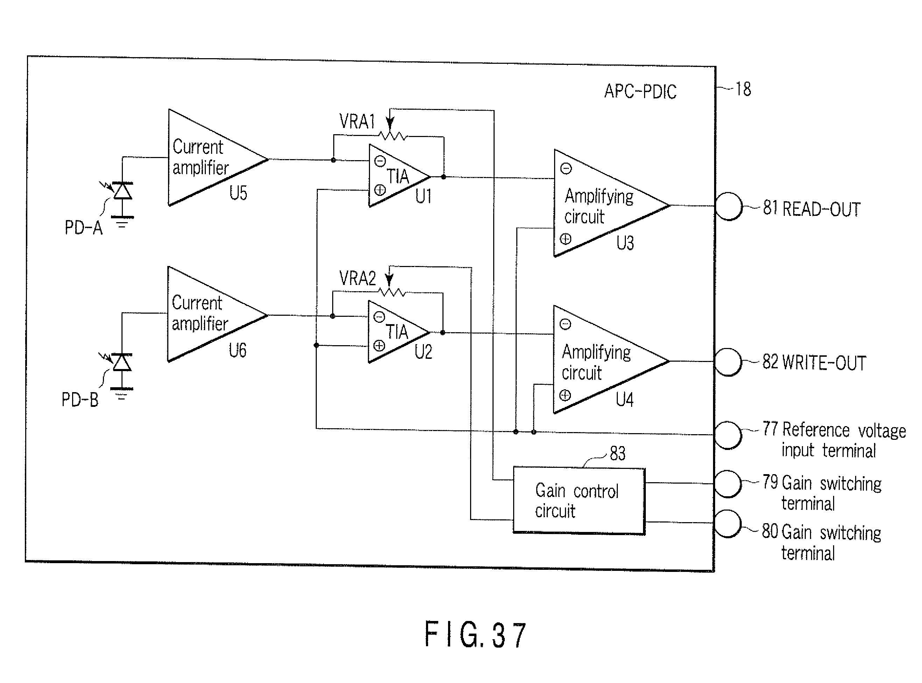

FIG. 37 is a diagram showing still another embodiment of the present invention. This embodiment is such that in the APC-PDIC 18 of the embodiment of FIG. 36, current amplifiers U5 and U6 are incorporated for current-amplifying respectively current outputs of the photo detector cells PD-A and PD-B. For the facilitation of understanding, components having the same function as those in FIG. 36 are denoted by the same reference numerals. The gain control is the same as the embodiment of FIG. 35.

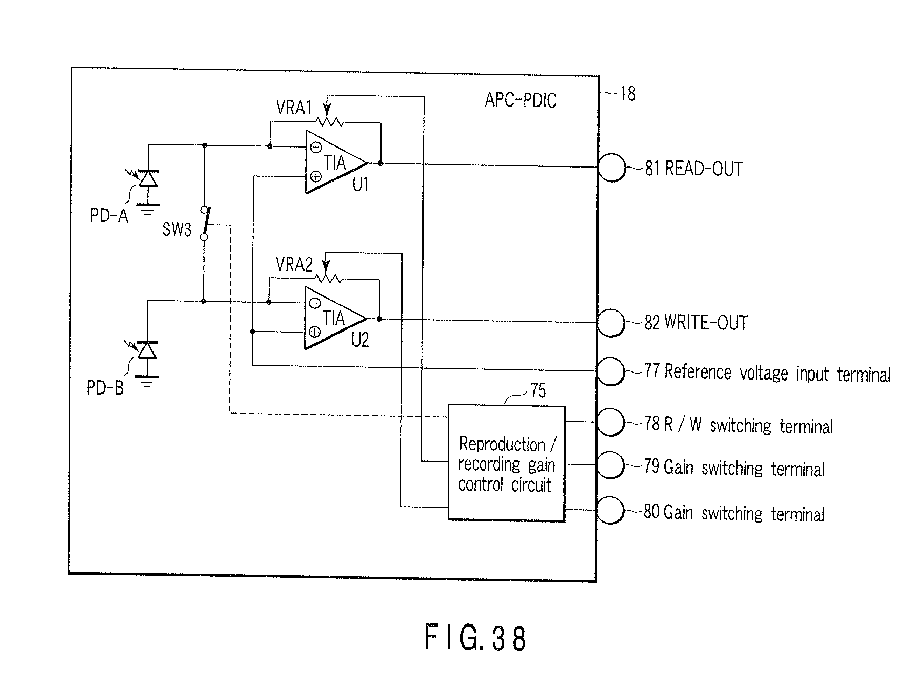

FIG. 38 is a diagram showing still another embodiment of the present invention. This embodiment is such that a switch SW3 for performing current addition at the reproduction time is added to the embodiment of FIG. 36. Consequently, the gain control is the same as in FIG. 36, and an explanation thereof is omitted. That is, the switch SW3 can add outputs of the photo detector cells PD-A and PD-3.

In this embodiment, at the reproduction time, a signal for turning on the switch SW3 is input from the R/W switching terminal 78 to control the switch SW3 via the reproduction/recording gain control circuit 75. Then, both output currents from the photo detector cell PD-A and PD-B are synthesized with the switch SW3 to be supplied to the TIA circuit U1. In the TIA circuit U1, an input current is subjected to current-voltage conversion to be output from the READ-OUT terminal 81. Its output signal is transmitted to the APC-PDIC system circuit (not shown) inside of the laser drive circuit 14 at the rear stage which is performing a recording operation.

At the recording time, a signal for turning off the switch 3 is input from the R/W switching terminal 78 to control the switch SW3 via the reproduction/recording gain control circuit 75. Then, an output current from the photo detector cell PD-B is subjected to current-voltage conversion at the TIA circuit U2 to be output to the WPITE-OUT terminal 82. This output is transmitted to the APC system circuit (not shown) inside of the laser drive circuit 14 at the rear stage which is performing a recording operation.

A reference voltage is sent and input from the reference voltage generation circuit (not shown) inside of the laser drive circuit 14 to the reference voltage input terminal 77 to be supplied to the TIA circuits U1 and U2. The TIA circuits U1 and U2 serve as means for supplying a reverse bias to the photo detector cells PD-A and PD-B.

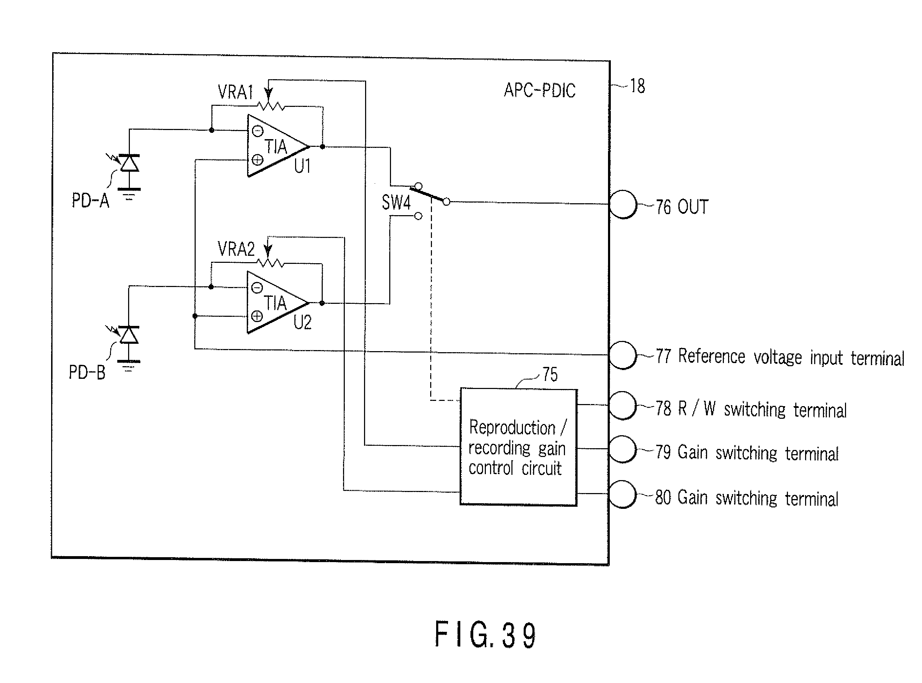

FIG. 39 is a diagram showing still another embodiment of the present invention. This embodiment is such that a switch SW4 is incorporated in the APC-PDIC 18 of FIG. 35, and an output signal line of the output terminal (OUT) 76 is shared for reproduction and recording. That is, an output of the TIA circuit U1 and an output of the TIA circuit U2 are supplied to one input terminal and the other of the switch SW4. The switch SW4 selects a signal of any one of the input terminals in accordance with the control signal, and outputs the selected signal to the output terminal 76.

A control signal for controlling the switch SW4 is input from the R/W switching terminal 78. The control signal controls the switch SW4 via the reproduction/recording gain control circuit 75. At the reproduction time, a control signal for allowing the switch SW4 to select an output of the TIA circuit U1 is input to the R/W switching terminal 78. At the recording time, a control signal for allowing the switch SW4 to select an output of the TIA circuit U2 is input from the R/W switching terminal 78. The other circuit operations and the gain control are the same as those of the embodiment of FIG. 35.

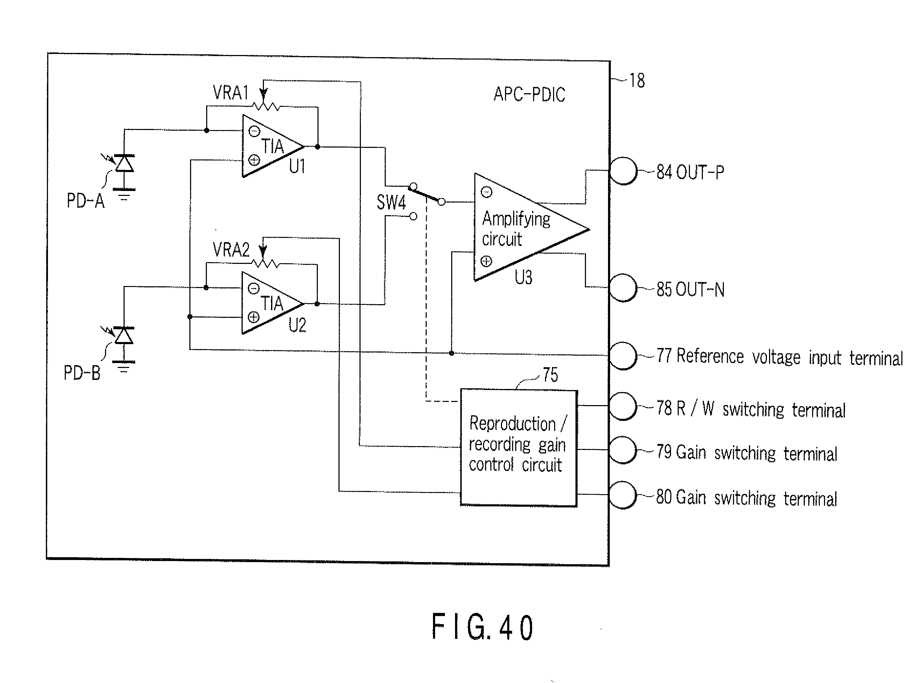

FIG. 40 is a diagram showing still another embodiment of the present invention. This embodiment is such that an amplifying circuit U3 is provided in the APC-PDIC of FIG. 39. More specifically, an output of the switch SW4 is supplied to the negative input terminal of the amplifying circuit U3, and differential output terminals (an OUT-P terminal and an OUT-N terminal) 84 and 85 of the amplifying circuit U3 are provided thereon. That is, in the amplifying circuit U3, a signal is buffered or amplified to be subjected to single-ended/differential conversion, and a differential output from the amplifying circuit U3 can be output to the OUT-P terminal 84 and the OUT-N terminal 85. Then, the embodiment is such that an output signal line is shared for reproduction and recording. To the positive input terminal of the amplifying circuit U3, a reference voltage from the reference voltage input terminal 77 is supplied. The other functions and circuit operations, and the gain control are the same as those of the embodiment of FIG. 35.

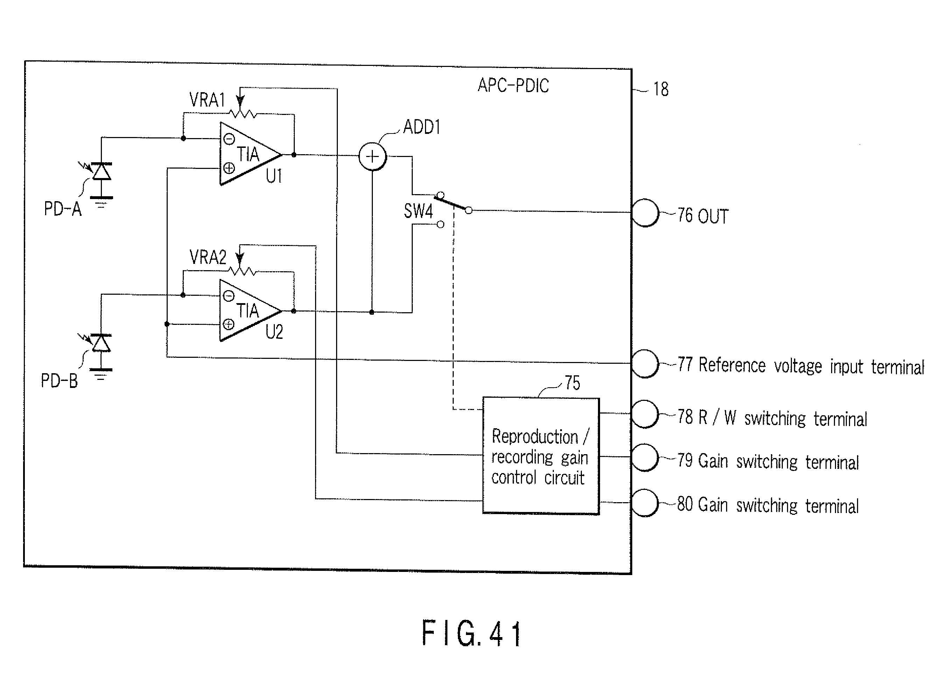

FIG. 41 is a view showing still another embodiment of the present invention. This embodiment has a configuration in which an addition circuit ADD1 is added to the inside of the APC-PDIC 18 of FIG. 39. More specifically, the configuration is such that the addition circuit ADD1 adds an output of the TIA circuit U1 and an output of the TIA circuit U2 to supply the addition output to one input terminal of the switch SW4.

At the reproduction time, the switch SW4 is controlled to select an output of the addition circuit ADD1. At the reproduction time, an output of the photo detector cell PD-A is subjected to current-voltage conversion at the TIA circuit U1. At the same time, an output of the photo detector cell PD-B is also subjected to current-voltage conversion at the TIA circuit U2. Then, the outputs of the TIA circuit U1 and the TIA circuit U2 are added with the addition circuit ADD1 to be derived to the OUT terminal 76 via the switch SW4 as a reproduction signal. This output is transmitted to the APC system circuit inside of the laser drive circuit 14 which is performing a reproduction operation.

At the recording time, the switch SW4 is controlled to select an output of the TIA circuit U2. At the recording time, a current corresponding to the recording information signal is output from the photo detector cell PD-B and is subjected to current-voltage conversion at the TIA circuit U2 to be output. This output is transmitted via the switch SW4 and the OUT terminal 76 to the APC system circuit inside of the laser drive circuit which is performing a recording operation.

The other circuit operations, functions and gain control are the same as those of the embodiment of FIG. 35.

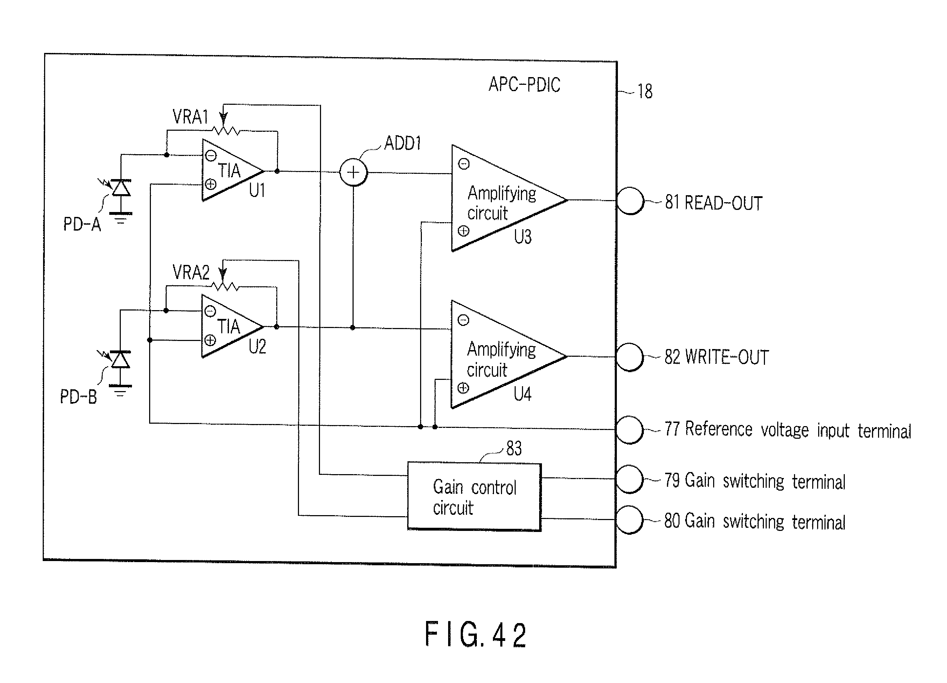

FIG. 42 is a diagram showing still another embodiment of the present invention. This embodiment is an example in which the switch SW4 of the APC-PDIC of FIG. 41 is eliminated, and amplifying circuits U3 and U4 are provided there. More specifically, an output terminal of the addition circuit ADD1 is connected to the negative input terminal of the amplifying circuit U3 while an output terminal of the TIA circuit U2 is connected to the negative input terminal of the amplifying circuit U4. A reference voltage from the reference voltage input terminal 77 is supplied to the positive input terminals of the amplifying circuits U3 and U4. Outputs of the amplifying circuits U3 and U4 are output respectively from the READ-OUT terminal 81 and the WRITE-OUT terminal 82.

The embodiment of FIG. 42 is different from the embodiment of FIG. 41 in that the output signal line is not shared. At the reproduction time, an output of the addition circuit ADD1 is transmitted via the amplifying circuit U3 and the READ-OUT terminal 81 to the APC system circuit inside of the laser drive circuit 14 which is performing a reproduction operation. At the recording time, an output of the TIA circuit U2 is transmitted via the amplifying circuit U4 and the WRITE-OUT terminal 82 to the APC system circuit inside of the laser drive circuit which is performing a recording operation.

The other circuit operations, functions and gain control are the same as those of the embodiment of FIG. 35.

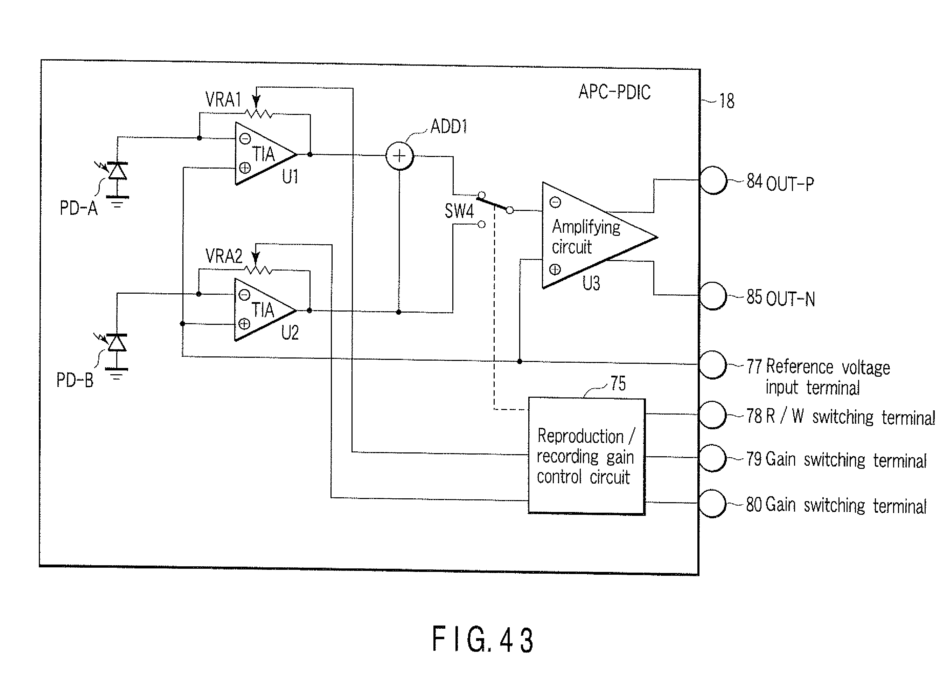

FIG. 43 is a diagram showing still another embodiment of the present invention. This embodiment is such that an amplifying circuit U3 is added to the inside of the APC-PDIC 18 of FIG. 41. The amplifying circuit U3 buffers or amplifies an output of the switch SW4 and subjects the output to single-ended/differential conversion. A differential output from the amplifying circuit U3 is output via the OUT-P terminal 84 and the OUT-N terminal 85. Thus, the embodiment is such that an output signal line is shared for reproduction and recording. The other circuit operations, functions and gain control are the same as those of the embodiment of FIG. 41.

As seen from the explanation of the embodiments of FIGS. 35 to 43 and the pattern of the photo detector cell of FIG. 34, an optimal photo detector cell size can be selected respectively for use in reproduction and for use in recording.

In general, in the APC of a front monitor method for setting the light amount of laser to a definite level, a light amount of 1 to 0.1% of the outgoing light amount of laser is allocated to the APC-PDIC. In particular, laser for reproduction has a small power and the usage band thereof is narrow. Consequently, it is required to take a large light receiving area such that the amplifier gain for amplifying the photo detector cell output does not increase so much. This is because characteristics such as an output offset and temperature offset are deteriorated.

When the light receiving area is increased, the capacity is increased along with the area. For this reason, the frequency band of the circuit naturally decreases. The light receiving area of the laser for reproduction is provided in such a specification, so that a preferable photo detector cell can be provided with no problem.

On the other hand, the light receiving area of the laser for recording cannot be the same as the area of the laser for reproduction. In correspondence to the higher speed recording, it is required to set the whole frequency characteristic to a wide band, and to detect a high-speed recording signal without distortion to allow the signal to return to the laser drive circuit. As a consequence, when the area is enlarged in the same manner as at the time of reproduction, the capacity band naturally falls. This causes a problem.

However, in the present invention, two photo detector cells are provided instead of one photo detector cell unlike the prior art. Thus, there is provided a large characteristic in that the sizes of the photo detector cells can be determined independently for reproduction and for recording. Then, the photo detector cell for recording is a photo detector cell having a small area in which the capacity is made smaller. As a consequence, it is possible to allow the photo detector cell to have a frequency characteristic with a wide frequency band. Furthermore, the recording laser power has a power 10 times to 150 times as large as the laser power for reproduction, and therefore, a decrease in the light receiving area is not a problem at all.

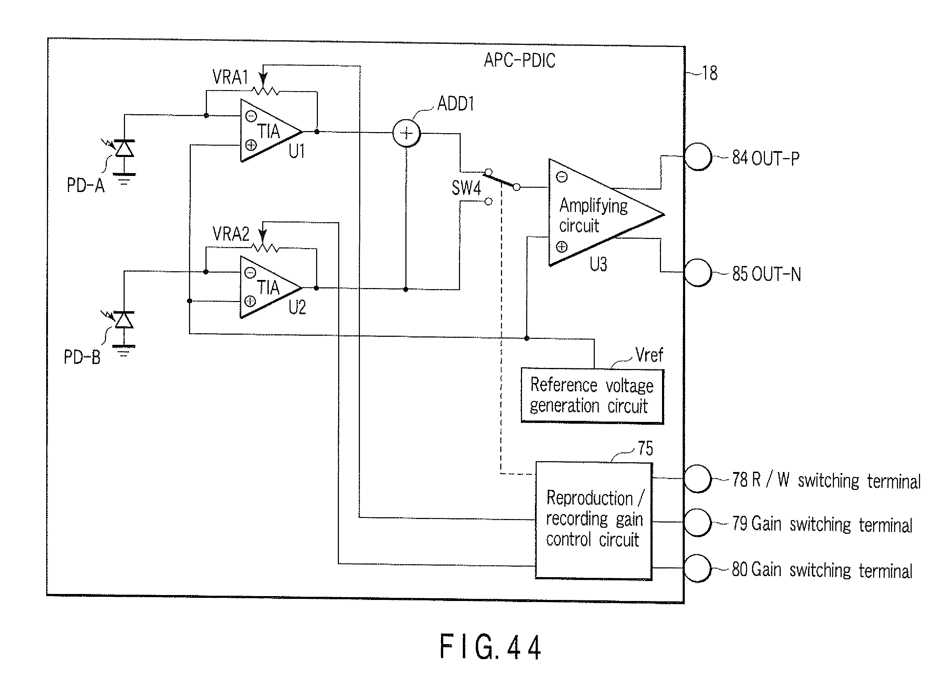

FIG. 44 is a diagram showing another embodiment of the present invention. In the embodiments which have been explained so far, the reference voltage of the APC-PDIC 18 is supplied from the outside of the APC-PDIC. In the embodiment of FIG. 44, a reference voltage generation circuit Vref is provided inside of the APC-PDIC 14. Even if the temperature of the APC-PDIC itself and the peripheral temperature rise, a stable output can be obtained. The other circuit operations, functions and gain control are the same as those of the embodiment of FIG. 43.

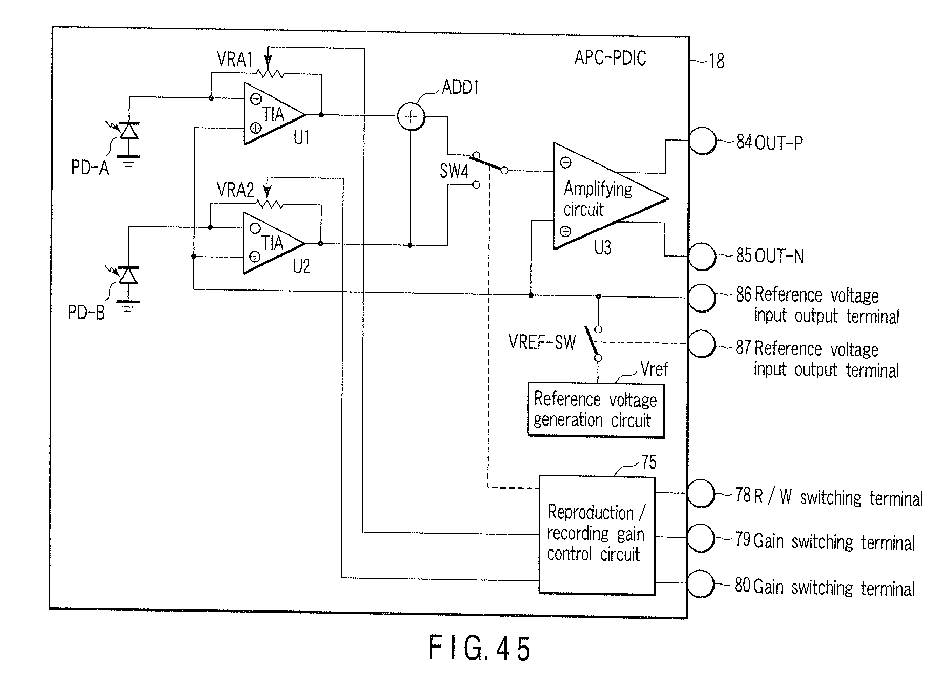

FIG. 45 is a diagram showing still another embodiment of the present invention. This embodiment enables the reference voltage generation circuit Vref of the APC-PDIC of FIG. 44 to correspond to both the internal supply and the external supply. The internal supply and the external supply can be changed over with the ON/OFF control of a switch VREF-SW.

When the reference voltage is supplied by means of the internal supply, a control signal for turning on the switch VREF-SW is input to a reference voltage control terminal 87. When the switch VREF-SW is turned on, a reference voltage is output from the reference voltage generation circuit Vref, and the reference voltage is supplied as the reference voltage of the TIA circuits U1 and U2 and the reference voltage of the amplification U3 on the one hand, while the reference voltage from the reference voltage generation circuit Vref is output also from a reference voltage input/output terminal 86 on the other.

The reference voltage output from the reference voltage input/output terminal 86 is used as the reference voltage of the laser drive circuit at the rear stage and inside of the laser drive circuit.

In the case where the reference voltage is supplied from the outside, a control signal for turning off the switch VREF-SW is input to the reference voltage control terminal 87 while the reference voltage sent, for example, from the reference voltage generation circuit inside of the laser drive circuit is input to the reference voltage input/output terminal 86. The reference voltage input to the reference voltage input terminal 86 is supplied as the reference voltage of the TIA circuits U1 and U2 and the amplifying circuit U3.

In the embodiments described so far, a current-voltage conversion circuit (TIA) is used in the current-voltage conversion of the information signal current which is output from the photo detector cell. An embodiment other than this embodiment will be explained.

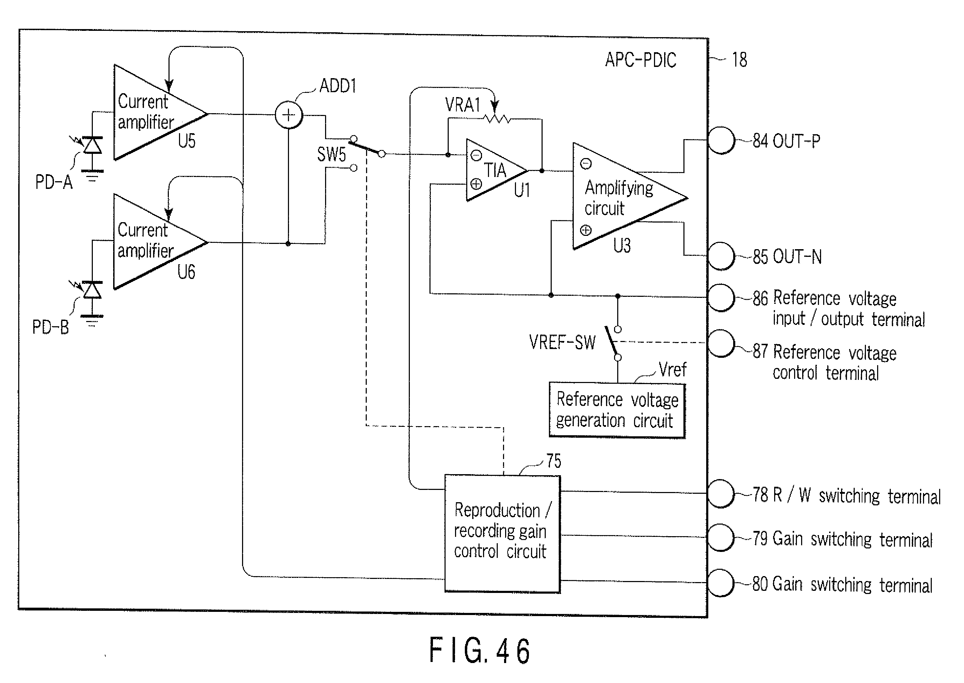

FIG. 46 is a diagram showing an embodiment of a circuit for current-amplifying current outputs of the photo detector cells PD-A and PD-B by means of current amplifiers U5 and U6.

A current output of the photo detector cell PD-A is current-amplified by the current amplifier U5 while a current output of the photo detector cell PD-B is current-amplified by the current amplifier U6. An output of the amplifier U5 and an output of the current amplifier U6 are added in current by the current addition circuit ADD1 to be supplied to one side of the switch SW5. The switch SW5 selects any one of the output of the current addition circuit ADD1 or the output of the current amplifier U6, and supplies the selected output to the negative input terminal of the TIA circuit U1.

An impedance VRA1 is connected between the negative input terminal of the TIA circuit U1 and the output terminal, and the gain of the TIA circuit U1 can be rendered variable.

An output subjected to current-voltage conversion at the TIA circuit U1 is supplied to the amplifying circuit U3. The amplifying circuit U3 buffers or amplifies an output converted to a voltage. The amplifying circuit U3 subjects the output to single-ended/differential conversion to be output respectively to the OUT-P terminal 84 and the OUT-N terminal 85.

This embodiment is such that a differential output from the amplifying circuit U3 is shared with the output signal line of the terminals 84 and 85 in reproduction and in recording.

The reference voltage operates the same operation as the example of FIG. 45. For example, in the case of the external supply, a control signal for turning of the switch VREF-SW is input to the reference voltage control terminal 87, and the reference voltage sent, for example, from the reference voltage generation circuit inside of the laser drive circuit is input to the reference voltage input/output terminal 86. The input reference voltage is supplied as the reference voltage of the TIA circuit U1 and the amplifying circuit U3 to the reference voltage input terminal 86.

The reproduction and recording operations will be explained hereinbelow. At the reproduction time, the switch SW5 is controlled in such a manner that an output of the addition circuit ADD1 is selected.

At the reproduction time, a current output of the photo detector cell PD-A is current-amplified by the current amplifier U5 while a current output of the photo detector cell PD-B is current-amplified by the current amplifier U6. Outputs of the current amplifiers U5 and U6 are added in current with the current addition circuit ADD1 to be input to the TIA circuit U1 via the switch SW5. A current-voltage converted output from the TIA circuit U1 is supplied to the amplifying circuit U3. The amplifying circuit U3 buffers or amplifies the input and subjects the output to the single-ended/differential conversion to be output to the OUT-P terminal 84 and the OUT-N terminal 85.

The signals output respectively to the OUT-P terminal 84 and the OUT-N terminal 85 are transmitted to the APC system circuit inside of the laser drive circuit which is performing a reproduction operation.

At the recording time, the switch SW5 is changed over in such a manner that an output of the current amplifier U6 is selected. At the recording time, a current output from the photo detector cell PD-B is current-amplified by the current amplifier U6. The current output which passes through the switch SW5 is subjected to current-voltage conversion at the TIA circuit U1, and its output voltage is supplied to the amplifying circuit U3. The amplifying circuit U3 buffers or amplifies the input to subject the input to single-ended differential conversion, and outputs the input respectively to the OUT-P terminal 84 and the OUT-N terminal 85. The signals output respectively to the OUT-P terminal 84 and the OUT-N terminal 85 are transmitted to the APC system circuit inside of the laser drive circuit which is performing a recording operation.

The gain of the above-described APC-PDIC 18 obtains a desired gain in two kinds of the fixed gain by means of the TIA circuit U1 and the portion which is current-amplified at a fixed value by means of the current amplifier U5 and the current amplifier U6. The gain of the current amplifiers U5 and U6 and the gain of the TIA circuit U1 are set in accordance with the control signal from the recording gain control circuit 75. The reproduction/recording gain control circuit 75 responds to the gain mode control signal given to the gain switching terminals 79 and 80 to output the control signal.

In the gain mode in this embodiment,
when the R/W switching terminal 78 can be controlled in two states, and the gain switching terminal 79 and the gain switching terminal 80 can be controlled in three states, a multiple-stage gain mode can be set as will be described later.

$$3 \text{ states} \times 3 \text{ states} \times 2 \text{ states} = 18 \text{ gain modes}$$

Out of the 18 gain modes, the reproduction 9 gain modes are provided on the current amplifier U5 and the impedance VRA1 while the recording 9 gain modes are provided on the current amplifier U6 and the impedance VRA1. With respect to the gain mode, any of the gain modes 1 to 9 can be set at a recording state and a reproducing state, respectively. This gain mode will be described in detail later with reference to FIG. 51.

The impedance VRA1 is described in volume. However, in actuality, a plurality of fixed resistors are changed over, and combined to enable changing over the gain in a stepwise manner. A specific circuit thereof will be described later with reference to FIGS. 50 and 51.

Incidentally, in the example of FIG. 46, the gain mode is allocated to the current amplifiers U5 and U6, but all the gain modes may be favorably set to the TIA circuit U1.

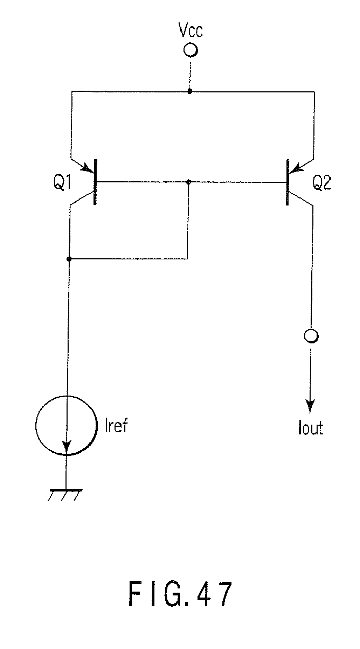

FIG. 47 is a diagram showing one embodiment of the current amplifying circuit. In this embodiment, as the current amplifying circuit, a current mirror circuit is shown. Its operation will be briefly described. The current mirror is widely used as a bias circuit of the transistor, an active load and the like. The current mirror circuit is a circuit in which a certain reference current is allowed to flow to obtain an output current which is proportional to the reference current (the reference current = the output current is used in many cases). FIG. 47 shows a basic configuration of the current mirror circuit. In FIG. 47, it is supposed that the characteristics of the two pnp transistors Q1 and Q2 are equal for the simplification of explanation. A voltage Vcc is applied to an emitter of the transistors Q1 and Q2. Furthermore, a base and a collector of the transistor Q1 are short-circuited, and a collector of the transistor Q1 is grounded via a current source for flowing the reference current Iref. Moreover, respective bases of the transistors Q1 and Q2 are connected to each other. In this current mirror circuit, the base and the collector of the transistor Q1 are short-circuited, so that the circuit is operated as a diode, and the reference current flows in the transistor Q1. At this time, the characteristics of the transistors Q1 and Q2 are equal and the voltages applied between the base and the emitter thereof are equal. Consequently, a current (an output current Iout) having a level equal to the reference current Iref which flows in the transistor Q1 flows in the transistor Q2.

So far, there has been explained the current mirror circuit. Those skilled in the art can easily assume that another circuit method can be used which enables obtaining the same function and the same performance in consideration of the circuit configuration, the consumed electric power, and other specifications.

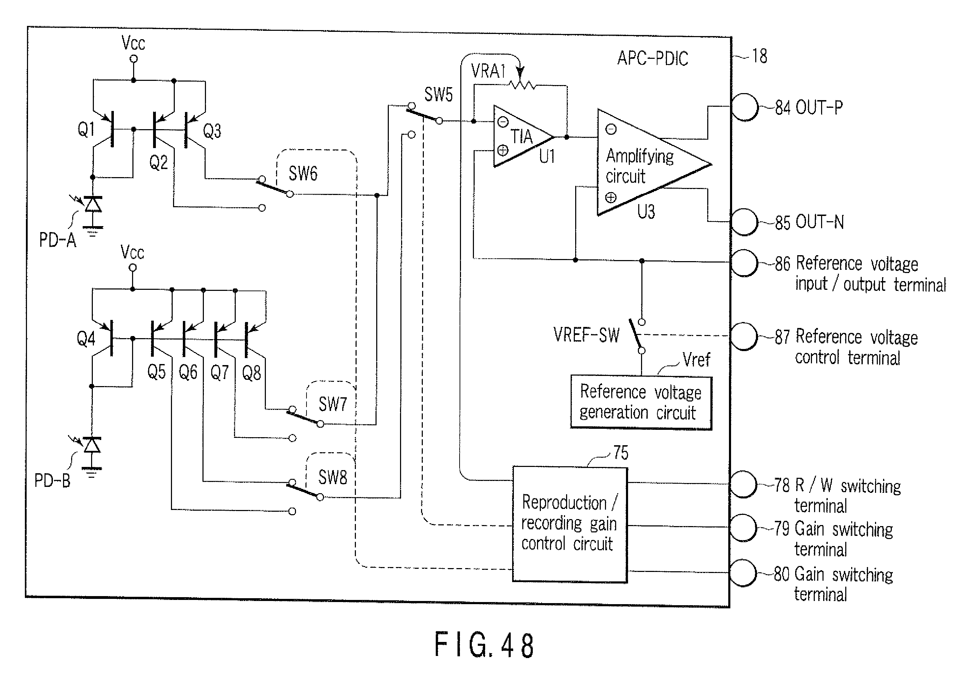

FIG. 48 is a diagram showing an embodiment in which the current mirror explained in FIG. 47 is used. The circuit shown in FIG. 46 forms a base. Transistors Q1 to Q3, and a switch SW6 correspond to the current amplifier U5 while transistors Q4 to Q8, and switches SW7 and SW8 correspond to the current amplifier U6.

As has been described above, at the reproduction time unlike at the recording time, a wide band is not required, and a laser power at the reproduction time is small, and therefore, a current ratio of Q1 to (Q2, Q3) on the reproduction side is set to be large. Finally, the current ratio of Q4 to (Q7 and Q8) which ratio is added in current is also set to be large. An output current of Q2 or Q3 and an output of Q7 or Q8 are synthesized in the input prior to the switch SW5. That is, at the reproduction time, (addition output = Q2 output + Q7 output) or (addition output = Q3 output + Q8 output) are output via the switch SW5.

On the other hand, at the recording time, a wide band is required, and a laser power at the recording time is large, and therefore, a current ratio of Q4 to (Q5, Q6) on the recording side is set to be small. Then, in the embodiment of FIG. 47 described above, and at the recording time, Q5 output or Q6 output are output via the switch SW5.

Incidentally, only the switch SW6 and the switch SW7 are associated in operation. For example, in the current addition, either of the current addition, (Q2 output + Q7 output) or (Q3 output + Q8 output) is selected with the switches SW6 and SW7.

The other operations are the same as the embodiment of the FIG. 46. The gain mode in this embodiment is such that, assuming that the R/W switching terminal 78 can be controlled in two states and the gain switching terminal 79 and the gain switching terminal 80 are controlled in three states, a multiple-stage gain mode can be set as is described below.

```
3 states × 3 states × 2 states = 18 gain modes
```

In this embodiment, when 9 modes are set on the side of the TIA circuit U1, two gain modes are set on the side of the current amplification. Thus, the 18 gain modes are enabled in total.

Out of the 18 gain modes, it is possible to allow the Q2, Q3 and VRA1 to take charge of the reproduction 9 gain modes and to allow the Q5, Q6 and VRA1 to take charge of the recording 9 gain modes.

The impedance VRA1 is described in volume. However, in actuality, the fixed resistor is changed over to change over the gain in a stepwise manner. A specific circuit thereof will be explained later with reference to FIGS. 50 and 51.

Incidentally, in the example of FIG. 48, the gain modes are allocated both to the side of the transistors Q1, Q2 and Q3 corresponding to the current amplifier U5 and to the side of the transistors Q4, Q5, Q6, Q7 and Q8 corresponding to the current amplifier U6. All the gain modes may be set in the TIA circuit U1.

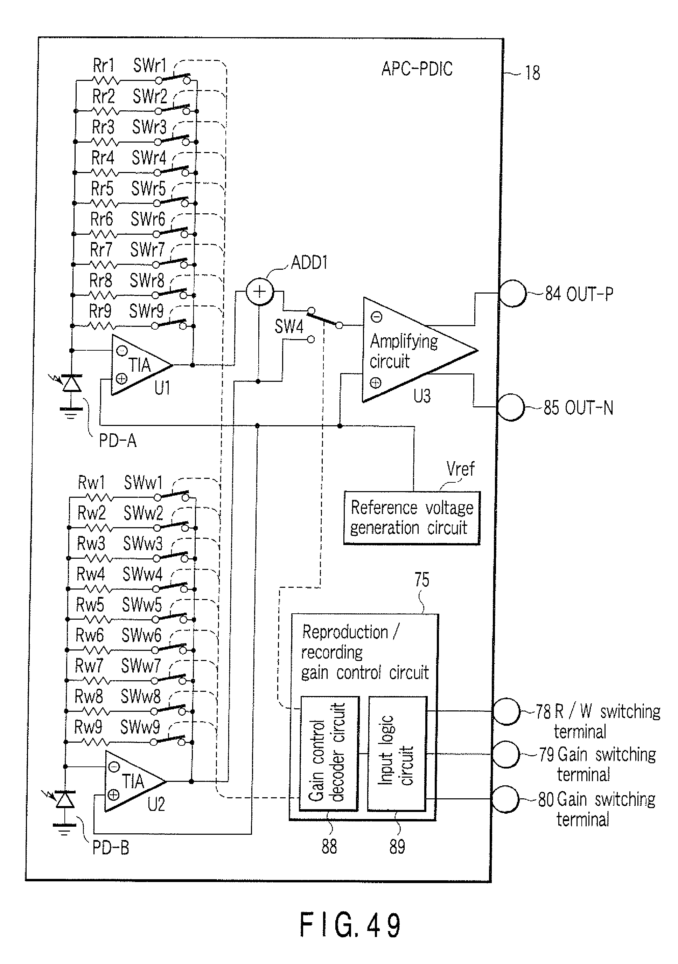

FIG. 49 is a diagram showing an embodiment in which VRA1 and VRA2 which are gain adjustment units of the embodiment of FIG. 44. The TIA circuits U1 and U2 on the first stage and the transimpedance which constitutes a gain setting are provided respectively in nine circuit portions. More specifically, nine series circuits of resistors and switches are connected in parallel between the negative input terminal of the TIA circuit U1 and the output terminal. The resistors are denoted by symbols Rr1 to Rr9, and the switches are denoted by symbols SWr1 to SWr9. Similarly, nine series circuits of resistors and switches are connected in parallel between the negative input terminal of the TIA circuit U2 and the output terminal. The resistors are denoted by symbols Rw1 to Rw9, and the switches are denoted by symbols SWw1 to SWw9.

In the gain mode in this embodiment, assuming that the R/W switching terminal 78 can be controlled in two states, and the gain switching terminal 79 and the gain switching terminal 80 can be controlled in three states, a multiple-stage gain mode can be set as follows.

```
3 states × 3 states × 2 states = 18 gain modes
```

Out of the 18 gain modes, the reproduction 9 gain modes are provided on Rr1 to Rr9, and the recording 9 gain modes are provided on Rw1 to Rw9. The gain and transimpedance are changed over and used between Swr1 to Swr9 and SWw1 to SWw9. The gain mode control by means of the selection and combination of Swr1 to Sr9 and Sww1 to Sww9 and the control of the reproduction and the recording of the switch SW4 are performed via the reproduction/recording gain control circuit 75 in accordance with the control signals input to the R/W switching terminal 78, the gain switching terminal 79, and the gain switching terminal 80. An internal circuit of the reproduction/recording gain control circuit 75 mainly comprises an input logic circuit 89 for detecting a 3-state input and a gain control decoder circuit 88 for turning on and off the SWr and SWw. The other circuit operations are the same as FIG. 44, and the detailed explanation thereof is omitted.

FIG. 50 is a diagram showing a variation of the embodiment of FIG. 49. The circuit which constitutes the base is shown in FIG. 44. Between the negative input terminal of the TIA circuit U1 and the output terminal, one transimpedance Rr, two transimpedances Rr, four transimpedances Rr and eight transimpedances Rr are connected in series. Then, an electronic switch SWr1 is connected in parallel to one transimpedance Rr. An electronic switch SWr2 is connected in parallel to two transimpedances Rr. An electronic switch SWr3 is connected in parallel to four transimpedances Rr, and an electronic switch SWr4 is connected to eight transimpedances Rr. The electronic switches SWr1, SWr2, SWr3 and SWr4 are connected in series.

In a similar manner, between the negative input terminal of the TIA circuit U2 and the output terminal, one transimpedance Rw, two transimpedances Rw, four transimpedances Rw and eight transimpedances Rw are connected in series. Then, an electronic switch SSw1 is connected in parallel to one Rw. An electronic switch SWw2 is connected in parallel to two Rw's. An electronic switch SWw3 is connected in parallel to four RW's. An electronic switch SWw 4 is connected in parallel to eight RW's. The electronic switches SWr1, SWr2, SWr3 and SWr4 are connected in series.

It becomes possible to set in a various manner the gains of the TIA circuit U1 and the TIA circuit U2 with the selection and the combination of the ON and OFF of the electronic switches SWr1, SWr2, SWr3 and SWr4, and the electronic switches SWw1, SWw2, SWw3 and SWw4.

Since a plurality of the same transimpedances are used in arrangement so that a so-called parity between resistors which is one large characteristic of the IC is eliminated, there is provided a large characteristic in that a correlative gain can be easily set to each other, and the gain can be very easily adjusted.

Furthermore, in this circuit, the amplifying circuit U3 also assumes the same circuit method. That is, between the negative input terminal of the amplifying circuit U3 and the switch SW4, one impedance Rrw is connected. Further, between the negative input terminal of the amplifying circuit U3 and the output terminal OUT-P 84, two impedances Rrw's are connected in series. Furthermore, to the impedance Rrw at the rear stage within the two impedances Rrw's connected in series, one impedance Rrw is connected in parallel. Moreover, to the impedance Rrw connected in parallel an electronic switch SWrw1 is connected in parallel.

Still furthermore, one transimpedance Rrw is connected between the positive input terminal of the amplifying circuit U3 and the reference voltage generation circuit Vref. Further, two impedances Rrw's are connected in series between the positive input terminal of the amplifying circuit U3 and the output terminal OUT-N terminal 85. Moreover, to the impedance Rwr at the rear stage within the two impedances Rw's connected in series, one impedance Rwr is connected in parallel. In addition, an electronic switch Swr2 is connected in parallel to the impedance Rrw connected in parallel.

In this case, the electronic switches SWr1 to SWr4, SWw1 to SWw4, Swr1, Swr2 and the switch SW1 are ON/OFF controlled with a control signal from the reproduction/recording gain control circuit 75. The reproduction/recording gain control circuit 75 outputs the control signal on the basis of the input signals supplied from the R/W switching terminal 78, the gain control terminal 79 and the gain control terminal 80.

The reproduction/recording gain control circuit 75 comprises an input logic circuit 89 for primarily detecting a 3-state input, and a gain control decoder 88 for ON/OFF controlling the electronic switches SWr1 to SWr4, SWw1 to SWw4, SWrw1, and SWrw2.

In this case, it is supposed that the electronic switch SWrw1 and the electronic switch SWrw2 are operated in association with each other. That is, in the case where the electronic switches SWr1 and SWr2 are turned off, the gain is given in the following equation 01.

$$(Rrw + Rrw//Rrw)/Rrw = 1.5 \ times \quad \dots \ (equation\ 01)$$

In the case where the electronic switches SWrw1 and SWrw2 are turned on, the gain is given in the equation 02.

$$(Rrw)/Rrw = 1 \ time \qquad \dots \ (equation\ 02)$$

Consequently, with the above-described configuration, a mode with a gain ratio of one to sixteen times can be obtained in the TIA circuit U1 on the reproduction side. Furthermore, a mode with a gain ratio of 1 to 1.5 times can be obtained with the ON/OFF control of the SWrw1 and SWrw2. The other circuit operations are the same as FIG. 44, and an explanation thereof is omitted.

Accordingly, in the gain mode of the present embodiment, the gain setting shown in FIG. 51 described later can be easily set. That is, in the U1 side circuit, 1-fold gain and 1.5-fold gain can be created on the basis of a mode with a gain ratio of 1 to 16 times and the ON/OFF of the switches SNrw1 and SWrw2, so that the characteristic of FIG. 51 can be obtained with no problem.

Incidentally, a common thing holds true of each of the embodiments. As shown in FIG. 50, in the case where an optimal gain is determined for each of the devices, control information for setting the gain may be stored in a memory. It becomes unnecessary to give control information by means of software from a system control unit of the device each time by storing the control information in the memory.

The multiple-stage gain mode of the present invention will be explained with reference to the following tables 1 and 2, and FIG. 51. Since this expression is troublesome, the gain is referred to as sensitivity.

As has been explained so far, in the case where three control inputs are given, gain modes of 3 x 3 x 3 = 27 can be applied thereto. However, in the embodiment of FIG. 50, 18 gain modes are provided. This is because the eighteen modes can be provided from a calculation that 2 x 3 x 3 = 18 is given with three kinds of control input of the R/W switching terminal 78, the gain switching terminal 79 and the gain switching terminal 80.

Conditions for setting the characteristic are presumed as follows.

Transmittance rate from laser to objective lens ... 20%

Light receiving amount rate of APC-PDIC with respect to laser outgoing power ... 1% of laser outgoing power

Under such conditions, one example of sensitivity on the reproduction side is shown in Table 1 hereinbelow.

When conditions are presumed such that:

$$\text{PDIC output voltage (mV)} = \text{Vout}$$

Outgoing laser power of objective lens (mW) = Po

Light receiving amount rate of APC-PDIC with respect to laser outgoing power (%) = Ri

$$\text{Sensitivity (mV/}\mu\text{W)} = S,$$

a calculation equation of the output voltage is can be represented as follows.

[Mathematical Expression 1]

$$Vout \;\; = \frac{Po \; \times 10^{\,3}}{To} \times \, Ri \; \times \, S$$

For example, in the case where the sensitivity is 14.3 (mV/$\mu$W) and the outgoing laser power of the objective lens is 0.7 (mW), the following mathematical expression is given.

[Mathematical Expression 2]

$$\frac{0.7 \times 10^{\,3}}{0.2} \times 0.01 \times 14.3 = 500.5\,(mv)$$

As seen from the reference of the item of the sensitivity, the sensitivity ratio is heightened toward the left having a high sensitivity when setting as a reference 2.4 mV/uW which is the minimum sensitivity. The sensitivity ratio on the first row from the lower place of Table 1 becomes a gain ratio in terms of the circuit.

Table 1

| Outgoing laser power of objective lens (mW) | Reproduction Sensitivity and output voltage (mV) | | | | | | | | |
|---|---|---|---|---|---|---|---|---|---|
| | 38 mV/uW | 28.6 mV/uW | 19 mV/uW | 14.3 mV/uW | 9.5 mV/uW | 7.1 mV/uW | 4.8 mV/uW | 3.6 mV/uW | 2.4 mV/uW |
| 0.1 | 190.5 | 142.9 | 95.2 | 71.4 | 47.6 | 35.7 | 23.8 | 17.9 | 11.9 |
| 0.2 | 381.0 | 285.7 | 190.5 | 142.9 | 95.2 | 71.4 | 47.6 | 35.7 | 23.8 |
| 0.3 | 571.4 | 428.6 | 285.7 | 214.3 | 142.9 | 107.1 | 71.4 | 53.6 | 35.7 |
| 0.4 | 761.9 | 571.4 | 381.0 | 285.7 | 190.5 | 142.9 | 95.2 | 71.4 | 47.6 |
| 0.5 | 952.4 | 714.3 | 476.2 | 357.1 | 238.1 | 178.6 | 119.0 | 89.3 | 59.5 |
| 0.6 | 1142.9 | 857.1 | 571.4 | 428.6 | 285.7 | 214.3 | 142.9 | 107.1 | 71.4 |
| 0.7 | 1333.3 | 1000.0 | 666.7 | 500.0 | 333.3 | 250.0 | 166.7 | 125.0 | 83.3 |
| 0.8 | 1523.8 | 1142.9 | 761.9 | 571.4 | 381.0 | 285.7 | 190.5 | 142.9 | 95.2 |
| 0.9 | 1714.3 | 1285.7 | 857.1 | 642.9 | 428.6 | 321.4 | 214.3 | 160.7 | 107.1 |
| 1.0 | 1904.8 | 1428.6 | 952.4 | 714.3 | 476.2 | 357.1 | 238.1 | 178.6 | 119.0 |
| 1.5 | 2857.1 | 2142.9 | 1428.6 | 1071.4 | 714.3 | 535.7 | 357.1 | 267.9 | 178.6 |
| 2.0 | 3809.5 | 2857.1 | 1904.8 | 1428.6 | 952.4 | 714.3 | 476.2 | 357.1 | 238.1 |
| 2.5 | 4761.9 | 3571.4 | 2381.0 | 1785.7 | 1190.5 | 892.9 | 595.2 | 446.4 | 297.6 |
| 3.0 | 5714.3 | 4285.7 | 2857.1 | 2142.9 | 1428.6 | 1071.4 | 714.3 | 535.7 | 357.1 |
| 4.0 | 7619.0 | 5714.3 | 3809.5 | 2857.1 | 1904.8 | 1428.6 | 952.4 | 714.3 | 476.2 |
| 5.0 | 9523.8 | 7142.9 | 4761.9 | 3571.4 | 2381.0 | 1785.7 | 1190.5 | 892.9 | 595.2 |
| 6.0 | 11428.6 | 8571.4 | 5714.3 | 4285.7 | 2857.1 | 2142.9 | 1428.6 | 1071.4 | 714.3 |
| 7.0 | 13333.3 | 10000.0 | 6666.7 | 5000.0 | 3333.3 | 2500.0 | 1666.7 | 1250.0 | 833.3 |
| 8.0 | 15238.1 | 11428.6 | 7619.0 | 5714.3 | 3809.5 | 2857.1 | 1904.8 | 1428.6 | 952.4 |
| 9.0 | 17142.9 | 12857.1 | 8571.4 | 6428.6 | 4285.7 | 3214.3 | 2142.9 | 1607.1 | 1071.4 |
| 10.0 | 19047.6 | 14285.7 | 9523.8 | 7142.9 | 4761.9 | 3571.4 | 2381.0 | 1785.7 | 1190.5 |
| Sensitivity ratio (Gain ratio) | 16.0 | 12.0 | 8.0 | 6.0 | 4.0 | 3.0 | 2.0 | 1.5 | 1.0 |

Next, under this condition, the sensitivity on the recording side is shown in the following Table 2.

A calculation equation of the output voltage is the same as in reproduction, its explanation is omitted.

As seen from the reference on the items of the sensitivity, the sensitivity ratio is heightened toward the left side having a high sensitivity when setting as a reference 0.1 mV/uW which is the minimum sensitivity. The sensitivity ratio from the first row from the bottom of Table 2 becomes a gain in terms of the circuit.

Table 2

| Outgoing laser power of objective lens (mW) | Recording Sensitivity and output voltage (mV) | | | | | | | | |
|---|---|---|---|---|---|---|---|---|---|
| | 1.7 mV/uW | 1.25 mV/uW | 0.83 mV/uW | 0.625 mV/uW | 0.42 mV/uW | 0.31 mV/uW | 0.21 mV/uW | 0.16 mV/uW | 0.1 mV/uW |
| 0.1 | 8.3 | 6.3 | 4.2 | 3.1 | 2.1 | 1.6 | 1.0 | 0.8 | 0.5 |
| 0.2 | 16.7 | 12.5 | 8.3 | 6.3 | 4.2 | 3.1 | 2.1 | 1.6 | 1.0 |

(continued)

| Outgoing laser power of objective lens (mW) | Recording Sensitivity and output voltage (mV) | | | | | | | | |
|---|---|---|---|---|---|---|---|---|---|
| | 1.7 mV/uW | 1.25 mV/uW | 0.83 mV/uW | 0.625 mV/uW | 0.42 mV/uW | 0.31 mV/uW | 0.21 mV/uW | 0.16 mV/uW | 0.1 mV/uW |
| 0.3 | 25.0 | 18.8 | 12.5 | 9.4 | 6.3 | 4.7 | 3.1 | 2.3 | 1.6 |
| 0.4 | 33.3 | 25.0 | 16.7 | 12.5 | 8.3 | 6.3 | 4.2 | 3.1 | 2.1 |
| 0.5 | 41.7 | 31.3 | 20.8 | 15.6 | 10.4 | 7.8 | 5.2 | 3.9 | 2.6 |
| 0.6 | 50.0 | 37.5 | 25.0 | 18.8 | 12.5 | 9.4 | 6.3 | 4.7 | 3.1 |
| 0.7 | 58.3 | 43.8 | 29.2 | 21.9 | 14.6 | 10.9 | 7.3 | 5.5 | 3.6 |
| 0.8 | 66.7 | 50.0 | 33.3 | 25.0 | 16.7 | 12.5 | 8.3 | 6.3 | 4.2 |
| 0.9 | 75.0 | 56.3 | 37.5 | 28.1 | 18.8 | 14.1 | 9.4 | 7.0 | 4.7 |
| 1.0 | 83.3 | 62.5 | 41.7 | 31.3 | 20.8 | 15.6 | 10.4 | 7.8 | 5.2 |
| 1.5 | 125.0 | 93.8 | 62.5 | 46.9 | 31.3 | 23.4 | 15.6 | 11.7 | 7.8 |
| 2.0 | 166.7 | 125.0 | 83.3 | 62.5 | 41.7 | 31.3 | 20.8 | 15.6 | 10.4 |
| 2.5 | 208.3 | 156.3 | 104.2 | 78.1 | 52.1 | 39.1 | 26.0 | 19.5 | 13.0 |
| 3.0 | 250.0 | 187.5 | 125.0 | 93.8 | 62.5 | 46.9 | 31.3 | 23.4 | 15.6 |
| 4.0 | 333.3 | 250.0 | 166.7 | 125.0 | 83.3 | 62.5 | 41.7 | 31.3 | 20.8 |
| 5.0 | 416.7 | 312.5 | 208.3 | 156.3 | 104.2 | 78.1 | 52.1 | 39.1 | 26.0 |
| 6.0 | 500.0 | 375.0 | 250.0 | 187.5 | 125.0 | 93.8 | 62.5 | 46.9 | 31.3 |
| 7.0 | 583.3 | 437.5 | 291.7 | 218.8 | 145.8 | 109.4 | 72.9 | 54.7 | 36.5 |
| 8.0 | 666.7 | 500.0 | 333.3 | 250.0 | 166.7 | 125.0 | 83.3 | 62.5 | 41.7 |
| 9.0 | 750.0 | 562.5 | 375.0 | 281.3 | 187.5 | 140.6 | 93.8 | 70.3 | 46.9 |
| 10.0 | 833.3 | 625.0 | 416.7 | 312.5 | 208.3 | 156.3 | 104.2 | 78.1 | 52.1 |
| 15.0 | 1250.0 | 937.5 | 625.0 | 468.8 | 312.5 | 234.4 | 156.3 | 117.2 | 78.1 |
| 20.0 | 1666.7 | 1250.0 | 833.3 | 625.0 | 416.7 | 312.5 | 208.3 | 156.3 | 104.2 |
| 25.0 | 2083.3 | 1562.5 | 1041.7 | 781.3 | 520.8 | 390.6 | 260.4 | 195.3 | 130.2 |
| 30.0 | 2500.0 | 1875.0 | 1250.0 | 937.5 | 625.0 | 468.8 | 312.5 | 234.4 | 156.3 |
| 40.0 | 3333.3 | 2500.0 | 1666.7 | 1250.0 | 833.3 | 625.0 | 416.7 | 312.5 | 208.3 |
| 50.0 | 4166.7 | 3125.0 | 2083.3 | 1562.5 | 1041.7 | 781.3 | 520.8 | 390.6 | 260.4 |
| 60.0 | 5000.0 | 3750.0 | 2500.0 | 1875.0 | 1250.0 | 937.5 | 625.0 | 468.8 | 312.5 |
| 70.0 | 5833.3 | 4375.0 | 2916.7 | 2187.5 | 1458.3 | 1093.8 | 729.2 | 546.9 | 364.6 |
| 80.0 | 6666.7 | 5000.0 | 3333.3 | 2500.0 | 1666.7 | 1250.0 | 833.3 | 625.0 | 416.7 |
| 90.0 | 7500.0 | 5625.0 | 3750.0 | 2812.5 | 1875.0 | 1406.3 | 937.5 | 703.1 | 468.8 |
| 100.0 | 8333.3 | 6250.0 | 4166.7 | 3125.0 | 2083.3 | 1562.5 | 1041.7 | 781.3 | 520.8 |
| Sensitivity ratio (Gain ratio) | 16.0 | 12.0 | 8.0 | 6.0 | 4.0 | 3.0 | 2.0 | 1.5 | 1.0 |

FIG. 51 is a view in which the characteristics of the outgoing laser output toward an object as against the output voltage of the APC-PDIC shown in the tables 1 and 2 are represented in a graph. Both the reproduction and the recording are plotted to the same graph.

An X-axis of the graph shows an objective lens outgoing laser output. In general, the objective lens outgoing light amount of laser generally requires 0.5 mW at the reproduction time and 75 mW or more which is approximate to 150 times at the peak power at the recording time depending on the double speed class. Further, in consideration of the rise in the laser power owing to a disparity of the disk, the maximum is set to 100 mW.

Furthermore, a Y-axis shows an output voltage of the APC-PDIC. A dynamic range which is conventionally set approximately to 2 V is set to a half level, namely, 1 V with a view to lower the consumed electric power. Although described in detail later, at least the consumed electric power of the output stage can be decreased to about a half as a consequence.

As described above, as seen from the respective tables of the reproduction and recording, the sensitivity ratio is a gain in terms of the circuit. For this reason, a group of resistors Rr or Rw of FIG. 50 can easily realize a gain in the Table 1 with ON/OFF of the SWr or SWw. Furthermore, an unequal integer number of 1.5 times will be realized by the amplifying circuit U3 at the rear stage.

So far, a multiple gain mode has been explained. This multiple gain mode can be applied to all the embodiments which have been so far explained.

In addition, as a matter of course, this gain allocation is merely one example. As to the other gain allocation, the gain and the gain ratio can be simply changed when the transimpedance (resistor) and the impedance (resistor) of FIG. 50 are changed.

Next, a lower consumed electric power of the present invention will be explained.

As is well known, the consumed electric power is represented in the following mathematical expression:

[Mathematical Expression 3]

$$i = C \times \frac{\Delta V}{\Delta t}$$

wherein i denotes a current; C denotes a capacity; $\Delta V$ denotes a voltage; and $\Delta t$ denotes a time.

Reference: Circuit Analysis for Learners of Engineering Vol. 1: Published by McGrowhill Publishing Co. Ltd.

Consequently, as seen from this mathematical expression, the voltage denoted by $\Delta V$ and a load capacity denoted by C are decreased, whereby a current that is an index of the load drive capability is lowered, and the consumed electric power can be decreased. As shown in the table of FIG. 51, the dynamic range which is conventionally set approximately to 2 V is set to a half, namely, 1 V in order to attempt to decrease the consumed electric power. As a consequence, even if the time $\Delta V$ and the load capacity C which constitute other reasons remain unchanged, at least the consumed electric power of the circuit at the rear stage can be decreased to about a half level.

Since an analog circuit which has a dominant consumed electric power is a final stage circuit for driving a load, although depending on the scale of the analog circuit, the current decrease at this output stage largely contributes toward a lower consumed electric power.

In actuality, the capacity Cf is connected in parallel to the resistor shown in the circuit of FIGS. 49 and 50, so that the frequency characteristic and the like can be set and adjusted.

So far, as has been explained above, according to the present invention, a multiple gain mode is provided. However, using an extremely small output voltage leads to a lower consumed electric power.

The characteristic and the advantage of the above-described embodiment will be described hereinbelow.

1. For a lower consumed electric power a multiple gain mode is provided, and the dynamic range and the through rate are lowered by just that much.
2. In order to compensate for the disparity resulting from the wavelength sensitivity of the APC-PDIC and the disparity of the wavelength of the laser, the fixed gain method is adopted, and the external volume is eliminated.
3. The photo detector cell is divided into two parts, which are respectively used for reproduction and for recording.

In this manner, according to the present invention, external parts such as a volume are not required. Then, it becomes possible to provide a cheap APC-PDIC which has an excellent AC characteristic in the reproduction system and in the recording system and which consumes a lower power and radiates a smaller amount of heat.

According to the present invention described above, an advantage can be obtained which will be described hereinbelow. That is, according to the present invention, the fundamentals of the original circuit technology are first strictly observed, thereby attempting to lower the consumed electric power. In the beginning, it is deeply sought as to which part can be removed in what way, whereby the personnel work such as a volume adjustment is eliminated, and an attempt is made to lower a consumed electric power.

The red laser which is used in the DVD, the temperature characteristic is very poor as compared with other blue laser and infrared laser. When the temperature rises, the rate at which the laser output falls is large. In other words, those skilled in the art well know that, with the red laser, a so-called IL curve (I = laser drive current, L = laser light emission amount) rises when the temperature rises, so that the laser output falls.

Consequently, set manufacturers manufacturing optical disks have a hard time in this temperature measurement and the control of the laser light amount.

Accordingly, to put it in an extreme way, a small heating of the circuit parts except for the laser results in the prevention of an increase in the temperature. It follows that by just that much, an output of laser does not decrease. In other words, with no rise in the temperature of the laser by means of parts except for heat generation of the laser itself, an output of laser does not fall.

The present invention is intended to decrease a consumed electric power of the APC-PDIC which is monitoring a laser power by placing an importance on and taking note of this point.

The present invention realizes a lower consumed electric power, the elimination of the external adjustment resistor and the elimination of the volume by increasing the number of the fixed gain modes and further decreasing a size of the dynamic range in order to lower the consumed electric power.

According to the embodiment, a large advantage as described hereinbelow will be obtained.

1. The external parts for the adjustment of the volumes, resistors, and the APC-PDIC gain become unnecessary. As a result, the design of a flexible substrate which is mounted on the PUH becomes easy. An external volume for compensating for various disparities becomes unnecessary. The disparities include 1) the sensitivity disparity of the APC-PDIC itself; 2) disparity resulting from the wavelength sensitivity of the APC-PDIC itself; 3) disparity in the light amount of laser; 4) disparity in the wavelength of laser; 5) disparity in the position of the APC-PDIC; and 6) disparity in the transmittance rate and reflection rate of the parts of the optical system. These disparities will come to be handled with software (a firmware), and the manufacture thereof can be automated. As a consequence, the manufacturing time can be shortened and the personnel cost can be largely cut down.

Furthermore, this result leads to the cost reduction of the pickup. In addition, owing to the elimination of the need of the volume which serves as an adjustment element, it becomes unnecessary to consider the volume, so that the design of the adjustment instrument is facilitated.

2. It becomes possible to lower the consumed electric power.

As a consequence, the heat generation can be decreased. This makes it possible to suppress a rise in the temperature in the drive. In addition, taking measures against heating and the development cost for the measures against heat generation are made unnecessary. As a result, with the slim drives and ultra slim drives incorporated in the notebook type personal computers, there is provided a large advantage in that the life of batteries is prolonged, and furthermore, the life of the drive itself is prolonged, and the reliability thereof increases.

Moreover, this makes it possible to thin down the thicknesses of the wiring width of the flexible substrate mounted on the pickup head, a power source to the substrate of the drive main body from the flexible substrate, and the wiring width to the signal wiring.

3. When the number of the photo detector cells is two, it becomes easy to take a balance between the characteristic at the time of reproduction and the characteristic at the time of recording.

Here, the photo detector cell for reproduction and the photo detector cell for recording are divided from each other. Further, the light receiving areas of the photo detector cell for reproduction and the photo detector cell for recording are used in a reasonable manner. Furthermore, an output of the photo detector cell for reproduction and an output of the photo detector cell for recording are added to be used as an output of the reproduction system.

Consequently, it becomes possible to optimize not only the sensitivity characteristic but also the current characteristic such as the frequency band, the phase characteristic, the through rate, and the group delay characteristic respectively in the reproduction system and in the recording system. That is, with the reproduction system, the laser power is small, and the frequency band may be low on the order of 1 MHz or the like. Therefore, it becomes possible to enlarge the signal size and better the SN by enlarging the area of the photo detector cell. On the other hand, a very large laser power which is about 150 times as large as the laser power of the reproduction system can be applied. For this reason, a high-speed pulse must be received in a wide band. In consideration of this point, the size of the photo detector cell for the recording system is reduced as compared with the size of the photo detector cell for the reproduction system, whereby it becomes possible to correspond to the higher speed recording and the high-speed recording.

As has been described so far, in a method for monitoring a light amount of laser by using the two photo detector cells, there is provided an advantage in that it becomes easy to take a balance between the two specifications, i.e., the specification of the reproduction system and the specification of the recording system.

By optimizing the size of the photo detector cell in the sensitivity characteristic and the current characteristic, it becomes possible to easily perform the APC control for stabilizing a laser power by monitoring a laser power accurately with good linearity even in the case where the ratio of the laser power of the reproducing laser power and the recording laser power is set to 1:150.

Moreover, with optical disks, a high-speed change-over is demanded such that the reproduction is performed immediately after the recording and the recording is performed immediately after the reproduction. However, with the circuit using the APC-PDIC of the present invention, a large problem ceases to exist such that the change-over speed is delayed at the time constant on the side of the lower band. Thus, there is provided a large advantage in that the change-over of the recording and reproduction is enabled at a high speed.

As has been described above, in the embodiment, it becomes possible to provide a cheap APC-PDIC having an excellent AC characteristic in the reproduction system and the recording system wherein the external parts such as the volume are not required and the consumed electric power/heat generation is small.

**Claims**

1. A photodetector circuit which monitors a light emission amount of laser of an optical disk apparatus, the circuit **characterized by** comprising:

   first and second photo detector cells (PD-A,PD-B);
   a first processing circuit (100) which derives as a control signal of a laser drive circuit an addition output of electric signals subjected to opto-electric conversion from the first and second photo detector cells at the time of a disk reproducing laser power; and
   a second processing circuit (200) which derives as a control signal of the laser drive circuit an electric signal subjected to opto-electrical conversion from any one of the first or second photo detector cells at the time of a disk recording laser power.

2. The photodetector circuit according to claim 1, **characterized in that** the first processing circuit (100) which sets to a control signal of the laser drive circuit an addition output of electric signals subjected to opto-electric conversion from the first and second photo detector cells obtains the addition output by turning on an analog switch (SW4) which adds the electric signals subjected to the opto-electric conversion from the first and second photo detector cells at the time of the disk reproducing laser power.

3. The photodetector circuit according to claim 1, **characterized in that** the first processing circuit (100) which sets to a control signal of the laser drive circuit an addition output of electric signals subjected to opto-electric conversion from the first and second photo detector cells obtains the addition output from an addition circuit (ADD1) which adds electric signals subjected to the opto-electric conversion from the first and second photo detector cells.

4. The photodetector circuit according to claim 1, **characterized in that** the first processing circuit (100) includes: an analog switch (SW4) which adds the electric signals subjected to the opto-electric conversion from the first and second photo detector cells by turning on the signal at the time of the disk reproducing laser power; and a first amplifying circuit (U4, U7) which amplifies an addition output from the analog switch, and
   the second processing circuit (200) includes: a second amplifying circuit (U5, U8) which amplifies the electric signal subjected to the opto-electric conversion from the second photo detector cell in a state in which the analog switch is turned off at the time of the disk recording laser power.

5. The photodetector circuit according to claim 1, **characterized in that** the first processing circuit has a first amplifying circuit which amplifies the electric signal subjected to the opto-electric conversion from the first photo detector cell, the second processing circuit has a second amplifying circuit which amplifies the electric signal subjected to the opto-electric conversion from the second photo detector cell, and
   the circuit is configured so that an output of the first amplifying circuit and an output of the second amplifying circuit are selectively derived with a change-over switch (SW3).

6. The photodetector circuit according to claim 1, **characterized by** further comprising:

   a change-over switch which (SW3)is supplied with the outputs of the first and second processing circuits to selectively derive either of the outputs; and
   an amplifying circuit (U3, U6) which buffers an output signal of the change-over switch and outputs a signal with a single end output or a differential output.

7. The photodetector circuit according to claim 1, **characterized in that** the first and second processing circuits respectively include current amplifying circuits (U7, U8) which amplify the electric signals subjected to the opto-electric conversion from the first and second photo detector cells.

8. The photodetector circuit according to claim 1, **characterized by** further comprising:

   a change-over switch (SW3) which selects any one of the outputs of the first and second processing circuits;
   a current-voltage conversion circuit (U10) which performs current-voltage conversion to an output of the change over switch; and
   an amplifying circuit (U6) which buffers a signal subjected to the current-voltage conversion and outputs the signal with a single end output or a differential output.

9. The photodetector circuit according to claim 1, **characterized by** further comprising:

   a change-over switch (SW3) which selects any one of the outputs of the first and second processing circuits;
   a current-voltage conversion circuit (U10) which performs current-voltage conversion to an output of the change-over switch; and
   an amplifying circuit (U6) which buffers a signal subjected to the current-voltage conversion and outputs the signal with a single end output or a differential output,
   wherein the first processing circuit further includes an analog switch (SW4) which adds the electric signals subject to the opto-electric signal from the first and second photo detector cells.

10. The photodetector circuit according to claim 1, **characterized by** further comprising:

    a change-over switch (SW3) which selects any one of the outputs of the first and second processing circuits;
    a current-voltage conversion circuit (U10) which performs current-voltage conversion to an output of the change over switch; and
    an amplifying circuit (U6) which buffers a signal subjected to the current-voltage conversion and outputs the signal with a single end output or a differential output,
    wherein the second processing circuit further has a second current amplifier (U8) which amplifies the electric signal subjected to the opto-electric conversion from the second photo detector cell; and
    the first processing circuit further has a first current amplifier (U7) which amplifies the electric signal subjected to the opto-electric conversion from the first photo detector cell, and an addition circuit (ADD1) which adds an output of the first current amplifier and an output of the second amplifier to output to the change-over switch (SW3).

11. The photodetector circuit according to claim 1, **characterized in that** a reference voltage generation circuit is formed on the same substrate as the substrate on which the first and second processing circuits are mounted.

12. The photodetector circuit according to claim 1, **characterized in that** a circuit is adopted which sets a signal output to a high impedance state when controlled to a non-active state as a circuit of an output stage of the first and second processing circuits.

13. The photodetector circuit according to claim 1, **characterized in that** the first and second photo detector cells are formed in patterns on the substrate, and an area of the second photo detector cell for use in recording is formed in a size smaller than an area of the first photo detector cell.

14. A method for deriving a control signal of a laser light emission amount of an optical disk apparatus, the method **characterized by** comprising:

    using first and second photo detector cells, a first processing circuit, and a second processing circuit;
    deriving from the first processing circuit as a control signal of a laser drive circuit an addition output of electric signals subjected to opto-electric conversion from the first and second photo detector cells at the time of a disk reproducing laser power; and
    deriving from the second processing circuit as a control signal of the laser drive circuit an electric signal subjected to opta-electric conversion from any one of the first and second photo detector cells at the time of a disk recording laser power.

15. The method for deriving a control signal of a laser light emission amount, according to claim 14, **characterized by** further comprising:

adding the electric signals subjected to the opto-electric conversion from the first and second photo detector cells by turning on an analog switch at the time of the disk reproducing laser power in order to obtain the addition output from the first processing circuit.

16. The method for deriving a control signal of a laser light emission amount, according to claim 14, **characterized by** further comprising:

adding the electric signals subjected to the opto-electric conversion from the first and second photo detector cells in order to obtain the addition output from the first processing circuit.

17. An optical pickup device of an optical disk apparatus configured to change over a disk reproducing laser power and a disk recording laser power,
**characterized in that** a photodetector circuit which monitors a laser light amount in the midst of an optical path of laser comprises:

first and second photo detector cells;
a first processing circuit which derives as a control signal of a laser drive circuit an addition output of electric signals subjected to opto-electric conversion from the first and second photo detector cells at the time of a disk reproducing laser power; and
a second processing circuit which derives as a control signal of the laser drive circuit an electric signal subjected to opto-electric conversion from any one of the first and second photo detector cells at the time of a disk recording laser power.

18. The photodetector circuit according to claim 1, **characterized in that** the first processing circuit and the second processing circuit are formed on the same substrate as the substrate on which the first and second photo detector cells are mounted.

19. The photodetector circuit according to claim 1, **characterized in that** the first processing circuit and the second processing circuit are formed over a first substrate having the first and second photo detector cells formed thereon and a second substrate having the laser drive circuit formed thereon.

20. The photodetector circuit according to claim 1, **characterized in that** the second processing circuit has a current mirror circuit of one-input and two-output type which amplifies a current output of the second photo detector cell subjected to the opto-electric conversion,
the first processing circuit has:

a first current mirror circuit of one-input and one-output type which amplifies a current output of the first photo detector cell subjected to the opto-electric conversion; and
an addition unit which obtains the addition output by connecting an output unit of the first current mirror circuit and an output unit of the second current mirror circuit.

21. A photodetector circuit which monitors a light emission amount of laser, **characterized by** comprising:

a plurality of rectangular shaped light receiving areas which are arranged on a substrate;
a first photo detector cell (PD-A12) formed by connecting the light receiving areas with a metal wiring; and
a second photo detector cell (PD-B) formed by connecting the light receiving areas except for the first photo detector cell with a metal wiring,
wherein the circuit is configured so that outputs of both the first and second photo detector cells are used at the reproduction time whereas an output of any one of the first and second photo detector cells is used at the recording time.

22. The photodetector circuit according to claim 21, **characterized in that** the circuit is configure so that a whole area is used or that cell outputs are added in order to use both the outputs of both the first and second photo detector cells at the reproduction time, and the circuit is configured so that a light receiving area smaller than that at the reproduction time is used in order to use an output of any one of the first and second photo detector cells.

**23.** A photodetector circuit which monitors a light emission amount of laser, **characterized in that** at least three rectangular light receiving areas are arranged on a substrate,
outside light receiving areas out of the three light receiving areas are formed by connection with a metal (51) wiring to form the first photo detector cell (PD-A1, PD-A2) , and
inside light receiving areas out of the three light receiving areas constitute a second photo detector cell (PD-B).

**24.** The photodetector circuit according to claim 23, wherein the shape of two long sides of the light receiving areas constituting the second photo detector cell is an arc, and each long side of each of the outside light receiving areas constituting the first photo detector cell is a reverse arc, the long sides of the latter areas running opposite to the long sides of the former areas.

**25.** The photodetector circuit according to claim 23, **characterized in that** the shape of two long sides of the light receiving areas constituting the second photo detector cell is an arc; each long side of each of the outside light receiving areas constituting the first photo detector cell is a reverse arc, the long sides of the latter areas running opposite to the long sides of the former areas; and each long side outside of the light receiving areas is an arc.

**26.** The photodetector circuit according to claim 23, **characterized in that** the shape of two long sides of the light receiving areas constituting the second photo detector cell is a straight line; each long side of each of the outside light receiving areas constituting the first photo detector cell is a straight line, the long sides of the latter areas running opposite to the long sides of the former areas; and each long side outside of each of the light receiving areas is an arc.

**27.** The photodetector circuit according to claim 23, **characterized in that** three or more light receiving areas are arranged, and
light receiving areas which form the first photo detector cell and light receiving areas which form the second photo detector cell are alternately arranged, and the light receiving areas which form the same photo detector cell are connected with a metal wiring.

**28.** The light receiving area according to claim 27, **characterized in that** the light receiving areas which are alternately arranged have thinner widths toward the outside.

**29.** An optical disk apparatus **characterized by** comprising: an optical pickup device configured to change over a disk reproducing laser power and a disk recording laser power of laser from a laser light source; and a photodetector circuit which monitors part of laser in the midst of an optical path of the laser which is directed from the laser light source to a disk,
wherein the photodetector circuit has:

a plurality of rectangular light receiving areas arranged on a substrate;
a first photo detector cell formed by connecting the light receiving areas with a metal wiring; and
a second photo detector cell formed by connecting the light receiving areas except for the first light receiving area with a metal wiring, and
the apparatus is configured so that outputs of both the first and second photo detector cells are used at the reproduction time whereas an output of any one of the first and second photo detector cells is used at the recording time.

**30.** The optical disk apparatus according to claim 29, **characterized in that** the apparatus is configured so that a whole area is used or that cell outputs are added in order to use outputs of both the first and second photo detector cells at the reproduction time, and the apparatus is configured so that a light receiving area smaller than that at the reproduction time is used in order to use an output of any one of the first and second photo detector cells.

**31.** An optical disk apparatus **characterized by** comprising: an optical pickup device configured to change over a disk reproducing laser power and a disk recording laser power of laser from a laser light source; and a photodetector circuit which monitors part of laser in the midst of the laser optical path which is directed from the laser light source to a disk,
wherein the photodetector circuit is such that at least three rectangular light receiving areas are arranged on a substrate, outside light receiving areas out of the three light receiving areas are formed by connection with a metal wiring to form the first photo detector cell, and inside light receiving areas out of the three light receiving areas constitute a second photo detector cell, the optical disk apparatus further comprising:

a first processing circuit which derives as a control signal of a laser drive circuit an addition output of electric signals subjected to opto-electric conversion from the first and second photo detector cells at the disk reproducing laser power; and

a second processing circuit which derives as a control signal of the laser drive circuit an electric signal subjected to opto-electric conversion from any one of the first and second photo detector cells at the disk recording laser power.

32. The optical disk according to claim 31, **characterized in that** the shape of two long sides of the light receiving areas constituting the second photo detector cell is an arc, and each long side of each of the outside light receiving areas constituting the first photo detector cell is a reverse arc, the long sides of the latter areas running opposite to the long sides of the former areas.

33. The optical disk according to claim 31, **characterized in that** the shape of two long sides of the light receiving areas constituting the second photo detector cell is an arc; each long side of each of the outside light receiving areas constituting the first photo detector cell is a reverse arc, the long sides of the latter areas running opposite to the long sides of the former areas; and each long side outside of each of the light receiving areas is an arc.

34. The optical disk apparatus according to claim 31, **characterized in that** the shape of two long sides of the light receiving areas constituting the second photo detector cell is a straight line; each long side of each of the outside light receiving areas constituting the first photo detector cell is a straight line, the long sides of the latter areas running opposite to the long sides of the former areas; and each long side outside of each of the light receiving areas is an arc.

35. The optical disk apparatus according to claim 31, **characterized in that** three or more light receiving areas are arranged, and

light receiving areas which form the first photo detector cell and light receiving areas which form the second photo detector cell are alternately arranged, and the light receiving areas which form the same photo detector cell are connected with a metal wiring.

36. The optical disk apparatus according to claim 35, **characterized in that** the light receiving areas which are alternately arranged have thinner widths toward the outside.

37. A photodetector which monitors a light emission amount of laser, **characterized by** comprising:

a first photo detector cell having a light receiving area; and
a second photo detector cell having a light receiving area,

wherein the circuit is configured so that outputs of both the first and second photo detector cells are used at the reproduction time whereas an output of any one of the first and second photo detector cells is used at the recording time.

38. The photodetector circuit according to claim 37, **characterized in that** the light receiving area of the first light receiving area is formed so as to surround the light receiving area of the second light receiving area.

39. An optical disk apparatus **characterized by** comprising: an optical pickup device configured to change over a disk reproducing laser power and a disk recording laser power of laser from a laser light source; and a photodetector circuit which monitors part of laser in the midst of an optical path of the laser which is directed from the laser light source to a disk,

wherein the photodetector circuit has a first photo detector cell having a light receiving area and a second photo detector cell having a light receiving area, and

the circuit is configured so that outputs of both the first and second photo detector cells are used at the reproduction time whereas an output of any one of the first and second photo detector cells is used at the recording time.

40. The optical disk apparatus according to claim 39, **characterized in that** the light receiving area of the first photo detector cell is formed so as to surround the light receiving area of the second photo detector cell.

41. A photodetector circuit which monitors a light emission amount of laser, **characterized by** comprising:

a photodetector (PD);

an amplifying circuit (U1) which amplifies and outputs an output current from the photodetector;

reproducing and recording integrated impedances (VRr, VRw) which are connected to the amplifying circuit and which are operated with a change-over of a gain of the amplifying circuit at the reproduction time and at the recording time;

a gain control circuit (35) which produces fixed gain modes of 6 types to 27 types by the impedance value VRr for use in reproduction and the impedance value VRw for use in recording respectively, and one type of the fixed gain mode is able to set, and which controls a change-over of the gain of the amplifying circuit at the reproduction time and at the recording time; and

a gain switching terminal (39,40) which gives a setting signal to the gain control circuit from the outside in order to one type of the fixed gain mode.

42. A photodetector circuit which monitors a light emission amount of laser, **characterized by** comprising:

a photodetector including a photo detector cell (PD-A) for a reproduction system and a photo detector cell (PD-B) for a recording system;

a first amplifying circuit (U1) which amplifies and outputs an output current from the photo detector cell of the reproduction system;

a second amplifying circuit (U2) which amplifies and outputs an output current from the photo detector cell of the recording system;

a reproducing integrated impedance (VRA1) which is connected to the first amplifying circuit such that a gain of the first amplifying circuit is changed over;

a recording integrated impedance (VRA2) which is connected to the second amplifying circuit such that a gain of the second amplifying circuit is changed over;

a gain control circuit (43) which produces fixed gain modes of 6 types to 27 types by a value of the reproducing impedance and a value of the recording impedance, and one type of the fixed gain mode is able to set; and

a gain switching terminal (39,40) which gives a setting signal to the gain control circuit from the outside in order to obtain one type of the fixed gain mode.

43. The photodetector circuit according to claim 42, **characterized by** further comprising:

a third amplifying circuit (U3) provided between a current/voltage output terminal of the first amplifying circuit and a monitor output terminal for reproduction; and

a fourth amplifying circuit (U4) provided between a current/voltage output terminal of the second amplifying circuit and a monitor output terminal for recording.

44. The photodetector circuit according to claim 42, **characterized by** further comprising:

a first current amplifier (U5) provided between the photo detector cell for the reproduction system and the first amplifying circuit;

a second current amplifier (U6) provided between the photo detector cell for the recording system and the second amplifying circuit;

a third amplifying circuit (U3) provided between a current/voltage output terminal of the first amplifying circuit and a monitor output terminal for reproduction; and

a fourth amplifying circuit (U4) provided between a current/voltage output terminal of the second amplifying circuit and a monitor output terminal for recording.

45. The photodetector circuit according to claim 42, **characterized by** further comprising:

a switch (SW3) which is turned on and off between an output terminal of the photo detector cell for the reproduction system and an output terminal of the photo detector cell for the recording system; and

a recording and reproduction state switching terminal (38) which turns on and off the switch via the gain control circuit.

46. The photodetector circuit according to claim 42, **characterized by** further comprising:

a second switch wherein output terminals of the first amplifying circuit and the second amplifying circuit are supplied to one input terminal and the other, respectively; and

a recording and reproduction switching terminal which controls a selection state of the second switch via the gain control circuit.

**47.** The photodetector circuit according to claim 42, **characterized by** further comprising:

a second switch wherein output terminals of the first amplifying circuit and the second amplifying circuit are supplied to one input terminal and the other, respectively;
a recording and reproduction state switching terminal which controls a selection state of the second switch via the gain control circuit; and
a differential output amplifying circuit to which an output terminal of the second switch is connected.

**48.** The photodetector circuit according to claim 42,
an addition circuit which adds an output of the first amplifying circuit and an output of the second amplifying circuit;
a second switch **characterized in that** an output of the addition circuit and an output of the second amplifying circuit are supplied to one input terminal and the other, respectively; and
a recording and reproduction state switching terminal which controls a selection state of the second switch via the gain control circuit.

**49.** The photodetector circuit according to claim 42, **characterized by** further comprising:

an addition circuit which adds an output of the first amplifying circuit and an output of the second amplifying circuit;
a third amplifying circuit provided between an output terminal of the addition circuit and a monitor output terminal for reproduction; and
a fourth amplifying circuit provided between an output terminal of the second amplifying circuit and a monitor output terminal for recording.

**50.** The photodetector circuit according to claim 42, **characterized by** further comprising:

an addition circuit which adds an output of the first amplifying circuit and an output of the second amplifying circuit;
a second switch wherein an output of the addition circuit and an output of the second amplifying circuit are supplied to one input terminal and the other, respectively;
a recording and reproduction state switching terminal which controls a selection state of the second switch via the gain control circuit; and
a differential amplifying circuit to which an output terminal of the second switch is connected.

**51.** The photodetector according to claim 42, further including a reference voltage generation circuit, which gives a reference voltage at least to the first amplifying circuit and the second amplifying circuit.

**52.** The photodetector circuit according to claim 42, **characterized by** further comprising: a reference voltage generation circuit; a reference voltage input/output terminal as an external connection terminal; a reference voltage switch which is turned on and off between an output terminal of the reference voltage generation circuit and the reference voltage input/output terminal; and a reference voltage control terminal which controls ON and OFF of the reference voltage switch,
wherein, when the reference voltage is turned on, the reference voltage is given to at least the first amplifying circuit, the second amplifying circuit and an external circuit.

**53.** A photodetector circuit which monitors a light emission amount of laser, **characterized by** comprising:

a photodetector including a photo detector cell for a reproduction system and a photo detector cell for a recording system;
a first current amplifier which amplifies and outputs an output current from the photo detector cell for the reproduction system;
a second current amplifier which amplifies and outputs an output current from the photo detector cell for the recording system;
an addition circuit which adds an output of the first current amplifier and an output of the second amplifier;
a switch wherein an output of the addition circuit and an output of the second current amplifier are supplied to one input terminal and the other, respectively;
a recording and reproduction state switching terminal which controls a selection state of the switch;
a current-voltage conversion circuit to which an output of the switch is supplied;

an integrated impedance which is connected to the current-voltage conversion circuit such that a gain of the current-voltage conversion circuit is changed over;

a gain control circuit which obtains fixed gain modes of 6 types to 27 types by set the impedance value, and one type of the fixed gain mode for recording or reproducing is able to set based on a control signal; and

a differential output amplifying circuit to which an output of the current-voltage conversion circuit is supplied.

54. The photodetector circuit according to claim 53, **characterized in that** the first current amplifier is formed of a current mirror circuit which is connected with the photo detector cell for the reproduction system at the side of a reference current source, the current mirror circuit having a plurality of output units with different current ratios of input and output, and

the second current amplifier is formed of a current mirror circuit which is connected with the photo detector cell for the recording system at the side of a reference current source, the current mirror circuit having a plurality of output units with different current ratios of input and output.

55. The photodetector circuit according to claim 41 or 42, **characterized in that** the reproducing impedance, and the recording impedance each are a circuit network in which a plurality of resistors and series circuits of the switch are connected in parallel, and the gain control circuit sets the gain by turning on and off an arbitrary switch.

56. The photodetector circuit according to claim 41 or 42, **characterized in that** the reproducing impedance and the recording impedance each are a circuit network in which a plurality of resistors having the same value are partitioned in plurality in different numbers and a switch is connected in parallel to respective partitions, and the gain control circuit sets the gain by turning on and off an arbitrary switch.

57. An optical disk apparatus **characterized by** comprising: an optical pickup device configured to change over a disk reproducing laser power and a disk recording laser power of laser from a light source; and a photodetector which monitors part of laser in the midst of an optical path of the laser,

wherein the photodetector circuit comprises:

a photodetector including a photo detector cell for a reproduction system and a photo detector cell for a recording system;

a first amplifying circuit which amplifies and outputs an output current from the photo detector cell for the reproduction system;

a second amplifying circuit which amplifies and outputs an output current from the photo detector cell for the reproduction system;

a reproducing integrated impedance which is connected to the first amplifying circuit such that a gain of the first amplifying circuit is changed over;

a recording integrated impedance which is connected to the second amplifying circuit such that a gain of the second amplifying circuit is changed over;

a gain control circuit which produces fixed gain modes of 6 types to 27 types by a value of the reproducing impedance and a value of the recording impedance, and one type of the fixed gain mode is able to set;

a gain switching terminal which gives a setting signal to the gain control circuit from the outside in order to obtain one type of the fixed gain modes.

58. The optical disk apparatus according to claim 57, **characterized in that** the reproducing impedance, and the recording impedance each are a circuit network in which a plurality of resistors having the same value are partitioned in plurality in different numbers and a switch is connected in parallel to respective partitions, and the gain control circuit sets the gain by turning on and off an arbitrary switch.

59. The optical disk apparatus according to claim 58, **characterized by** further comprising:

an addition circuit which adds an output of the first amplifying circuit and an output of the second amplifying circuit;

a second switch wherein an output of the addition circuit and an output of the second amplifying circuit are supplied to one input terminal and the other, respectively;

a recording/reproduction state switching terminal which controls a selection state of the second switch via the gain control circuit; and

a differential output amplifying circuit to which an output terminal of the second switch is connected.

60. The optical disk apparatus according to claim 59, **characterized by** further comprising a memory having stored therein the setting signal given to the gain control circuit.

FIG. 1

EP 1 770 694 A2

FIG. 2

FIG. 3

Photodetector pattern

FIG. 4

FIG. 5

EP 1 770 694 A2

FIG. 6

FIG. 7

F I G. 8

F I G. 9

FIG. 10

FIG. 11

FIG. 12

F I G. 13

EP 1 770 694 A2

FIG.14

F I G. 15

Photodetector pattern

FIG.16

Photodetector pattern

FIG.17

Photodetector pattern

FIG.18

Photodetector pattern

# FIG.19

# FIG.20

F I G. 2 1

EP 1 770 694 A2

FIG. 22

FIG. 23

PD-A

PD-B

52

# FIG. 24

PD-A

PD-B

52

# FIG. 25

F I G. 2 6

EP 1 770 694 A2

Photodetector pattern

$\alpha$

PD-A1

PD-B1

$\beta$

PD-A2

PD-B2

PD-A3

52

PD-B3

PD-A4

PD-B4

51B

51A

PD-A5

FIG. 27

Photodetector pattern

$\alpha 3$

PD-A1

PD-B1

$\beta 2$

$\alpha 2$

PD-A2

PD-B2

$\beta 1$

$\alpha 1$

PD-A3

52

PD-B3

PD-A4

PD-B4

51A

51B

PD-A5

FIG. 28

FIG.29

FIG.30

FIG.31

FIG. 32

FIG. 33

F I G. 3 4

F I G. 3 5

FIG. 36

F I G. 37

EP 1 770 694 A2

F I G. 3 8

EP 1 770 694 A2

FIG.39

EP 1 770 694 A2

FIG. 40

FIG. 41

EP 1 770 694 A2

F I G. 4 2

APC-PDIC
18

VRA1
⊖ TIA ⊕ U1
PD-A
ADD1
+
⊖ Amplifying circuit ⊕ U3
81 READ-OUT

VRA2
⊖ TIA ⊕ U2
PD-B
⊖ Amplifying circuit ⊕ U4
82 WRITE-OUT

77 Reference voltage input terminal

83
Gain control circuit
79 Gain switching terminal
80 Gain switching terminal

EP 1 770 694 A2

F I G. 4 3

18

APC-PDIC

PD-A

PD-B

VRA1

VRA2

TIA U1

TIA U2

ADD1

SW4

Amplifying circuit U3

Vref

Reference voltage generation circuit

Reproduction / recording gain control circuit

75

84 OUT-P

85 OUT-N

78 R / W switching terminal

79 Gain switching terminal

80 Gain switching terminal

F I G. 44

F I G. 4 5

EP 1 770 694 A2

F I G. 4 6

EP 1 770 694 A2

FIG. 47

FIG. 48

FIG.49

F I G. 5 0

F I G. 5 1

**EP 1 770 694 A2**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2000332546 A
- JP 2003187484 A
- JP 15187484 A
- JP 2003234623 A
- JP 2003023327 A
- JP 5081695 A
- JP 2003281770 A
- JP 2003063543 A
- JP 2005182868 A
- JP 2004022051 A
- JP 2004342278 A
- JP 2004273033 A

**Non-patent literature cited in the description**

- Circuit Analysis for Learners of Engineering. Mc-Growhill Publishing Co. Ltd, vol. 1